(19) Europäisches Patentamt
European Patent Office
Office européen des brevets

(11) EP 3 845 394 B1

(12) EUROPEAN PATENT SPECIFICATION

(45) Date of publication and mention of the grant of the patent:
**30.04.2025 Bulletin 2025/18**

(21) Application number: **19853768.0**

(22) Date of filing: **29.08.2019**

(51) International Patent Classification (IPC):
***B41C 1/10*** *(2006.01)* ***C08F 212/08*** *(2006.01)*
***C08F 212/36*** *(2006.01)* ***C08F 220/14*** *(2006.01)*
***C08F 220/20*** *(2006.01)* ***C08F 220/44*** *(2006.01)*
***C08F 220/56*** *(2006.01)* ***C08F 220/60*** *(2006.01)*
***C09D 4/06*** *(2006.01)* ***C09D 133/24*** *(2006.01)*
***C08F 265/06*** *(2006.01)*

(52) Cooperative Patent Classification (CPC):
(C-Sets available)
**C08F 212/36; B41C 1/1008; B41C 1/1033; C08F 212/08; C08F 220/606; C08F 265/06;** B41C 2210/04; B41C 2210/08; B41C 2210/22; B41C 2210/24; C08F 220/14; C08F 220/20; C08F 220/44; C08F 220/56; C09D 4/06; (Cont.)

(86) International application number:
**PCT/JP2019/033984**

(87) International publication number:
**WO 2020/045586 (05.03.2020 Gazette 2020/10)**

# (54) PLANOGRAPHIC PRINTING PLATE PRECURSOR, METHOD OF PREPARING A PLANOGRAPHIC PRINTING PLATE, AND PLANOGRAPHIC PRINTING METHOD

FLACHDRUCKPLATTENVORLÄUFER, VERFAHREN ZUR HERSTELLUNG EINER FLACHDRUCKPLATTE UND FLACHDRUCKVERFAHREN

PRÉCURSEUR DE PLAQUE D’IMPRESSION PLANOGRAPHIQUE, PROCÉDÉ DE FABRICATION DE PLAQUE D’IMPRESSION PLANOGRAPHIQUE, ET PROCÉDÉ D’IMPRESSION PLANOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2018 JP 2018163556**
**31.01.2019 JP 2019016536**

(43) Date of publication of application:
**07.07.2021 Bulletin 2021/27**

(73) Proprietor: **FUJIFILM Corporation**
**Tokyo 106-8620 (JP)**

(72) Inventors:
- **ISHIJI, Yohei**
**Shizuoka 421-0396 (JP)**
- **YANAGI, Shunsuke**
**Shizuoka 421-0396 (JP)**
- **ARAKI, Kenjiro**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A1- 2 363 748**
**EP-A1- 2 554 381**
**EP-A2- 2 383 118**
**WO-A1-2017/018262**
**WO-A1-2017/150039**
**JP-A- 2006 317 716**
**JP-A- 2010 234 587**
**JP-A- 2013 503 365**
**US-A1- 2009 183 647**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

• **HEATLEY F ET AL: "NMR studies of free-radical polymerization and copolymerization of monomers and polymers containing allyl groups", EUROPEAN POLYMER JOURNAL, PERGAMON PRESS LTD OXFORD, GB, vol. 29, no. 2-3, 1 February 1993 (1993-02-01), pages 255 - 268, XP024051795, ISSN: 0014-3057, [retrieved on 19930201], DOI: 10.1016/0014-3057(93)90092-T**

(52) Cooperative Patent Classification (CPC): (Cont.)
C09D 133/24

C-Sets
**C08F 212/08, C08F 220/286, C08F 220/603, C08F 212/36;**
**C08F 212/36, C08F 212/08, C08F 220/06;**
**C08F 212/36, C08F 212/08, C08F 222/102;**
**C08F 220/606, C08F 230/02, C08F 222/385, C08F 220/286;**
**C08F 265/06, C08F 222/1006;**
C08F 220/14, C08F 220/287, C08F 222/102;
C08F 220/20, C08F 220/286, C08F 220/56, C08F 222/385;
C08F 220/44, C08F 220/286, C08F 212/08;
C08F 220/56, C08F 220/286, C08F 220/20, C08F 222/385;
C09D 4/06, C08F 265/06

## Description

## BACKGROUND OF THE INVENTION

1. Field of the Invention

The present disclosure relates to a planographic printing plate precursor, a method of preparing a planographic printing plate, a planographic printing method, and a curable composition.

2. Description of the Related Art

A planographic printing plate is typically formed of a lipophilic image area that receives ink in the process of printing and a hydrophilic non-image area that receives dampening water. Planographic printing is a method of performing printing by utilizing the property that water and oil-based ink repel each other to generate a difference in adhesiveness of ink onto a surface of a planographic printing plate using a lipophilic image area of the planographic printing plate as an ink receiving unit and a hydrophilic non-image area as a dampening water receiving unit (ink non-receiving unit), allowing the ink to land only on an image area, and transferring the ink to a printing material such as paper.

In the related art, a planographic printing plate precursor (PS plate) obtained by providing a lipophilic photosensitive resin layer (image recording layer) on a hydrophilic support has been widely used in order to prepare such a planographic printing plate. A planographic printing plate is typically obtained by performing plate-making according to a method of exposing a planographic printing plate precursor through an original picture such as a lith film, allowing a part which is an image area of an image recording layer to remain, dissolving the other unnecessary part of the image recording layer in an alkaline developer or an organic solvent so that the part is removed, and exposing a surface of a hydrophilic support to form a non-image area.

Further, environmental problems related to a waste liquid associated with wet treatments such as a development treatment have been highlighted due to the growing interest in the global environment.

In order to deal with the above-described environmental problem, it is desired to simplify the process of development or plate-making or not to perform any treatment. As one of simple preparation methods, a method referred to as "on-press development" has been performed. That is, the on-press development is a method of exposing a planographic printing plate precursor, mounting the planographic printing plate precursor on a printing press without performing development of the related art, and removing an unnecessary part of an image recording layer, at an initial stage of a typical printing step.

As planographic printing plate precursors of the related art, those described in JP2013-503365A and JP2010-234587A are exemplified.

JP2013-503365A describes a planographic printing plate precursor including a substrate and an image-forming layer on the substrate, in which the precursor contains polymer particles having an average diameter of 3 to 20 μm on the outermost layer thereof, each polymer particle contains a core of a crosslinked polymer and a graft hydrophilic polymer surface group, and the polymer surface group is grafted on the surface of each particle by polymerizing a hydrophilic monomer in the presence of the crosslinked polymer particles.

JP2010-234587A describes a planographic printing plate precursor including an aluminum support which has been subjected to a roughening treatment and an image recording layer containing an infrared absorbing agent (A), a radical polymerization initiator (B), a radically polymerizable monomer (C), a compound (D) having two or more mercapto group-containing groups in one molecule, and a polymer fine particle (E) having a polyalkylene oxide segment, on the aluminum support.

EP 2 554 381 A1 relates to a plate making method of a lithographic printing plate comprising (1) preparing a lithographic printing plate precursor capable of forming an image with a semiconductor laser emitting an infrared ray having a wavelength from 760 to 1,200 nm which comprises a support and an image-recording layer, (2) placing a lith film on the lithographic printing plate precursor and reducing pressure so that the lith film is closely adhered to the lithographic printing plate precursor, (3) conducting UV exposure, and (4) conducting on-press development.

EP 2 363 748 A1 relates to a lithographic printing plate precursor comprising a support and an image-recording layer an unexposed area of which is capable of being removed with dampening water and/or printing ink and contains (a) an infrared absorbing agent, (b) a radical polymerization initiator, (c) a polymer particle, and (d) a radical polymerizable urethane oligomer.

EP 2 383 118 A2 relates to lithographic printing plate precursor comprising a hydrophilic support and an image-recording layer containing (A) a polymer fine particle, (B) a radical polymerizable compound and (C) an infrared absorbing dye, wherein the polymer fine particle is a polymer fine particle obtained by a reaction between a polyvalent isocyanate compound and a compound having an active hydrogen atom.

## SUMMARY OF THE INVENTION

In the planographic printing plate, a planographic printing plate in which the number of printable plates (hereinafter, also referred to as "printing durability") is high is required.

Particularly, in recent years, an ink that is cured by being irradiated with ultraviolet rays (UV) (also referred to as "ultraviolet curable ink") is used as an ink for printing in some cases.

The ultraviolet curable ink has high productivity because the ink can be dried instantly, can easily reduce environmental pollution because the ink usually has a small content of a solvent or does not contain a solvent, and can form an image without being dried with heat or by being dried with heat in a short time, and thus the ink has an advantage that the range of applications for printing targets and the like is expanded.

Therefore, a planographic printing plate precursor that can provide a planographic printing plate having excellent printing durability (hereinafter, also referred to as "UV printing durability") in a case of using an ultraviolet curable ink is considered to be extremely industrially useful.

As a result of intensive examination on the planographic printing plate precursors described in JP2013-503365A and JP2010-234587A, the present inventors found that there is room for further improvement in printing durability of a planographic printing plate to be obtained particularly in a case where an ultraviolet curable ink is used as an ink.

An object to be achieved is to provide a planographic printing plate precursor from which a planographic printing plate with excellent printing durability is obtained even in a case where an ultraviolet curable ink is used.

Further, an object to be achieved is to provide a method of preparing a planographic printing plate with excellent printing durability even in a case where an ultraviolet curable ink is used, and a planographic printing method.

An object to be achieved is to provide a curable composition containing novel polymer particles.

The means for achieving the above-described object are defined in the appended claims.

According to an aspect, it is possible to provide a planographic printing plate precursor from which a planographic printing plate with excellent printing durability is obtained even in a case where an ultraviolet curable ink is used.

Further, according to another aspect, it is possible to provide a method of preparing a planographic printing plate with excellent printing durability even in a case where an ultraviolet curable ink is used, and a planographic printing method.

According to still another aspect, it is possible to provide a curable composition containing novel polymer particles.

## DESCRIPTION OF THE PREFERRED EMBODIMENTS

Hereinafter, the contents of the present disclosure will be described in detail. The description of constituent elements below is made based on representative embodiments of the present disclosure in some cases, but the present disclosure is not limited to such embodiments. The invention is as defined in the claims and the disclosure below provides aspects and embodiments useful for further understanding the invention.

Further, in the present specification, a numerical range shown using "to" indicates a range including numerical values described before and after "to" as a lower limit and an upper limit.

In the present specification, in a case where substitution or unsubstitution is not noted in regard to the notation of a "group" (atomic group) in the present specification, the "group" includes not only a group that does not have a substituent but also a group having a substituent. For example, the concept of an "alkyl group" includes not only an alkyl group that does not have a substituent (unsubstituted alkyl group) but also an alkyl group having a substituent (substituted alkyl group).

In the present specification, the concept of "(meth)acryl" includes both acryl and methacryl, and the concept of "(meth)acryloyl" includes both acryloyl and methacryloyl.

Further, the term "step" in the present specification indicates not only an independent step but also a step which cannot be clearly distinguished from other steps as long as the intended purpose of the step is achieved.

Further, in the present disclosure, "% by mass" has the same definition as that for "% by weight", and "part by mass" has the same definition as that for "part by weight".

In the present disclosure, a composition may contain only one or two or more components in combination and a polymer may have only one or two or more structural units in combination, unless otherwise specified.

In the present disclosure, the amount of each component in a composition or each structural unit in a polymer indicates the total amount of a plurality of materials corresponding to each component in the composition or the total amount of a plurality of structural units corresponding to each structural unit in the polymer in a case where the composition contains a plurality of materials corresponding to each component described above or the polymer has a plurality of structural units corresponding to each structural unit described above, unless otherwise specified.

Further, in the present disclosure, a combination of two or more preferred embodiments is a more preferred embodiment.

Further, the weight-average molecular weight (Mw) and the number average molecular weight (Mn) in the present disclosure are molecular weights in terms of polystyrene used as a standard substance, which are detected by using tetrahydrofuran (THF) as a solvent, a differential refractometer, and a gel permeation chromatography (GPC) analyzer using TSKgel GMHxL, TSKgel G4000HxL, and TSKgel G2000HxL (all trade names, manufactured by Tosoh Corporation) as columns, unless otherwise specified.

In addition, the median diameter in polymer particles of the present disclosure indicates a value measured by a light scattering method unless otherwise specified, and the median diameter also indicates a diameter in which the number of larger particles is the same as the number of smaller particles in a case where powder is divided into two sides, which are particles with larger particle diameters and particles with smaller particle diameters, based on a certain particle diameter. The median diameter of polymer particles according to a light scattering method is measured using LA-920 (manufactured by Horiba, Ltd.) according to the manual of the device described above.

In the present specification, the term "planographic printing plate precursor" includes not only a planographic printing plate precursor but also a key plate precursor. Further, the term "planographic printing plate" includes not only a planographic printing plate prepared by performing operations such as exposure and development on a planographic printing plate precursor as necessary but also a key plate. In a case of a key plate precursor, the operations of exposure, development, and the like are not necessarily required. Further, a key plate is a planographic printing plate precursor for attachment to a plate cylinder that is not used in a case where printing is performed on a part of a paper surface with one or two colors in color newspaper printing.

Further, in the present specification, "*" in a chemical structural formula represents a binding position with respect to another structure.

Hereinafter, the present disclosure will be described in detail.

(Planographic printing plate precursor)

A planographic printing plate precursor according to the embodiment of the present disclosure includes a support and an image recording layer in this order, the image recording layer contains polymer particles containing an addition polymerization type resin (hereinafter, also referred to as "specific polymer particles"), and the addition polymerization type resin contains a polymerizable group and a hydrophilic structure.

It is preferable that the planographic printing plate precursor according to the embodiment of the present disclosure is a negative type planographic printing plate precursor.

Further, the planographic printing plate precursor according to the embodiment of the present disclosure can be suitably used as an on-press development type planographic printing plate precursor.

In the present disclosure, the on-press development type planographic printing plate precursor indicates a planographic printing plate precursor which can be developed by an on-press development method described below.

As a result of intensive examination conducted by the present inventors, it was found that a planographic printing plate precursor from which a planographic printing plate with excellent printing durability (UV printing durability) in a case of using an ultraviolet curable ink is obtained can be provided by employing the above-described configuration.

The detailed mechanism by which the above-described effect is obtained is not clear, but can be assumed as follows.

It is considered that in a case where specific polymer particles contain an addition polymerization type resin having a hydrophilic structure, the hydrophilicity of the surface of each specific polymer particle is increased and the hydrophilicity of the entire image recording layer can be maintained to be high, and thus a planographic printing plate precursor with improved strength of the image area and excellent printing durability can be obtained even in a case where an ultraviolet curable ink is used.

Further, it is considered that the planographic printing plate precursor according to the embodiment of the present disclosure is likely to have excellent developability (particularly, on-press developability) because the hydrophilicity of the entire image recording layer is high.

Further, since the specific polymer particles used in the present disclosure have a hydrophilic structure, the developability is enhanced, and the dispersibility of the specific polymer particles in a developer is also enhanced. Therefore, scum is unlikely to be generated in a case of on-press development. Therefore, it is considered that a planographic printing plate precursor having an excellent property of suppressing on-press development scum is easily obtained.

Further, it is considered that the planographic printing plate precursor according to the embodiment of the present disclosure is likely to have excellent printing durability even in a case where a solvent ink that is not an ultraviolet curable ink is used.

<Image recording layer>

The planographic printing plate precursor according to the embodiment of the present disclosure includes an image recording layer containing specific polymer particles.
It is preferable that the image recording layer used in the present disclosure is a negative type image recording layer.
From the viewpoints of the printing durability and the photosensitivity, it is preferable that the image recording layer in the present disclosure is an image recording layer according to any of the first embodiment or the second embodiment described below.
First embodiment: the image recording layer contains specific polymer particles, an infrared absorbing agent, a polymerization initiator, and a polymerizable compound.
Second embodiment: the image recording layer contains specific polymer particles, an infrared absorbing agent, and hydrophobic thermoplastic polymer particles.
From the viewpoint of the printing durability, particularly the UV printing durability, it is preferable that the image recording layer used in the present disclosure further contains a binder polymer in the first embodiment.
Further, from the viewpoint of the on-press developability, it is preferable that the image recording layer used in the present disclosure may further contain hydrophobic thermoplastic polymer particles in the first embodiment.
In the planographic printing plate precursor according to the embodiment of the present disclosure, from the viewpoint of the on-press developability, it is preferable that the unexposed portion of the image recording layer can be removed by at least one of dampening water or printing ink.
Hereinafter, details of each component contained in the image recording layer will be described.

[Specific polymer particles]

The image recording layer in the planographic printing plate precursor according to the embodiment of the present disclosure contains polymer particles (specific polymer particles) containing an addition polymerization type resin that has a polymerizable group and a hydrophilic structure.
From the viewpoints of the UV printing durability and the on-press developability, it is preferable that the specific polymer particles contains 80% by mass or greater of the addition polymerization type resin, more preferable that the specific polymer particles contains 90% by mass or greater of the addition polymerization type resin, still more preferable that the specific polymer particles contain 95% by mass or greater of the addition polymerization type resin, and particularly preferable that the specific polymer particles are formed of the addition polymerization type resin.
The upper limit of the content of the addition polymerization type resin is not particularly limited, and may be 100% by mass or less.
Further, the content of the resin component in the specific polymer particles is preferably 80% by mass or greater, more preferably 90% by mass or greater, and still more preferably 95% by mass or greater.
The upper limit of the content of the resin component is not particularly limited, and may be 100% by mass or less.
From the viewpoints of the UV printing durability and ease of manufacturing, it is preferable that the addition polymerization type resin is a resin formed by polymerizing an ethylenically unsaturated compound and more preferable that the addition polymerization type resin is a resin formed by copolymerizing a polyfunctional ethylenically unsaturated compound and a monofunctional ethylenically unsaturated compound.
The addition polymerization type resin may contain only one polymerizable group and only one hydrophilic structure or may contain two or more kinds of any or both the polymerizable groups and hydrophilic groups.

- Polymerizable group -

The addition polymerization type resin contains at least a polymerizable group.
The polymerizable group may be, for example, a cationically polymerizable group or a radically polymerizable group, but a radically polymerizable group is preferable from the viewpoint of the reactivity.
The polymerizable group is an ethylenically unsaturated group which is a (meth)acryloxy group.
Further, the introduction of these polymerizable groups to the specific polymer particles can be carried out by a method of introducing polymerizable groups using residues of polyfunctional monomers to be added in a case of synthesis of particles or a method of introducing polymerizable groups to the surface of each particle through the polymer reaction after synthesis of particles. In the present disclosure, the method of introducing polymerizable groups through the polymer reaction after synthesis of particles is desirable. This is because more active polymerizable groups can be allowed to be present on the surface of each particle in a case where the polymerizable groups are introduced after the synthesis of particle, and thus the reactivity of the polymerizable groups with the matrix is enhanced and the polymerizable groups are likely to be strongly crosslinked with the matrix.

As described above, the structural unit containing a polymerizable group can be introduced to the addition polymerization type resin by, for example, the polymer reaction. Specifically, the introduction can be carried out by, for example, a method of allowing a compound (such as glycidyl methacrylate) containing an epoxy group and a polymerizable group to react with a polymer to which a structural unit containing a carboxy group such as methacrylic acid has been introduced or a method of allowing a compound (such as 2-isocyanatoethyl methacrylate) containing an isocyanate group and a polymerizable group to react with a polymer to which a structural unit containing a group having active hydrogen such as a hydroxy group or an amino group has been introduced.

In such an introduction method, a structural unit containing a carboxy group or a structural unit containing a group that has active hydrogen can be allowed to remain in the addition polymerization type resin by adjusting the reaction rate of the compound containing an epoxy group and a polymerizable group or the compound containing an isocyanate group and a polymerizable group with respect to the structural unit containing a carboxy group such as methacrylic acid or the structural unit containing a group having active hydrogen (hereinafter, also collectively referred to as "structural units before the reaction", and these structural units after the introduction of polymerizable groups are also referred to as "structural units after the reaction").

Further, in such an introduction method, the introduction can be carried out according to a method of polymerizing the structural unit containing a carboxy group such as methacrylic acid or the structural unit containing a group that has active hydrogen (the structural unit before the reaction) by increasing the proportion of the structural unit before the reaction at the later stage of the synthesis of particles, that is, more structural units before the reaction can be allowed to be present on the surface of each particle by synthesizing the particles according to a seed polymerization method, and thus more polymerizable groups can be introduced to the surface of each particle during the subsequent polymer reaction.

Since the structural unit before the reaction corresponds to a structural unit having a hydrophilic structure described below, in a case where the reaction rate is decreased, the addition polymerization type resin is allowed to contain the structural unit having a hydrophilic structure (an ionic group such as a carboxy group or an amino group), and the dispersibility of the specific polymer particles, the developability of the planographic printing plate precursor, and the like can also be further improved.

The reaction rate is, for example, preferably in a range of 10% to 100% and more preferably in a range of 30% to 70%.

The reaction rate is a value defined by Equation R.

Reaction rate = (number of moles of structural unit after reaction in obtained addition polymerization type resin/total number of moles of structural unit before reaction in obtained addition polymerization type resin) $\times$ 100 Equation R     Equation R

Further, the structural unit containing a polymerizable group may be introduced to the addition polymerization type resin according to, for example, a method of allowing a compound containing a carboxy group and a polymerizable group to react with a polymer to which a structural unit containing an epoxy group such as glycidyl (meth)acrylate has been introduced.

Further, the structural unit containing a polymerizable group may be introduced to the addition polymerization type resin using, for example, a monomer having a partial structure represented by Formula d1 or Formula d2. Specifically, for example, the structural unit containing a polymerizable group is introduced to the addition polymerization type resin by forming an ethylenically unsaturated group on the partial structure represented by Formula d1 or Formula d2 through an elimination reaction using a base compound, after the polymerization carried out using at least the monomer described above.

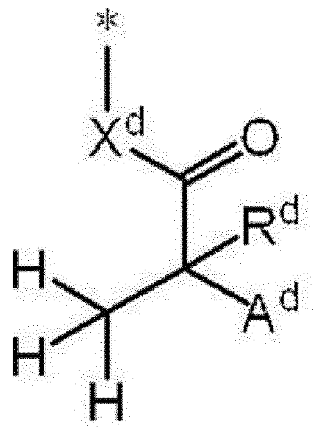

Formula d1

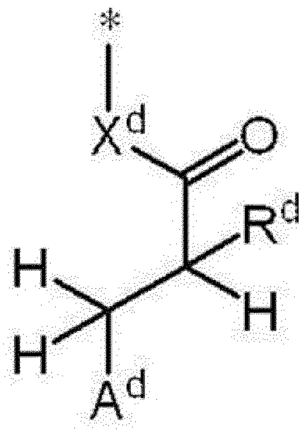

Formula d2

In Formulae d1 and d2, $R^d$ represents a hydrogen atom or an alkyl group, $A^d$ represents a halogen atom, $X^d$ represents -O- or $-NR^N-$, $R^N$ represents a hydrogen atom or an alkyl group, and * represents a binding site with respect to another structure.

In Formulae d1 and d2, it is preferable that $R^d$ represents a hydrogen atom or a methyl group.

In Formulae d1 and d2, it is preferable that $A^d$ represents a chlorine atom, a bromine atom, or an iodine atom.

In Formulae d1 and d2, it is preferable that $X^d$ represents -O-. In a case where $X^d$ represents $-NR^N-$, $R^N$ represents preferably a hydrogen atom or an alkyl group having 1 to 4 carbon atoms and more preferably a hydrogen atom.

Examples of the structural unit containing a polymerizable group include a structural unit represented by Formula D1.

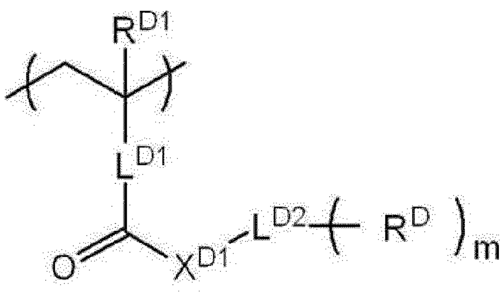

Formula D1

In Formula D1, $L^{D1}$ represents a single bond or a divalent linking group, $L^{D2}$ represents a single bond or an (m + 1)-valent linking group, $X^{D1}$ represents -O- or $-NR^N-$, $R^N$ represents a hydrogen atom or an alkyl group, $R^D$ represents a group represented by Formula DA-2 or DA-3, $R^{D1}$ represents a hydrogen atom or a methyl group, and m represents an integer of 1 or greater.

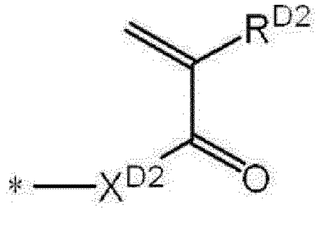

Formula DA-2

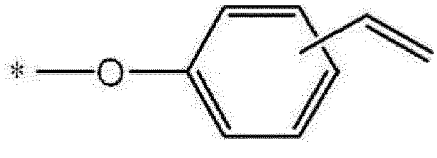

Formula DA-3

In Formula DA-2, $X^{D2}$ represents -O- or $-NR^N-$, $R^N$ represents a hydrogen atom or an alkyl group, $R^{D2}$ represents a hydrogen atom or a methyl group, and * represents a binding site with respect to $L^{D2}$ in Formula D1.

From the viewpoint of the reactivity, it is preferable that $R^D$ in Formula D1 represents a group represented by Formula DA-2.

In Formula D1, it is preferable that $L^{D1}$ represents a single bond. In a case where $L^{D1}$ represents a divalent linking group, an alkylene group, an arylene group, or a divalent group in which two or more of these groups are bonded to each other is preferable, and an alkylene group having 2 to 10 carbon atoms or a phenylene group is more preferable.

In Formula D1, $L^{D2}$ represents preferably a linking group containing a group represented by any of Formulae D2 to D6 and more preferably a group represented by a bond of at least two structures selected from the group consisting of a group represented by any of Formulae D2 to D6, an ester bond, an alkylene group, and an alkyleneoxy group.

In Formula D1, it is preferable that both $X^{D1}$ and $X^{D2}$ represent -O-. Further, in a case where at least one of $X^{D1}$ or $X^{D2}$ represents $-NR^N-$, $R^N$ represents preferably a hydrogen atom or an alkyl group having 1 to 4 carbon atoms and more preferably a hydrogen atom.

In Formula D1, it is preferable that $R^{D1}$ represents a methyl group.

In Formula D1, it is preferable that at least one of m $R^{D2}$'s represents a methyl group.

In Formula D1, m represents preferably an integer of 1 to 4, more preferably 1 or 2, and still more preferably 1.

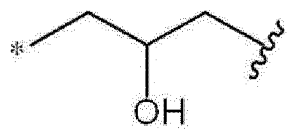

Formula D2

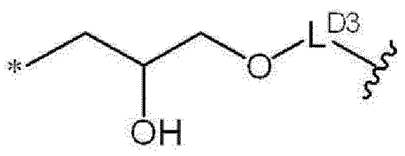

Formula D3

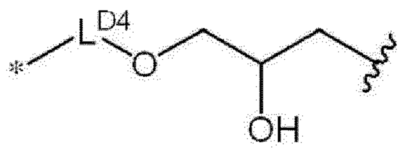

Formula D4

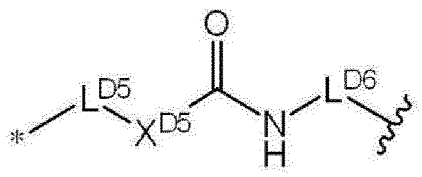

Formula D5

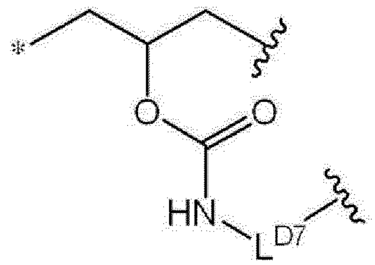

Formula D6

In Formulae D2 to D6, $L^{D3}$ to $L^{D7}$ represent a divalent linking group, $L^{D5}$ and $L^{D6}$ may be different from each other, $X^{D5}$ represents -O- or $-NR^N-$, $R^N$ represents a hydrogen atom or an alkyl group, * represents a binding site with respect to $X^{D1}$ in Formula D1, and the wavy line represents a binding site with respect to $X^{D2}$ in Formula D1.

In Formula D3, $L^{D3}$ represents preferably an alkylene group, an arylene group, or a group in which two or more of these groups are bonded to each other and more preferably an alkylene group having 1 to 10 carbon atoms, a phenylene group, or a group in which two or more of these groups are bonded to each other.

In Formula D4, $L^{D4}$ represents preferably an alkylene group, an arylene group, or a group in which two or more of these groups are bonded to each other and more preferably an alkylene group having 1 to 10 carbon atoms, a phenylene group, or a group in which two or more of these groups are bonded to each other.

In Formula D5, $L^{D5}$ represents preferably an alkylene group, an arylene group, or a group in which two or more of these groups are bonded to each other and more preferably an alkylene group having 1 to 10 carbon atoms, a phenylene group, or a group in which two or more of these groups are bonded to each other.

In Formula D5, it is preferable that $X^{D5}$ represents -O- or -NH-.

In Formula D5, $L^{D6}$ represents preferably an alkylene group, an arylene group, or a group in which two or more of these groups are bonded to each other and more preferably an alkylene group having 1 to 10 carbon atoms, a phenylene group, or a group in which two or more of these groups are bonded to each other.

In Formula D6, $L^{D7}$ represents preferably an alkylene group, an arylene group, or a group in which two or more of these groups are bonded to each other and more preferably an alkylene group having 1 to 10 carbon atoms, a phenylene group, or a group in which two or more of these groups are bonded to each other.

From the viewpoint of the reactivity, the number of atoms between the polymerizable group (for example, a (meth) acryloxy group) and the main chain of the addition polymerization type resin is preferably in a range of 1 to 20 and more preferably in a range of 6 to 12.

Specific examples of the structural unit containing a polymerizable group will be described below, but the structural unit containing a polymerizable group in the addition polymerization type resin of the present disclosure is not

limited thereto.

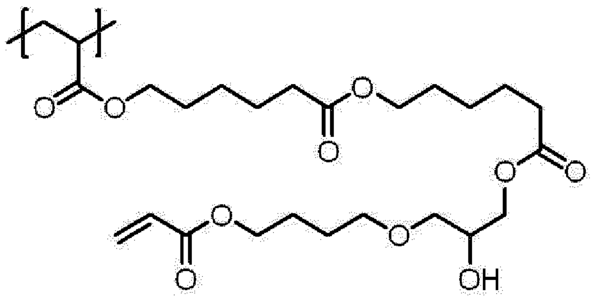

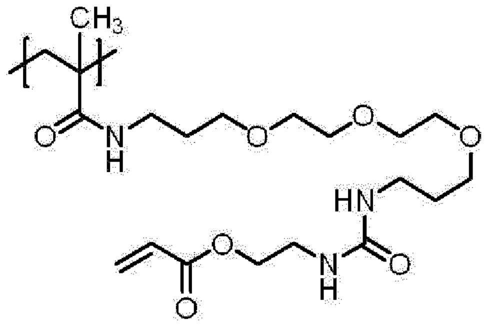

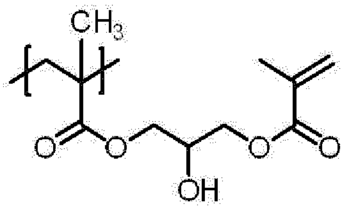

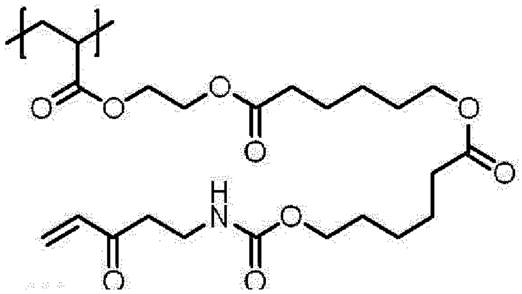

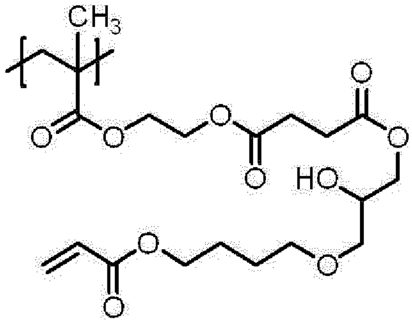

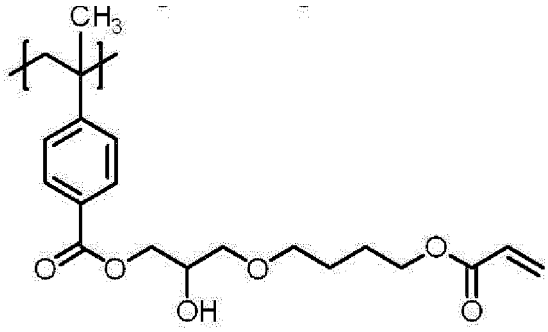

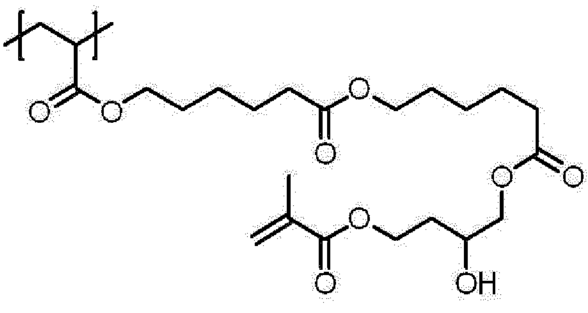

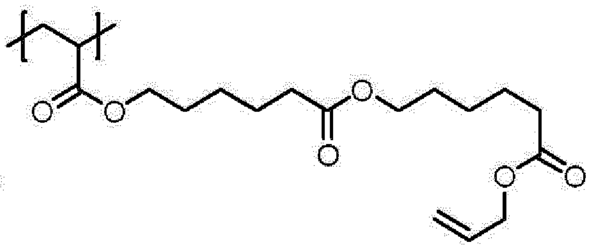

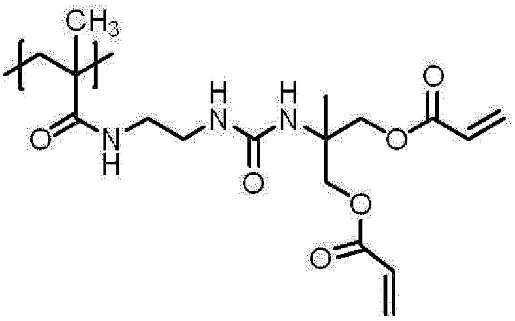

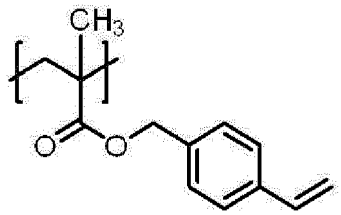

From the viewpoint of the UV printing durability, the content of the structural unit containing a polymerizable group in the addition polymerization type resin is preferably in a range of 1% by mass to 50% by mass, more preferably in a range of 5% by mass to 45% by mass, still more preferably in a range of 10% by mass to 40% by mass, and particularly preferably in a range of 10% by mass to 35% by mass with respect to the total mass of the addition polymerization type resin.

The polymerizable group value (the amount of the polymerizable group per 1 g of the addition polymerization type resin) of the addition polymerization type resin is preferably in a range of 0.01 mol/g to 2.0 mol/g and more preferably in a range of 0.1 mol/g to 1.0 mol/g. The polymerizable group value is measured by an iodometric titration method.

- Hydrophilic structure -

The addition polymerization type resin contains a polymerizable group and a hydrophilic structure.

From the viewpoints of the UV printing durability, the on-press developability, the property of suppressing on-press development scum, and the dispersion stability of particles, particularly the dispersion stability of particles in water, the addition polymerization type resin contains preferably an ionic group or an acid group and more preferably an ionic group, as the hydrophilic structure.

In the present disclosure, an ionic group indicates a group, at least a part of which can be dissociated into an anion or a cation in water.

Further, from the viewpoints of the UV printing durability, the on-press developability, the property of suppressing on-press development scum, and the dispersion stability of particles, particularly the dispersion stability of particles in water, it is more preferable that the addition polymerization type resin contains a sulfonate group (a salt of a sulfonic acid group) or a sulfonic acid group, or a carboxylate group (a salt of a carboxylic acid group) or a carboxylic acid group as the hydrophilic structure.

From the viewpoints of the UV printing durability, the on-press developability, the property of suppressing on-press development scum, and the dispersion stability of particles, particularly the dispersion stability of particles in an organic solvent, the addition polymerization type resin has preferably a polyalkylene oxide structure or a polyester structure and more preferably a polyalkylene oxide structure, as the hydrophilic structure.

Further, from the viewpoints of the UV printing durability, the on-press developability, the property of suppressing on-press development scum, and the dispersion stability of particles, it is particularly preferable that the addition polymerization type resin contains an ionic group or an acid group and a polyalkylene oxide structure as the hydrophilic structure.

From the viewpoints of the on-press developability, the property of suppressing on-press development scum, and the dispersion stability of particles, a sulfonic acid group, a carboxylic acid group, a phosphoric acid group, or a sulfuric acid monoester group is preferable, a sulfonic acid group or a carboxylic acid group is more preferable, and a carboxylic acid group or a sulfonic acid group is particularly preferable, as the acid group.

From the viewpoints of the UV printing durability, the on-press developability, the property of suppressing on-press development scum, and the dispersion stability of particles, a group (anionic group) that dissociates a counter ion to produce an anion is preferable, a salt of an acid group is more preferable, a sulfonate group, a carboxylate group, or a sulfate monoester group is still more preferable, and a carboxylic acid group or a sulfonate group is particularly preferable, as the ionic group.

The counter cation in the salt of an acid group may be an inorganic cation or an organic cation, but is preferably an inorganic cation. Further, the counter cation may be a monovalent cation or a polyvalent cation, but is preferably a monovalent cation.

As the inorganic cation, an alkali metal ion or an alkaline earth metal ion is preferable, an alkali metal ion is more preferable, and a lithium ion, a sodium ion, or a potassium ion is still more preferable.

Examples of the organic cation include a quaternary ammonium cation and a cation obtained by alkylating a nitrogen atom of an aromatic nitrogen-containing heterocycle.

Examples of the quaternary ammonium cation include a tetramethylammonium cation, a tetraethylammonium

cation, and a dimethylbenzylammonium cation, and examples of the cation obtained by alkylating a nitrogen atom of an aromatic nitrogen-containing heterocycle include a pyridinium cation.

Among these, an alkali metal ion or a quaternary ammonium cation is preferable and an alkali metal ion is more preferable, as the counter cation.

From the viewpoints of the UV printing durability, the on-press developability, the property of suppressing on-press development scum, and the dispersion stability of particles, it is preferable that the addition polymerization type resin has a structural unit represented by Formula A-1 as the structural unit having a hydrophilic structure.

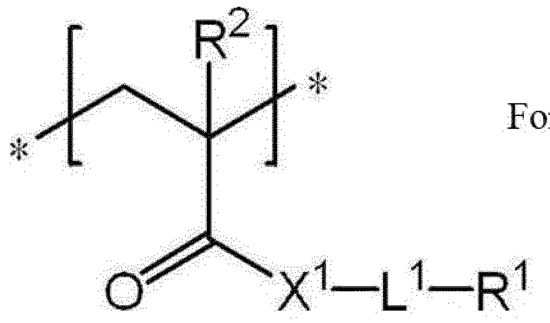

Formula A-1

In Formula A-1, $X^1$ represents -O- or $NR^3$, $L^1$ represents a divalent linking group having 1 to 20 carbon atoms, $R^1$ represents an ionic group or an acid group, $R^2$ represents a hydrogen atom or a methyl group, and $R^3$ represents a hydrogen atom, an alkyl group, or an aryl group.

It is preferable that $X^1$ represents -O-.

$L^1$ represents preferably a divalent linking group having 2 to 10 carbon atoms, more preferably a divalent linking group having 2 to 8 carbon atoms, still more preferably an alkylene group having 2 to 8 carbon atoms, and particularly preferably an alkylene group having 2 to 5 carbon atoms.

As the divalent linking group, an alkylene group or a group formed by bonding one or more alkylene groups to one or more of at least one structure selected from the group consisting of an ether bond and an ester bond is preferable, and an alkylene group is more preferable.

$R^3$ represents preferably a hydrogen atom, an alkyl group having 1 to 4 carbon atoms, or a phenyl group and more preferably a hydrogen atom.

From the viewpoints of the dispersion stability of particles, particularly the dispersion stability of particles in an organic solvent, a polyethylene oxide structure, a polypropylene oxide structure, or a poly(ethylene oxide/propylene oxide) structure is preferable as the polyalkylene oxide structure.

From the viewpoints of the dispersion stability of particles, particularly the dispersion stability of particles in an organic solvent, the number of alkylene oxide structures in the polyalkylene oxide structure is preferably 2 or greater, more preferably 5 or greater, still more preferably in a range of 5 to 200, and particularly preferably in a range of 8 to 150.

The polyester structure is not particularly limited, and preferred examples thereof include a ring-opening polymerization chain of a lactone and a polycondensation chain of hydroxycarboxylic acid.

From the viewpoints of the dispersion stability of particles, particularly the dispersion stability of particles in an organic solvent, the number of hydroxycarboxylic acid structures (lactone structures) in the polyester structure is preferably 2 or greater, more preferably in a range of 2 to 20, still more preferably in a range of 2 to 10, and particularly preferably in a range of 4 to 10.

From the viewpoints of the UV printing durability, the on-press developability, the property of suppressing on-press development scum, and the dispersion stability of particles, the addition polymerization type resin has preferably a structural unit represented by Formula A-3 or A-4 and more preferably a structural unit represented by Formula A-3, as the structural unit having a hydrophilic structure.

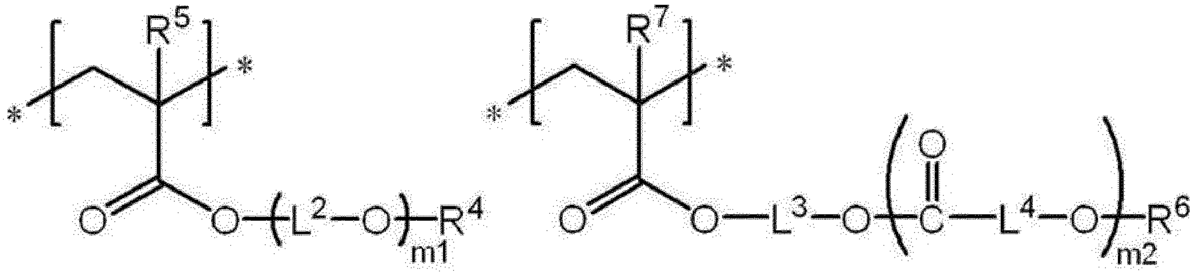

Formula A-3 Formula A-4

In Formulae A-3 and A-4, $L^2$ represents an ethylene group or a propylene group, $L^3$ represents an alkylene group having 2 to 10 carbon atoms, $L^4$ represents an alkylene group having 1 to 10 carbon atoms, $R^4$ and $R^6$ each independently represent a hydrogen atom, an alkyl group, or an aryl group, $R^5$ and $R^7$ each independently represent a hydrogen atom or a methyl group, m1 represents an integer of 2 to 200, and m2 represents an integer of 2 to 20.

It is preferable that $L^2$ represents an ethylene group or a 1,2-propylene group.

$L^3$ represents preferably an alkylene group having 2 to 8 carbon atoms, more preferably an alkylene group having 2 to 4 carbon atoms, and still more preferably an ethylene group.

$L^4$ represents preferably an alkylene group having 2 to 8 carbon atoms, more preferably an alkylene group having 3 to 8 carbon atoms, and still more preferably an alkylene group having 4 to 6 carbon atoms.

$R^4$ and $R^6$ each independently represent preferably a hydrogen atom, an alkyl group having 1 to 4 carbon atoms, or a phenyl group, preferably a hydrogen atom or an alkyl group having 1 to 4 carbon atoms, and still more preferably a hydrogen atom or a methyl group.

m1 represents preferably an integer of 5 to 200 and more preferably an integer of 8 to 150.

m2 represents preferably an integer of 2 to 10 and more preferably an integer of 4 to 10.

From the viewpoints of the UV printing durability, the on-press developability, the property of suppressing on-press development scum, and the dispersion stability of particles, the addition polymerization type resin has particularly preferably a structural unit represented by Formula A-1 and a structural unit represented by Formula A-3 or A-4 and most preferably a structural unit represented by Formula A-1 and a structural unit represented by Formula A-3.

From the viewpoints of the on-press developability, the property of suppressing on-press development scum, and the dispersion stability of particles, it is preferable that the addition polymerization type resin contains a group represented by Formula Z as the group having a hydrophilic structure.

*-Q-W-Y Formula Z

In Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, any one of W or Y has a hydrophilic structure, and * represents a binding site with respect to another structure.

Q represents preferably a divalent linking group having 1 to 20 carbon atoms and more preferably a divalent linking group having 1 to 10 carbon atoms.

Further, Q represents preferably an alkylene group, an arylene group, an ester bond, an amide bond, or a group formed by combining two or more of these groups and more preferably a phenylene group, an ester bond, or an amide bond.

It is preferable that the divalent group having a hydrophilic structure as W is a polyalkyleneoxy group or a group in which $-CH_2CH_2NR^W-$ is bonded to one terminal of a polyalkyleneoxy group. Further, $R^W$ represents a hydrogen atom or an alkyl group.

It is preferable that the divalent group having a hydrophobic structure as W is $-R^{WA}-$, $-O-R^{WA}-O-$, $-R^WN-R^{WA}-NR^W-$, $-OC(=O)-R^{WA}-O-$, or $-OC(=O)-R^{WA}-O-$. Further, $R^{WA}$'s each independently represent a linear, branched, or cyclic alkylene group having 6 to 120 carbon atoms, a haloalkylene group having 6 to 120 carbon atoms, an arylene group having 6 to 120 carbon atoms, an alkarylene group having 6 to 120 carbon atoms (a divalent group obtained by removing one hydrogen atom from an alkylaryl group), or an aralkylene group having 6 to 120 carbon atoms.

It is preferable that the monovalent group having a hydrophilic structure as Y is -OH, -C(=O)OH, a polyalkyleneoxy group having a hydrogen atom or an alkyl group at a terminal, or a group in which $-CH_2CH_2N(R^W)-$ is bonded to a terminal of a polyalkyleneoxy group having a hydrogen atom or an alkyl group at the other terminal.

It is preferable that the monovalent group having a hydrophobic structure as Y is a linear, branched, or cyclic alkyl

group having 6 to 120 carbon atoms, a haloalkyl group having 6 to 120 carbon atoms, an aryl group having 6 to 120 carbon atoms, an alkaryl group (an alkylaryl group) 6 to 120 carbon atoms, an aralkyl group having 6 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoints of the on-press developability, the property of suppressing on-press development scum, and the dispersion stability of particles, the content of the structural unit having a hydrophilic structure in the addition polymerization type resin is preferably in a range of 1% by mass to 50% by mass, more preferably in a range of 5% by mass to 40% by mass, and particularly preferably in a range of 10% by mass to 30% by mass with respect to the total mass of the addition polymerization type resin.

Further, from the viewpoints of the on-press developability, the property of suppressing on-press development scum, and the dispersion stability of particles, in a case where the hydrophilic structure is an ionic group, the content of the structural unit containing an ionic group in the addition polymerization type resin is preferably in a range of 1% by mass to 30% by mass, more preferably in a range of 2% by mass to 20% by mass, and particularly preferably in a range of 4% by mass to 10% by mass with respect to the total mass of the addition polymerization type resin.

- Crosslinked structure -

It is preferable that the addition polymerization type resin further has a crosslinked structure. It is considered that since the addition polymerization type resin has a crosslinked structure, the hardness of the specific polymer particles is improved, the strength of the image area is improved, and thus the printing durability is further improved even in a case where an ultraviolet curable ink that is more likely to deteriorate a plate than other inks is used.

The crosslinked structure is not particularly limited, but a structural unit formed by polymerizing a polyfunctional ethylenically unsaturated compound or a structural unit in which one or more reactive groups form a covalent bond inside a particle. From the viewpoints of the UV printing durability and the on-press developability, the number of functional groups in the polyfunctional ethylenically unsaturated compound is preferably in a range of 2 to 15, more preferably in a range of 3 to 10, still more preferably in a range of 4 to 10, and particularly preferably in a range of 5 to 10.

That is, from the viewpoints of the UV printing durability and the on-press developability, it is preferable that the structural unit having a crosslinked structure is a bifunctional to pentadeca-functional branched unit.

Further, an n-functional branched unit indicates a branched unit having n molecular chains, that is, a structural unit having an n-functional branching point (crosslinked structure).

The ethylenically unsaturated group in the polyfunctional ethylenically unsaturated compound is not particularly limited, and examples thereof include a (meth)acryloxy group, a (meth)acrylamide group, an aromatic vinyl group, and a maleimide group.

Further, it is preferable that the polyfunctional ethylenically unsaturated compound is a polyfunctional (meth) acrylate compound, a polyfunctional (meth)acrylamide compound, or a polyfunctional aromatic vinyl compound.

Examples of the polyfunctional (meth)acrylate compound include diethylene glycol diacrylate, triethylene glycol diacrylate, tetraethylene glycol diacrylate, trimethylolpropane diacrylate, trimethylolpropane triacrylate, 1,4-butanediol diacrylate, 1,6-hexanediol diacrylate, polyethylene glycol diacrylate, polypropylene glycol diacrylate, tricyclodecane dimethylol diacrylate, ditrimethylolpropane tetraacrylate, pentaerythritol triacrylate, pentaerythritol tetraacrylate, dipentaerythritol triacrylate, dipentaerythritol hexaacrylate, and triacrylate of tris(β-hydroxyethyl)isocyanurate.

Examples of the polyfunctional (meth)acrylate compound include N,N'-methylene bisacrylamide, and N-[tris(3-acrylamidopropoxymethyl)methyl]acrylamide.

Examples of the polyfunctional aromatic vinyl compound include divinylbenzene.

The number of carbon atoms in the branch unit is not particularly limited, but is preferably in a range of 8 to 100 and more preferably in a range of 8 to 70.

Further, from the viewpoints of the UV printing durability, the on-press developability, and the strength of particles, as the structural unit having a crosslinked structure, at least one structural unit selected from the group consisting of structural units represented by Formulae BR-1 to BR-17 is preferable, at least one structural unit selected from the group consisting of structural units represented by Formulae BR-1 to BR-10 or Formulae BR-13 to BR-17 is more preferable, at least one structural unit selected from the group consisting of structural units represented by Formulae BR-1 to BR-7 or BR-13 to BR-17 is still more preferable, and a structural unit represented by Formula BR-1 is particularly preferable.

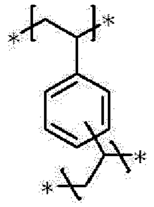

BR - 1

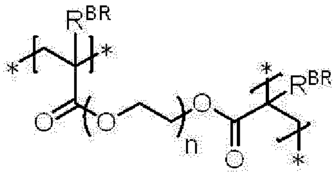

BR - 2

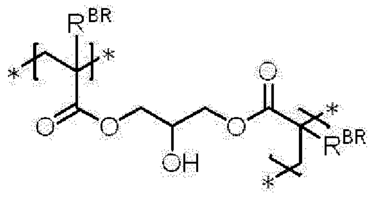

BR - 3

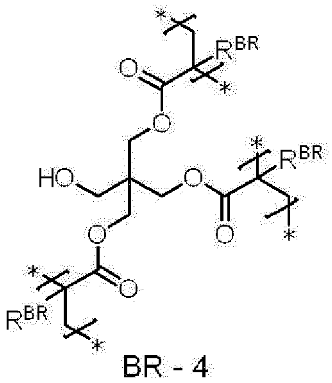

BR - 4

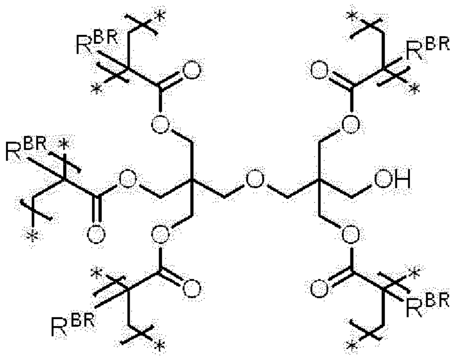

BR - 5

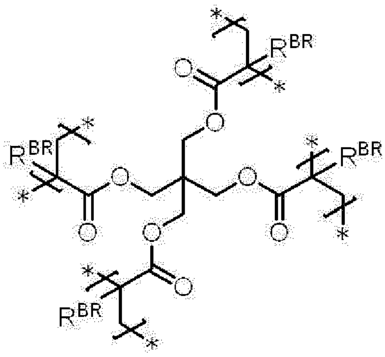

BR - 6

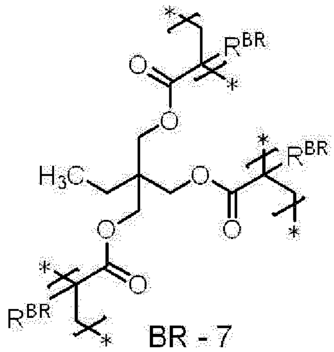

BR - 7

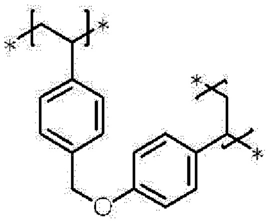

BR - 8

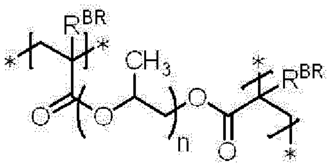

BR - 9

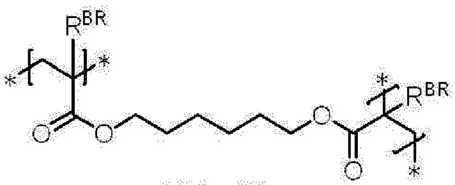

BR - 10

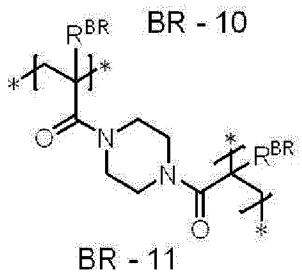

BR - 11

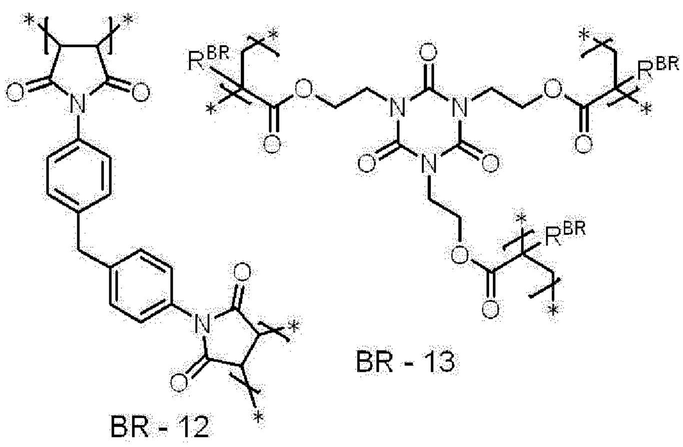

BR - 12

BR - 13

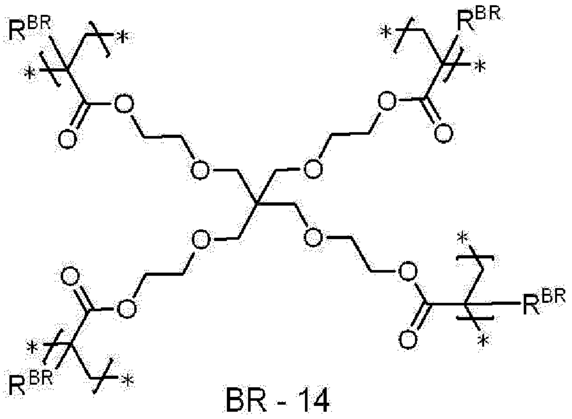
BR - 14

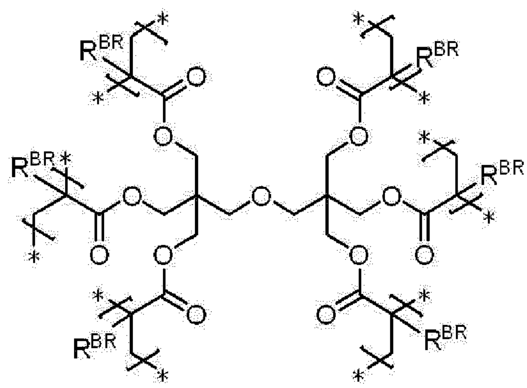
BR - 15

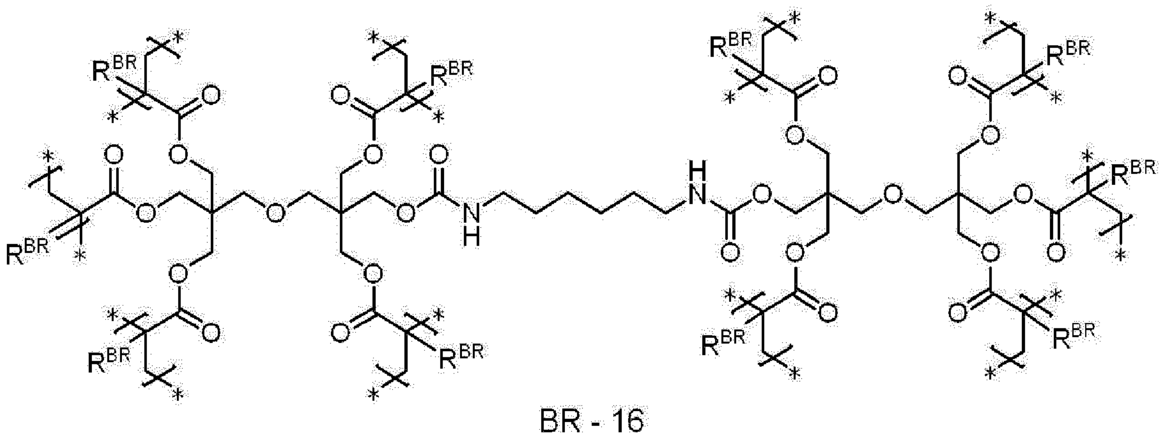
BR - 16

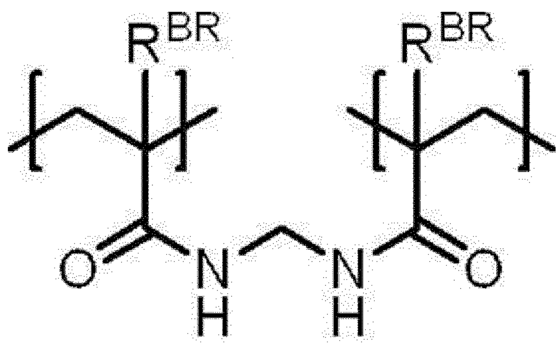
BR - 17

In the above-described structures, $R^{BR}$'s each independently represent a hydrogen atom or a methyl group, and n represents an integer of 1 to 20.

From the viewpoints of the UV printing durability and the on-press developability, the content of the structural unit having a crosslinked structure in the addition polymerization type resin is preferably in a range of 1% by mass to 50% by mass, more preferably in a range of 5% by mass to 45% by mass, still more preferably in a range of 10% by mass to 40% by mass, and particularly preferably in a range of 10% by mass to 35% by mass with respect to the total amount of the addition polymerization type resin.

- Other structural units -

The addition polymerization type resin may have structural units (other structural units) other than the structural unit containing a polymerizable group, the structural unit having a hydrophilic structure, and the structural unit having a crosslinked structure.

Preferred examples of compounds that form other structural units include monofunctional ethylenically unsaturated compounds such as a styrene compound, a (meth)acrylate compound, a (meth)acrylonitrile compound, a (meth)acrylamide compound, a vinyl halide compound, a vinyl ester compound, a vinyl ether compound, and an $\alpha$-olefin compound.

Specific examples thereof include styrene, methyl methacrylate, acrylonitrile, methacrylonitrile, N,N-dimethyl(meth)acrylamide, acryloyl morpholine, 2-hydroxyethyl acrylate, 2,3-dihydroxypropyl methacrylate, 2-ethylhexyl methacrylate, diacetone acrylamide, N-isopropyl acrylamide, cyclohexyl methacrylate, acryloxymethyl ethylene carbonate, p-t-butyl styrene, acrylamide, and methacrylamide.

Among these, from the viewpoint of having a function close to that of a hydrophilic group, the addition polymerization type resin has preferably at least one structural unit selected from the group consisting of a structural unit formed of acrylonitrile, a structural unit formed of dimethyl(meth)acrylamide, a structural unit formed of acryloyl morpholine, a structural unit formed of N-isopropylacrylamide, a structural unit formed of acrylamide, and a structural unit formed of methacrylamide, more preferably at least one structural unit selected from the group consisting of a structural unit formed of methacrylamide, a structural unit formed of acrylamide, a structural unit formed of acrylonitrile, a structural unit formed of methyl methacrylate, and a structural unit formed of styrene, and still more preferably at least one structural unit selected from the group consisting of a structural unit formed of acrylonitrile and a structural unit formed of methacrylamide.

Further, the structural unit formed of acrylonitrile is a structural unit represented by Formula X-1, the structural unit formed of methyl methacrylate is a structural unit represented by Formula X-2, the structural unit formed of styrene is a structural unit represented by Formula X-3, the structural unit formed of acrylamide and methacrylamide is a structural unit represented by Formula X-4 or X-5, and the structural unit formed of acryloyl morpholine is a structural unit represented by Formula X-6.

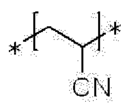
X - 1

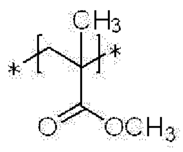
X - 2

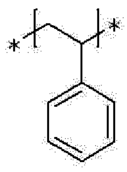
X - 3

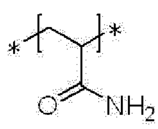
X - 4

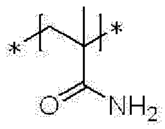
X - 5

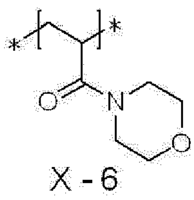
X - 6

The addition polymerization type resin may have only one or two or more other structural units or may not have other structural units.

From the viewpoints of the UV printing durability and the on-press developability, the content of other structural units in the addition polymerization type resin is preferably in a range of 10% by mass to 90% by mass, more preferably in a range of 20% by mass to 85% by mass, still more preferably in a range of 40% by mass to 80% by mass, and particularly preferably in a range of 50% by mass to 75% by mass with respect to the total mass of the addition polymerization type resin.

- Characteristics of particles -

<<Dispersibility>>

From the viewpoints of the developability and the on-press developability, it is preferable that the specific polymer particles used in the present disclosure are water-dispersible polymer particles.

In the present disclosure, in a case where 0.5 g of specific polymer particles are mixed into 100 mL of water in an environment of 20°C, the mixture is poured into a 200 ml three-neck flask and dispersed by being stirred with a three-one motor for 10 minutes (200 rpm), and the resulting solution is allowed to stand in an environment of 20°C for 1 hour, the specific polymer particles are considered to be dispersible in water in a case where a precipitate is not visually confirmed, or a small amount of a precipitate is visually confirmed, but the precipitate can be easily re-dispersed.

In the specific polymer particles, it is preferable that a precipitate is not visually confirmed after the solution is allowed to stand for 1 hour, or a small amount of a precipitate is visually confirmed, but the precipitate can be easily re-dispersed and more preferable that a precipitate is not visually confirmed and the dispersibility is satisfactory.

Further, from the viewpoints of the printing durability, the UV printing durability, the developability, and the on-press developability, it is preferable that the specific polymer particles used in the present disclosure are organic solvent-dispersible polymer particles.

In the present disclosure, the specific polymer particles are considered to be dispersible in an organic solvent in a

case where the particles are dispersed in at least one organic solvent from among a mixed solvent of MEK, MFG, and methanol at a ratio of 48:30:22 (mass ratio, SP value of 11.1), a mixed solvent of 1-propanol and water at a ratio of 1:1 (mass ratio, SP value of 17.7), and a single alcoholic organic solvent (such as methanol, ethanol, 1-propanol, 2-propanol, 1-butanol, or MFG), and the image recording layer in the planographic printing plate precursor according to the embodiment of the present disclosure can be formed by using such a solvent in which the particles are dispersed as a coating solvent described below.

In the present disclosure, MEK represents methyl ethyl ketone, and MFG represents 1-methoxy-2-propanol.

In the present disclosure, in a case where 0.5 g of specific polymer particles are mixed into at least one of the 100 mL solvent described above in an environment of 20°C, the mixture is dispersed by being stirred for 10 minutes, and the resulting solution is allowed to stand in an environment of 20°C for 1 hour, the specific polymer particles are considered to be dispersible in an organic solvent in a case where a small amount of precipitate is visually confirmed, but the precipitate can be easily re-dispersed.

In the specific polymer particles, it is preferable that a small amount of precipitate is visually confirmed after the solution is allowed to stand for 1 hour, but the precipitate can be easily re-dispersed and more preferable that a precipitate is not visually confirmed and the dispersibility is satisfactory.

In a case where the specific polymer particles according to the present disclosure are dispersible in an organic solvent, the coating can be performed in a state where the particles are satisfactorily dispersed in a coating solution in a case of forming an image recording layer. It is considered that in a case where an image recording layer is formed using such a coating solution, since particles are unlikely to be applied in an aggregated state, the coated surface state of the image recording layer is excellent, and the printing durability, the UV printing durability, the developability, and the on-press developability are likely to be excellent.

The SP value of the solvent used as a coating solvent is preferable in a range of 9.3 to 18.0, more preferably in a range of 10.0 to 15.0, and still more preferably in a range of 10.5 to 12.5. It is preferable that the specific polymer particles in the present disclosure are dispersible in an organic solvent having the above-described SP value.

Further, the SP values of representative solvents are as follows.

MEK (SP value = 9.3), MFG (SP value = 11.2), methanol (SP value = 14.7), ethanol (SP value = 12.4), 1-propanol (SP value = 11.9), 2-propanol (SP value = 11.2), 1-butanol (SP value = 11.4), and water (SP value = 23.4)

The SP value in the present specification is set as a value calculated by an Okitsu method (Toshinao Okitsu, "Journal of the Adhesion Society of Japan" Vol. 29 (5) (1993)).

Specifically, the SP value is calculated based on the following equation. Further, ΔF is a value described in the documents.

$$\text{SP value } (\delta) = \Sigma\Delta F \text{ (Molar Attraction Constants)/V (molar volume)}$$

Further, the unit of the SP value in the present specification is $MPa^{1/2}$.

Further, in a case where a mixture of a plurality of organic solvents is used as the organic solvent, the SP value is acquired as a weighted average value according to the content mass ratio of each organic solvent.

Specifically, the weighted average value is "X" acquired by Mathematical Formula 1.

Specifically, the SP value of the organic solvent A containing two or more organic solvents is X calculated by substituting the SP value of the i-th type organic solvent (i represents an integer of 1 or greater) to be contained for Si and substituting the mass content ratio of the i-th type organic solvent in the entire organic solvent A for Wi, in Mathematical Formula 1.

$$X = \frac{\sum(Si \times Wi)}{\sum Wi} \quad \text{Mathematical Formula 1}$$

<<Median diameter>>

From the viewpoint of improving the UV printing durability, the median diameter of the specific polymer particles is preferably 1000 nm or less and more preferably in a range of 50 nm to 300 nm.

The method of measuring the median diameter is as described above.

<<Coefficient of variation>>

The coefficient of variation in particle diameter of the specific polymer particles is 100% or less, more preferably 50% or less, and still more preferably 30% or less.
The lower limit of the coefficient of variation is not particularly limited and may be 0%.
The coefficient of variation can be decreased by appropriately setting the reaction conditions such as the stirring speed and the temperature and increasing the content of the hydrophilic structure (particularly the amount of polyalkylene oxide structure) in the addition polymerization type resin.
In the present disclosure, the coefficient of variation in particle diameter of the specific polymer particles is measured by directly observing the particle diameter according to the following microscopic method.
The details of the measurement carried out by directly observing the particle diameter according to the microscopic method described above will be described in detail.

1. Preparation of sample

1 g of a dispersion liquid containing the specific polymer particles is spread on an aluminum cup, solidified by natural drying, and ground in a mortar, thereby obtaining a powder sample.

2. SEM measurement

The obtained sample is measured using a scanning electron microscope (SEM, manufactured by JEOL Ltd.). After two fields of view where the number of particles is 50 or more are obtained, the particle diameters of all the particles are measured according to the Feret method (interposed between parallel lines: widths of parallel lines = diameters) to obtain particle diameters of 100 or more particles.

3. Coefficient of variation

After the numerical values are arranged in order of the particle diameters, similar to the definition of the median diameter, the point where the number of large particles is the same as the number of small particles is defined as the central particle diameter, and the coefficient of variation in particles according to the microscopic method is acquired from the range of vibration of the central particle diameter.

[Core shell particle]

The planographic printing plate precursor according to the embodiment of the present disclosure includes a support and an image recording layer on the support, the image recording layer contains an infrared absorbing agent, a polymerization initiator, and core shell particles, a core portion of each core shell particle contains an addition polymerization type resin A (hereinafter, also simply referred to as a "resin A") containing a functional group A, the addition polymerizable resin A in the core portion has a hydrophilic structure, and a shell portion of each core shell particle contains a compound B containing a polymerizable group and a functional group B that is bondable to or interactable with the functional group A.
Further, in the resin A or the compound B, the resin A or the resin B may each independently have only one or two or more of respective structural units described below unless otherwise specified.

<<Functional group A and functional group B>>

In the core shell particle, the functional group A and the functional group B are functional groups that is bondable to or interactable with each other.
Examples of the bond which can be formed by the functional group A and the functional group B include a covalent bond, an ionic bond, and a hydrogen bond. Further, examples of the interaction which can be made by the functional group A and the functional group B include dipole interaction.

- Group capable of covalent bonding between functional group A and functional group B -

The group that is capable of covalent bonding between the functional group A and the functional group B is not particularly limited as long as the group is capable of forming a covalent bond through the reaction between the functional group A and the functional group B, and examples thereof include a hydroxy group, a carboxy group, an amino group, an amide group, an epoxy group, an isocyanate group, a thiol group, a glycidyl group, an aldehyde group, and a sulfonic acid

group. Among these, from the viewpoint of the UV printing durability, a hydroxy group, a carboxy group, an amino group, and an epoxy group are preferable, and a hydroxy group and a carboxy group are more preferable.

- Group capable of ionic bonding between functional group A and functional group B -

The group that is capable of ionic bonding between the functional group A and the functional group B is not particularly limited as long as one of the functional group A and the functional group B contains a cationic group and the other contains an anionic group.

It is preferable that the cationic group is an onium group. Examples of the onium group include an ammonium group, a pyridinium group, a phosphonium group, an oxonium group, a sulfonium group, a selenonium group, and an iodonium group. Among these, from the viewpoint of the UV printing durability, an ammonium group, a pyridinium group, a phosphonium group, or a sulfonium group is preferable, an ammonium group or a phosphonium group is more preferable, and an ammonium group is particularly preferable.

The anionic group is not particularly limited, and examples thereof include a phenolic hydroxyl group, a carboxy group, $-SO_3H$, $-OSO_3H$, $-PO_3H$, $-OPO_3H_2$, $-CONHSO_2-$, and $-SO_2NHSO_2-$. Among these, a phosphoric acid group, a phosphonic acid group, a phosphinic acid group, a sulfuric acid group, a sulfonic acid group, a sulfinic acid group, or a carboxy group is preferable, a phosphoric acid group or a carboxy group is more preferable, and a carboxy group is still more preferable.

- Group capable of hydrogen bonding between functional group A and functional group B -

The group that is capable of hydrogen bonding is not particularly limited as long as one of the functional group A and the functional group B has a hydrogen bond-donating site and the other has a hydrogen bond receiving site.

The hydrogen bond-donating site may have a structure that has an active hydrogen atom capable of hydrogen bonding, and a structure represented by X-H is preferable.

X represents a hetero atom. Among hetero atoms, a nitrogen atom or an oxygen atom is preferable.

From the viewpoint of the UV printing durability, as the hydrogen bond-donating site, at least one structure selected from the group consisting of a hydroxy group, a carboxy group, a primary amide group, a secondary amide group, a primary amino group, a secondary amino group, a primary sulfonamide group, a secondary sulfonamide group, an imide group, a urea bond, and a urethane bond is preferable, at least one structure selected from the group consisting of a hydroxy group, a carboxy group, a primary amide group, a secondary amide group, a primary sulfonamide group, a secondary sulfonamide group, a maleimide group, a urea bond, and a urethane bond is more preferable, least one structure selected from the group consisting of a hydroxy group, a carboxy group, a primary amide group, a secondary amide group, a primary sulfonamide group, a secondary sulfonamide group, and a maleimide group is still more preferable, and at least one structure selected from the group consisting of a hydroxy group and a secondary amide group is particularly preferable.

The hydrogen bond receiving site may be a structure having an atom with an unshared electron pair, and a structure having an oxygen atom with an unshared electron pair is preferable, at least one structure selected from the group consisting of a carbonyl group (including a carbonyl structure such as a carboxy group, an amide group, an imide group, a urea bond, or a urethane bond) and a sulfonyl group (including a sulfonyl structure such as a sulfonamide group) is more preferably, and a carbonyl group (including a carbonyl structure such as a carboxy group, an amide group, an imide group, a urea bond, or a urethane bond) is particularly preferable.

As the group capable of hydrogen bonding between the functional group A and the functional group B, a group having the above-described hydrogen bond-donating site and the above-described hydrogen bond receiving site is preferable, a group containing a carboxy group, an amide group, an imide group, a urea bond, a urethane bond, or a sulfonamide group is preferable, and a group containing a carboxy group, an amide group, an imide group, or a sulfonamide group is more preferable.

- Group capable of dipole interaction between functional group A and functional group B -

The group capable of dipole interaction between the functional group A and the functional group B may be a group having a polarized structure other than the structure represented by X-H (X represents a hetero atom, a nitrogen atom, or an oxygen atom) in the group capable of hydrogen bonding described above, and suitable examples thereof include a group to which atoms with different electronegativities are bonded.

As a combination of atoms with different electronegativities, a combination of a carbon atom and at least one atom selected from the group consisting of an oxygen atom, a nitrogen atom, a sulfur atom, and a halogen atom is preferable, and a combination of a carbon atom and at least one atom selected from the group consisting of an oxygen atom, a nitrogen atom, and a sulfur atom is more preferable.

Among these, from the viewpoint of the UV printing durability, a combination of a nitrogen atom and a carbon atom and a combination of a carbon atom, a nitrogen atom, an oxygen atom, and a sulfur atom are preferable. Specifically, a cyano group, a cyanuric group, and a sulfonic acid amide group are more preferable.

Further, it is preferable that the functional group A and the functional group B are groups capable of the same dipole interaction.

The bond between the functional group A and the functional group B and the interaction between the functional group A and the functional group B can be confirmed by the following method.

Specifically, 2 g of the resin A (concentration of solid contents: 20 mass% aqueous solution) and 8 g of the compound B (concentration of solid contents: 7.5 mass% MFG (2-methoxy-2-propanol solution)) are allowed to react or mixed and centrifuged at 21000 Xg for 60 minutes to collect a precipitate. Next, the precipitate is washed with a solvent that dissolves the compound B to wash the compound B containing the functional group B that does not react with or interact with the functional group A, and the precipitate is dried at 40°C.

It can be determined that the functional group A and the functional group B are bonded or interact with each other at an optional ratio in a case where infrared absorption spectrum (IR) measurement is performed on the dried material of the precipitate, an increase in weight before and after the reaction or the mixing is quantified, the number of absorption peaks derived from the functional group B in IR measurement is increased, and the weight of the dried solid material is decreased.

As the functional group B that is bondable to or interactable with the functional group A (that is, the functional group A that is bondable to or interactable with the functional group B), a group capable of covalent bonding to the functional group (hereinafter, also simply referred to as a "group capable of covalent bonding"), a group capable of ionic bonding to the functional group A (hereinafter, also simply referred to as a "group capable of ionic bonding"), a group capable of hydrogen bonding to the functional group A (hereinafter, also simply referred to as a "group capable of hydrogen bonding"), or a group capable of dipole interaction with the functional group A (hereinafter, also simply referred to as a "group capable of dipole interaction") is preferable from the viewpoint of the UV printing durability, and a group capable of ionic bonding, a group capable of hydrogen bonding, or a group capable of dipole interaction is more preferable from the viewpoint of the UV printing durability.

- Group capable of covalent bonding -

The group capable of covalent bonding is appropriately selected according to the kinds of the functional group A and the functional group B.

In a case where one of the functional group A and the functional group B is, for example, a carboxy group, examples of the group capable of covalent bonding to the carboxy group include a hydroxy group and a glycidyl group.

Further, in a case where one of the functional group A and the functional group B is, for example, $-NH_2$ (primary amino group), examples of the group capable of covalent bonding to $-NH_2$ include an isocyanate group and a glycidyl group.

- Group capable of Ionic bonding -

The group capable of ionic bonding to the functional group A is appropriately selected according to the kinds of the functional group A and the functional group B. As a combination of functional groups forming an ionic bond on the surface of each core shell particle, for example, the compound B that can be bonded is required to contain a basic group in a case where the surface of the core shell particle (resin A) contains an acidic group.

Examples of the acidic group include a carboxylic acid, a sulfonic acid, a phosphoric acid group, a polymerization residue of (meth)acrylic acid, and a polymerization residue of a (meth)acrylic acid derivative containing a carboxy group at a terminal. From the viewpoint of increasing the acid value, a polymerization residue of (meth)acrylic acid is preferable.

In a case where one of the functional group A and the functional group B is, for example, a carboxy group, examples of the group capable of ionic bonding to the carboxy group include a tertiary amino group, a pyridyl group, and a piperidyl group.

In a case where one of the functional group A and the functional group B is, for example, a sulfonic acid group, examples of the group capable of ionic bonding to the sulfonic acid group include a tertiary amino group.

In a case where one of the functional group A and the functional group B is, for example, $-SO_3^-$, examples of the group capable of ionic bonding to $-SO_3^-$ include a cationic group such as a quaternary ammonium group.

In a case where one of the functional group A and the functional group B is a phosphoric acid group, examples of the group capable of ionic bonding to the phosphoric acid group include a tertiary amino group.

- Group capable of hydrogen bonding -

The group capable of hydrogen bonding is appropriately selected according to the kinds of the functional group A and the functional group B.

In a case where one of the functional group A and the functional group B is a carboxy group, examples of the group capable of hydrogen bonding to the carboxy group include an amide group and a carboxy group.

In a case where one of the functional group A and the functional group B is a phenolic hydroxyl group, examples of the group capable of hydrogen bonding to the phenolic hydroxyl group include a phenolic hydroxyl group.

- Group capable of dipole interaction -

The group capable of dipole interaction is appropriately selected according to the kinds of the functional group A and the functional group B.

As a preferred example of a combination of functional groups forming a bond using dipole interaction on the surface of each core shell particle (resin A), the dipole interaction works on the compound B capable of bonding to the surface of the core shell particle (resin A), and the resin A and the compound B contains functional groups having the same skeleton.

Examples of the functional group on which the dipole interaction works include a sulfonic acid amide group, a cyano group, and a cyanuric group. Among these, a cyano group is preferable.

In a case where one of the functional group A and the functional group B is, for example, a cyano group, examples of the group capable of dipole interaction with the cyano group include a cyano group.

In a case where one of the functional group A and the functional group B is a sulfonic acid amide group, examples of the group capable of dipole interaction with the sulfonic acid amide group include a sulfonic acid amide group.

<<Examples of bonding or interaction>>

Specific examples of bonding or interaction between the functional group A and the functional group B are shown below, but the bonding or interaction between the functional group A and the functional group B in the present disclosure is not limited thereto.

Covalent bond

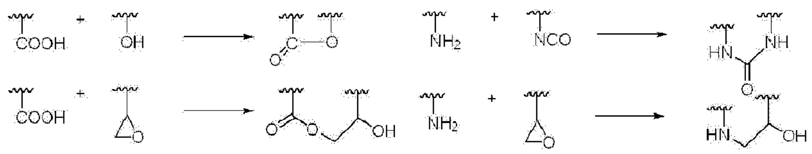

Ionic bond

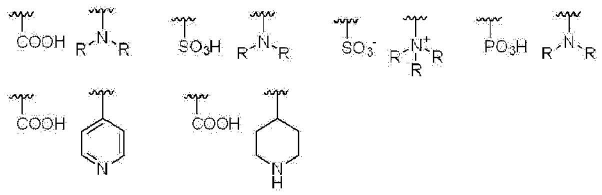

Hydrogen bond

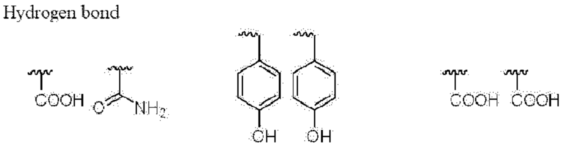

Dipole interaction

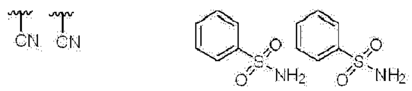

<<Core portion>>

The core portion of a core shell particle contains the addition polymerizable resin A (resin A) containing a functional group A, and the addition polymerizable resin A has a hydrophilic structure.
The hydrophilic structure has the same definition as that for the hydrophilic structure in the specific polymer particles, and the preferred embodiments thereof are also the same as described above.

[Addition polymerization type resin A]

From the viewpoints of the UV printing durability and ease of manufacturing, the addition polymerization type resin A (resin A) is preferably an acrylic resin, a styrene-acrylic copolymer, a polyurea resin, or a polyurethane resin, more preferably an acrylic resin, a styrene-acrylic copolymer, or a polyurethane resin, and still more preferably an acrylic resin.
As the acrylic resin, a resin in which the content of a structural unit formed of a (meth)acrylic compound (a structural unit derived from a (meth)acrylic compound) is 50% by mass or greater with respect to the total mass of the resin is preferable.
Suitable examples of the (meth)acrylic compound include a (meth)acrylate compound and a (meth)acrylamide compound.
The resin A may be used alone or in combination of two or more kinds thereof. Further, the resin A may be in a latex state.
The functional group A contained in the resin A is not particularly limited as long as the functional group A is bondable to or interactable with the functional group B contained in the compound B. The functional group A can be appropriately set according to the kind of the functional group B described below.
The resin A may contain a single functional group A or a combination of two or more kinds thereof.
In the resin A, from the viewpoint of the UV printing durability, the functional group A is preferably at least one group selected from the group consisting of a carboxy group, a cyano group, and an amino group and more preferably an amino group.
Further, it is preferable that the resin A has a structural unit having a functional group A.

- Structural unit containing cyano group (-CN) -

From the viewpoint of the UV printing durability, it is preferable that the resin A has a structural unit formed of a compound containing a cyano group.
It is preferable that the cyano group is introduced to the resin A as a structural unit containing a cyano group, typically using a compound (monomer) containing a cyano group. Examples of the compound containing a cyano group include an acrylonitrile compound, and suitable examples thereof include (meth)acrylonitrile.
As the structural unit containing a cyano group, a structural unit formed of an acrylonitrile compound is preferable, and a structural unit formed of (meth)acrylonitrile is more preferable.
Further, preferred examples of the structural unit formed of a compound containing a cyano group include a structural unit represented by Formula a1.

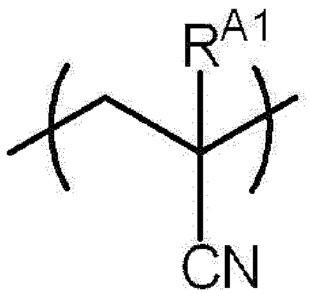
Formula a1

In Formula a1, $R^{A1}$ represents a hydrogen atom or an alkyl group.
In Formula a1, $R^{A1}$ represents preferably a hydrogen atom or an alkyl group having 1 to 4 carbon atoms, more preferably a hydrogen atom or a methyl group, and still more preferably a hydrogen atom.
In a case where the resin A has a structural unit containing a cyano group, from the viewpoint of the UV printing durability, the content of the structural unit containing a cyano group is preferably in a range of 5% by mass to 90% by mass, more preferably in a range of 20% by mass to 80% by mass, and particularly preferably in a range of 30% by mass to 60% by mass with respect to the total mass of the resin A.

- Structural unit containing carboxy group (-COOH) -

From the viewpoint of the UV printing durability, it is preferable that the resin A has a structural unit containing a carboxy group. It is preferable that the carboxy group is introduced to the resin A as a structural unit containing a carboxy group, typically using a compound (monomer) containing a carboxy group.
The structural unit containing a carboxy group may be a structural unit formed of a compound containing a carboxy group such as acrylic acid, methacrylic acid, itaconic acid, crotonic acid, isocrotonic acid, or maleic acid.
It is preferable that the resin A has at least one structural unit selected from the group consisting of a structural unit formed of acrylic acid and a structural unit represented by Formula a2.

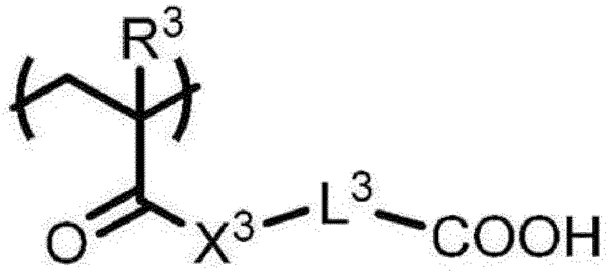

Formula a2

In Formula a2, $R^3$ represents a hydrogen atom or a methyl group, $X^3$ represents -O- or $-NR^7-$, $R^7$ represents a hydrogen atom or an alkyl group, and $L^3$ represents a single bond or a divalent hydrocarbon group having 1 or more carbon atoms.
In Formula a2, in a case where $X^3$ represents $-NR^7$, $R^7$ represents preferably a hydrogen atom or an alkyl group having 1 to 4 carbon atoms, more preferably a hydrogen atom or a methyl group, and still more preferably a hydrogen atom.
In Formula a2, $L^3$ represents a single bond or a divalent hydrocarbon group having 1 or more carbon atoms, preferably a single bond or a divalent hydrocarbon group which may have an ester bond or an ether bond therein, more preferably a single bond or a divalent hydrocarbon group, and still more preferably a single bond or a divalent saturated aliphatic hydrocarbon group. In a case where $L^3$ represents a divalent hydrocarbon group, the number of carbon atoms in the divalent hydrocarbon group as $L^3$ is preferably in a range of 2 to 15 and more preferably in a range of 3 to 12.
The content of the structural unit containing a carboxy group (preferably a structural unit a2) is preferably in a range of 5% by mass to 70% by mass and more preferably in a range of 10% by mass to 55% by mass with respect to the total mass of the resin A.

- Structural unit containing amino group -

From the viewpoint of the UV printing durability, it is preferable that the resin A has a structural unit formed of a compound containing an amino group.
The amino group may be a primary amino group, a secondary amino group, or a tertiary amino group. From the viewpoint of the UV printing durability, a (meth)acrylamide group is preferable, and methacrylamide or acrylamide is more preferable.
The content of the structural unit containing an amino group is preferably in a range of 5% by mass to and 70% by mass, more preferably in a range of 10% by mass to 50% by mass, and still more preferably in a range of 10% by mass to 40% by mass with respect to the total mass of the resin A.

<<Structural unit having hydrophilic structure>>

The resin A contained in the core portion of a core shell particle has a hydrophilic structure and preferably a structural unit having a hydrophilic structure. The hydrophilic structure and the structural unit having a hydrophilic structure are the same as those described above, and the preferred embodiments thereof are also the same as described above.
From the viewpoint of the UV printing durability, the content of the structural unit having a hydrophilic structure is preferably 50% by mass or less, more preferably in a range of 1% by mass to 20% by mass, and still more preferably in a range of 2% by mass to 10% by mass with respect to the total mass of the resin A.
Further, it is preferable that the resin A further has a structural unit having a crosslinked structure.

<<Structural unit having crosslinked structure>>

From the viewpoint of the UV printing durability, the resin A contained in the core portion of a core shell particle further has preferably a crosslinked structure and more preferably a structural unit having a crosslinked structure.

Examples of the structural unit having a crosslinked structure include the above-described structural unit having a crosslinked structure, and the preferred embodiments thereof are also the same as described above.

In a case where the resin A has a structural unit having a crosslinked structure, from the viewpoints of the UV printing durability and the on-press developability, the content of the structural unit having a crosslinked structure in the resin A is preferably in a range of 1% by mass to 50% by mass, more preferably in a range of 5% by mass to 45% by mass, still more preferably in a range of 10% by mass to 40% by mass, and particularly preferably in a range of 10% by mass to 35% by mass with respect to the total amount of the resin A.

<<Structural unit containing hydrophobic group>>

In the core shell particles, the resin A contained in the core portion may have a structural unit containing a hydrophobic group from the viewpoint of the ink impressing property.

Examples of the hydrophobic group include an alkyl group, an aryl group and an aralkyl group.

As the structural unit containing a hydrophobic group, a structural unit formed of an alkyl(meth)acrylate compound, an aryl(meth)acrylate compound, or an aralkyl(meth)acrylate compound is preferable, and a structural unit formed of an alkyl(meth)acrylate compound is more preferable.

The number of carbon atoms in the alkyl group in the alkyl (meth)acrylate compound is preferably in a range of 1 to 10. The alkyl group may be linear or branched and may have a cyclic structure. Examples of the alkyl (meth)acrylate compound include methyl (meth)acrylate, ethyl (meth)acrylate, propyl (meth)acrylate, cyclohexyl (meth)acrylate, 2-ethylhexyl (meth)acrylate, and dicyclopentanyl (meth)acrylate.

The aryl group in the aryl (meth)acrylate compound preferably has 6 to 20 carbon atoms and is more preferably a phenyl group. Further, the aryl group may have a known substituent. Preferred examples of the aryl (meth)acrylate compound include phenyl (meth)acrylate.

The carbon number of the alkyl group in the aralkyl (meth)acrylate compound is preferably in a range of 1 to 10. The alkyl group may be linear or branched and may have a cyclic structure. Further, the aryl group in the aralkyl(meth) acrylate compound preferably has 6 to 20 carbon atoms and is more preferably a phenyl group. Preferred examples of the aralkyl (meth)acrylate compound include benzyl (meth)acrylate.

In the core shell particles, the content of the structural unit containing a hydrophobic group in the resin A contained in the core portion is preferably in a range of 5% by mass to 50% by mass and more preferably in a range of 10% by mass to 30% by mass with respect to the total mass of the resin A.

In the core shell particles, the resin A contained in the shell portion may have structural units other than the above-described structural units in the resin A without particular limitation, and examples thereof include a structural unit formed of a vinyl ether compound or the like.

Examples of the vinyl ether compound include methyl vinyl ether, ethyl vinyl ether, propyl vinyl ether, n-butyl vinyl ether, tert-butyl vinyl ether, 2-ethylhexyl vinyl ether, n-nonyl vinyl ether, lauryl vinyl ether, cyclohexyl vinyl ether, cyclohexyl methyl vinyl ether, 4-methylcyclohexyl methyl vinyl ether, benzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethylcyclohexylmethyl vinyl ether, diethylene glycol monovinyl ether, polyethylene glycol vinyl ether, chloroethyl vinyl ether, chlorobutyl vinyl ether, chloroethoxyethyl vinyl ether, phenylethyl vinyl ether, and phenoxy polyethylene glycol vinyl ether.

In a case where the resin A has other structural units, the content of other structural units is preferably in a range of 5% by mass to 50% by mass and more preferably in a range of 10% by mass to 30% by mass with respect to the total mass of the resin A.

The core portion may contain the resin A, and from the viewpoint of the UV printing durability, the content of the resin A in the core portion is preferably 80% by mass or greater, more preferably 90% by mass or greater, and still more preferably and 95% by mass or greater, and it is particularly preferable that the core portion is formed of the resin A.

Further, the core portion is preferably a particle and more preferably a particle formed of the resin A.

[Shell portion]

The shell portion of the core shell particle contains the compound B containing a polymerizable group and the functional group B that is bondable to or interactable with the functional group A.

<<Compound B>>

The compound B contained in the shell portion of a core shell particle contains a polymerizable group and the functional group B that is bondable to or interactable with the functional group A.

The compound B may be a monomer or a polymer.

In the present disclosure, a polymer indicates a compound having a weight-average molecular weight of 1000 or greater. Further, in a case where the compound B is a polymer, the compound B will be also referred to as the resin B.

Further, the monomer indicates a compound having a weight-average molecular weight of less than 1000.

In a case where the compound B is a polymer, the resin B may be an addition polymerization type resin or a polycondensation resin, but from the viewpoints of the UV printing durability and ease of manufacturing, the resin B is preferably an acrylic resin, a polyurea resin, or a polyurethane resin, more preferably an acrylic resin or a polyurethane resin, and particularly preferably an acrylic resin.

As the acrylic resin, a resin in which the content of a structural unit formed of a (meth)acrylic compound (a structural unit derived from a (meth)acrylic compound) is 50% by mass or greater with respect to the total mass of the resin is preferable.

Suitable examples of the (meth)acrylic compound include a (meth)acrylate compound and a (meth)acrylamide compound.

The compound B contains the functional group B is bondable to or interactable with the functional group A. Examples of the functional group B that is bondable to or interactable with the functional group A include the above-described groups that is bondable to or interactable with the functional group.

The compound B may contain only one or two or more functional groups B.

In the compound B, from the viewpoint of the UV printing durability, the functional group B is preferably at least one group selected from the group consisting of primary to tertiary amino groups, a carboxy group, an epoxy group, and a cyano group, more preferably any of primary to tertiary amino groups or a cyano group, and particularly preferably any of primary to tertiary amino groups.

Further, in a case where the compound B is a polymer, it is preferable that the compound B has a structural unit containing a functional group B.

In a case where the compound B is a polymer, from the viewpoint of the UV printing durability, it is preferable that the resin B has a structural unit containing an amino group, a structural unit represented by Formula a3, or a structural unit represented by Formula a1 (a structural unit containing a cyano group) as the structural unit containing the functional group B that is bondable to or interactable with the functional group A.

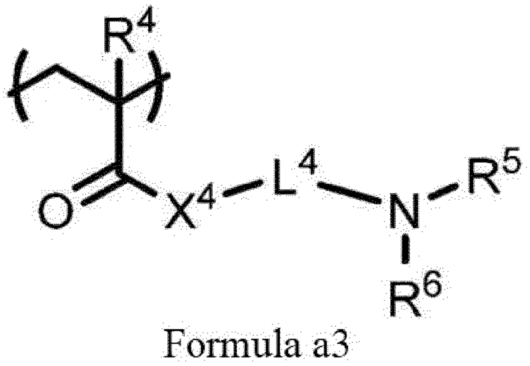

Formula a3

In Formula a3, $R^4$ represents a hydrogen atom or a methyl group, $X^4$ represents -O- or -$NR^8$-, $R^8$ represents a hydrogen atom or an alkyl group, at least two of $L^4$, $R^5$, and $R^6$ may be bonded to form a ring, $L^4$ represents a single bond or a divalent hydrocarbon group having 1 or more carbon atoms, $R^5$ and $R^6$ each independently represent a monovalent hydrocarbon group having 1 or more carbon atoms, and each * independently represents a binding site with respect to another structure.

In Formula a3, in a case where $X^4$ represents -$NR^8$, $R^8$ represents preferably a hydrogen atom or an alkyl group having 1 to 4 carbon atoms, more preferably a hydrogen atom or a methyl group, and more preferably a hydrogen atom.

In Formula a3, $L^4$ represents a single bond or a divalent hydrocarbon group having 1 or more carbon atoms, preferably a single bond or a divalent hydrocarbon group which may have a urea bond or an ether bond, more preferably a single bond or a divalent hydrocarbon group, and still more preferably a single bond or a divalent saturated aliphatic hydrocarbon group. The number of carbon atoms of $L^4$ is more preferably in a range of 2 to 10 and still more preferably in a range of 2 to 8.

$R^5$ and $R^6$ each independently represent a monovalent hydrocarbon group having 1 or more carbon atoms and

preferably a saturated aliphatic hydrocarbon group having 1 or more carbon atoms. $R^5$ and $R^6$ each independently have preferably 1 to 10 carbon atoms, more preferably 1 to 5 carbon atoms, and still more preferably 1 to 3 carbon atoms.

From the viewpoint of improving the UV printing durability and increasing the number of functional groups in the resin A, in the resin B of Formula a3, it is preferable that $X^4$ represents -O-, $L^4$ represents a divalent saturated aliphatic hydrocarbon group having 2 to 10 carbon atoms, and $R^5$ and $R^6$ each independently represent a saturated aliphatic hydrocarbon group having 1 to 5 carbon atoms and more preferable that $X^4$ represents -O-, $L^4$ represents a divalent saturated aliphatic hydrocarbon group having 2 to 8 carbon atoms, and $R^5$ and $R^6$ each independently represent a saturated aliphatic hydrocarbon group having 1 to 3 carbon atoms.

<<Polymerizable group>>

The compound B contains a polymerizable group. The polymerizable group contained in the compound B may be a cationically polymerizable group or a radically polymerizable group, but from the viewpoint of the reactivity, a radically polymerizable group is preferable.

The polymerizable group contained in the compound B is not particularly limited as long as the group can be polymerized, but an ethylenically unsaturated group is preferable, a vinylphenyl group (styryl group), a (meth)acryloxy group, or a (meth)acrylamide group is more preferable, and a (meth)acryloxy group is particularly preferable, from the viewpoints of the reactivity and the UV printing durability.

Further, the introduction of these polymerizable groups to the compound B can be carried out by a method of introducing polymerizable groups using residues of polyfunctional monomers to be added in a case of synthesis of core shell particles or a method of introducing polymerizable groups to the surface of each particle through the polymer reaction after synthesis of core shell particles, and the method can be appropriately selected. In the present disclosure, the method of introducing polymerizable groups through the polymer reaction after synthesis of core shell particles is desirable. This is because more active polymerizable groups can be allowed to be present on the surface of each core shell particle in a case where the polymerizable groups are introduced after the synthesis of core shell particle, and thus the reactivity of the polymerizable groups with the matrix is enhanced and the polymerizable groups are likely to be strongly crosslinked with the matrix.

Other embodiments such as the structural unit containing a polymerizable group contained in the compound B are the same as those in the description of the polymerizable group in the specific polymer particles, and the preferred embodiments thereof are also the same as described above.

In a case where the compound B is a polymer, from the viewpoint of the UV printing durability, the content of the structural unit containing a polymerizable group in the resin B is preferably in a range of 10% by mass to 60% by mass, more preferably in a range of 20% by mass to 55% by mass, and particularly preferably in a range of 30% by mass to 50% by mass with respect to the total mass of the resin B.

The polymerizable group value (the amount of the polymerizable group per 1 g of the compound B) (preferably an ethylenically unsaturated group value) of the core shell particles is preferably in a range of 0.05 mmol/g to 5 mmol/g and more preferably in a range of 0.2 mmol/g to 3 mmol/g. The polymerizable group value and the ethylenically unsaturated group value are measured by an iodometric titration method.

<<Structural unit having hydrophilic structure>>

From the viewpoint of the UV printing durability, it is preferable that the resin B has a structural unit having a hydrophilic structure.

It is preferable that the structural unit contains a group represented by Formula Z as the hydrophilic structure. The group represented by Formula Z has the same definition as that for the group represented by Formula Z, and the preferable range thereof is also the same as described above.

In a case where the resin B has a hydrophilic structure, from the viewpoint of the UV printing durability, the content of the structural unit having a hydrophilic structure in the resin B is preferably in a range of 10% by mass to 60% by mass, more preferably in a range of 20 % by mass to 55% by mass, and particularly preferably in a range of 30% by mass to 50% by mass with respect to the total amount of the resin B.

<<Structural unit formed of aromatic vinyl compound>>

In a case where the compound B is a polymer, the resin B may further have a structural unit formed of an aromatic vinyl compound, but it is preferable that the resin B does not have the structural unit from the viewpoint of the UV printing durability.

The structural unit formed by the aromatic vinyl compound in the resin B has the same definition as that for the structural unit formed of the aromatic vinyl compound in the resin A, and the preferred embodiments are also the same as

described above.

From the viewpoint of the ink impressing property, the content of the structural unit formed of the aromatic vinyl compound in the resin B is preferably 20% by mass or less and more preferably 10% by mass or less with respect to the total mass of the resin B. Further, it is particularly preferable that the resin B does not have the structural unit formed of the aromatic vinyl compound.

<<Structural unit having crosslinked structure>>

In a case where the compound B is a polymer, the resin B may have a crosslinked structure from the viewpoint of the UV printing durability.

The crosslinked structure and the structural unit having the crosslinked structure in the resin B each have the same definition as that for the crosslinked structure and the structural unit having the crosslinked structure described above, and the preferred embodiments are also the same as described above.

From the viewpoints of the UV printing durability and the on-press developability, the content of the structural unit having a crosslinked structure in the resin B is preferably in a range of 0.1% by mass to 20% by mass, more preferably in a range of 0.5% by mass to 15% by mass, and particularly preferably in a range of 1% by mass to 10% by mass with respect to the total mass of the resin B.

<<Structural unit containing hydrophobic group>>

In a case where the compound B is a polymer, the resin B may have a structural unit having a hydrophobic group from the viewpoint of the ink impressing property.

The structural unit containing a hydrophobic group in the resin B has the same definition as that for the structural unit having a hydrophobic group in the resin A, and the preferred embodiments are also the same as described above.

In a case where the resin B has a structural unit containing a hydrophobic group, the content of the structural unit containing a hydrophobic group is preferably in a range of 1% by mass to 50% by mass and more preferably in a range of 5% by mass to 30% by mass with respect to the total mass of the resin B.

In a case where the compound B is a polymer in the core shell particles, it is preferable that the resin B has a structural unit containing the functional group B, a structural unit having a hydrophilic structure, and a structural unit containing a polymerizable group from the viewpoint of UV printing durability.

The contents of the structural unit containing the functional group B, the structural unit having the hydrophilic structure, and the structural unit containing the polymerizable group in the resin B can be appropriately selected to be in a range of 1% by mass to 80% by mass with respect to the total content of the structural units of the resin B, respectively. Further, from the viewpoint of the UV printing durability, the content of each structural unit is more preferably in a range of 10% by mass to 50% by mass.

In the core shell particles, in a case where the compound B is a polymer, the resin B may have structural units other than the above-described structural units in the resin A without particular limitation, and examples of other structural units include a structural unit formed of a vinyl ether compound or the like.

In a case where the resin B has other structural units, the content of other structural units is preferably in a range of 1% by mass to 50% by mass and more preferably in a range of 5% by mass to 30% by mass with respect to the total mass of the resin B.

In a case where the compound B is a monomer, the compound B is a monomer containing the functional group B and a polymerizable group, and the functional group and the polymerizable group in the case where the compound B is a monomer each have the same definition as that for the functional group B and the polymerizable group described above, and the preferred embodiments thereof are also the same as described above.

In the core shell particles, for example, the compound B is a monomer in a case where the resin A contains a (meth)acrylamide group, and a compound containing a polymerization residue of (meth)acrylic acid or a polymerization residue of a (meth)acrylic acid derivative containing carboxylic acid in a terminal may be exemplified as the compound B in a case where the functional group B of the monomer is a group capable of hydrogen bonding, but a polymerization residue of (meth)acrylic acid is preferable from the viewpoint of increasing the number of functional groups at the same weight ratio.

In the core shell particles, for example, the compound B is a monomer in a case where the resin A contains a carboxy group, and it is preferable that the compound B is (meth)acrylamide in a case where the functional group B containing the monomer is a group capable of hydrogen bonding.

In the core shell particles, for example, the compound B is a monomer in a case where the resin A contains an acidic group such as a carboxy group, a sulfonic acid group, or a phosphoric acid group. Further, from the viewpoint of increasing the number of functional groups per compound, it is preferable that the compound B is dimethylaminoethyl (meth)acrylate in a case where the functional group containing the monomer is a group capable of ionic bonding.

In the core shell particles, for example, the compound B is a monomer in a case where the resin A contains a

cyano group, and it is preferable that the compound B is (meth)acrylonitrile in a case where the functional group containing the monomer is a group capable of dipole interaction.

The content of the compound B with respect to the content of the resin A in the core shell particles (hereinafter, also referred to as the "coverage") can be appropriately set. From the viewpoint of the UV printing durability, the content thereof is preferably in a range of 1% by mass to 90% by mass, more preferably in a range of 5% by mass to 80% by mass, and particularly preferably 10% by mass to 70% by mass with respect to the total mass of the resin A in the core shell particles.

The content of the compound B with respect to the content of the resin A in the core shell particles is acquired by infrared absorption spectrum (IR) measurement.

Specifically, the IR measurement is performed by washing the reaction product or the mixture of the resin A and the resin B with a solvent that dissolves the resin B, washing the resin B containing the functional group B that has not reacted or interacted with the functional group A, and drying the precipitate at 40°C. The IR measurement is performed using a paste of the resin A and the resin B mixed at an optional ratio (resin A:resin B = 2:8 to 8:2), the peak area of the polymerizable group contained in the compound B is calculated to create a calibration curve with the peak that only the resin A has as a standard, and the coverage is obtained based on the peak area thereof.

In a case where the compound B is a resin, the number average molecular weight (Mn) of the resin B is preferably in a range of 500 to 1000000, more preferably in a range of 5000 to 500000, and still more preferably in a range of 10000 to 200000.

Further, from the viewpoint of the UV printing durability, it is preferable that the number average molecular weight of the resin A is larger than the number average molecular weight of the resin B.

From the viewpoint of the UV printing durability, the arithmetic average particle diameter of the core portion is preferably in a range of 10 nm to 1000 nm, more preferably in a range of 30 nm to 800 nm, and particularly preferably in a range of 50 nm to 600 nm.

From the viewpoint of the UV printing durability, the arithmetic average particle diameter of the core shell particles is preferably in a range of 10 nm to 1000 nm, more preferably in a range of 50 nm to 800 nm, and particularly preferably in a range of 70 nm to 600 nm.

The arithmetic average particle diameter of the core shell particles in the present disclosure indicates a value measured by a dynamic light scattering method (DLS) unless otherwise specified.

The arithmetic average particle diameter of the core shell particles is measured by DLS using a Brookhaven BI-90 (manufactured by Brookhaven Instrument Company) according to the manual of the above-described device.

Further, from the viewpoint of the UV printing durability, the average thickness of the shell portion is preferably in a range of 1 nm to 100 nm, more preferably in a range of 1 nm to 50 nm, and particularly preferably in a range of 2 nm to 20 nm.

The average thickness of the shell portion in the present disclosure is obtained by dyeing the cross sections of particles according to a known method, observing the cross sections with an electron microscope, and calculating the average value of the thicknesses of the shell portions at 10 or more sites in total for 10 or more particles.

- Method of producing resin A and resin B contained in core shell particles -

The method of producing the resin contained in the core shell particles is not particularly limited, and the resin can be produced by a known method.

For example, the resin can be obtained by polymerizing a compound used for forming a structural unit having the functional group A or a compound used for forming a structural unit having the functional group B and a compound used for forming a structural unit other than these structural units according to a known method.

- Specific examples -

Specific examples of the resin A contained in the core shell particles are shown below, but the resin used in the present disclosure is not limited thereto.

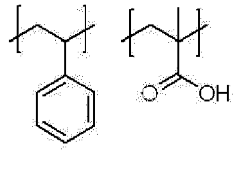

A-1

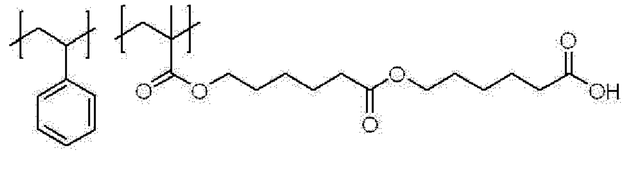

A-2

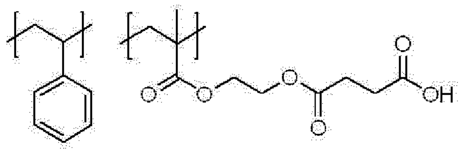

A-3

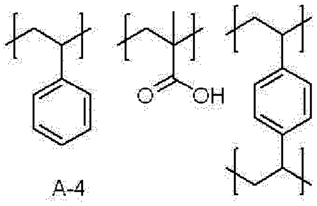

A-4

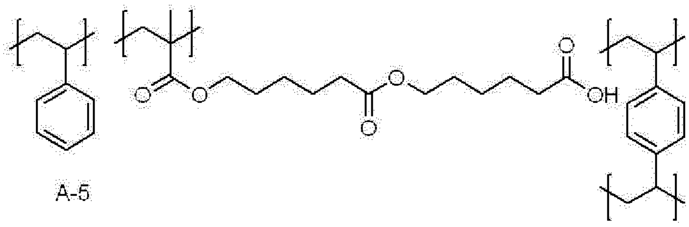

A-5

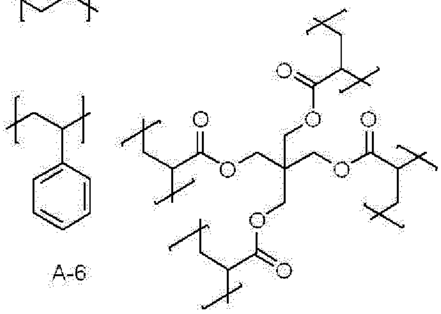

A-6

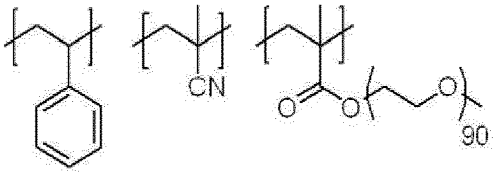

A-7

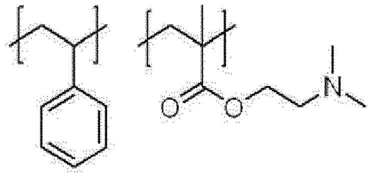

A-8

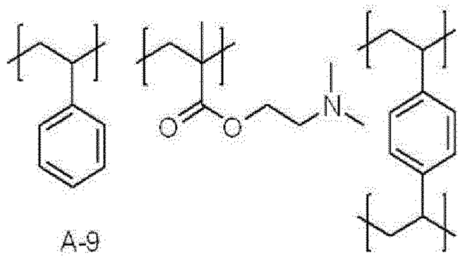

A-9

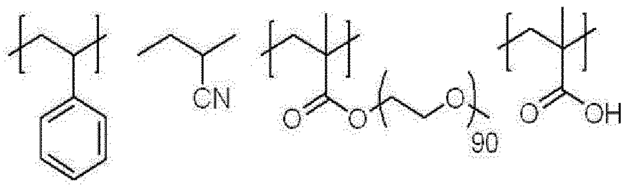

A-10

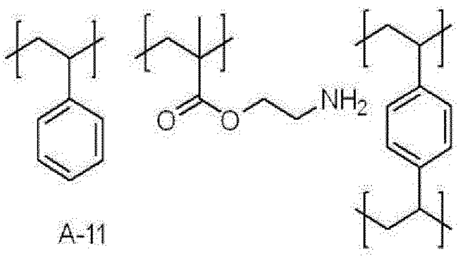

A-11

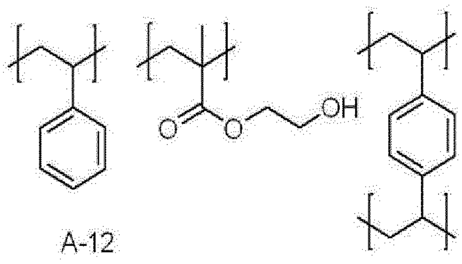

A-12

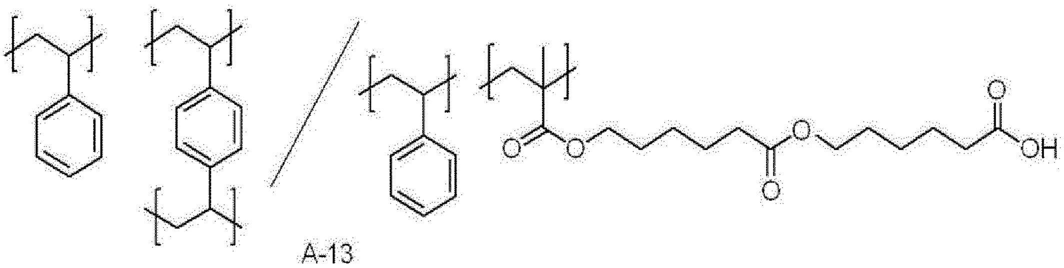

A-13

Further, A-13 represents an example of particles in which a large amount of the resin shown on the left side is present inside the core portion and a large amount of the resin A shown on the right side is present toward the outside.

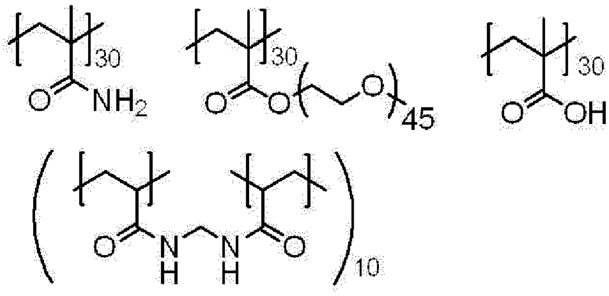

G-26

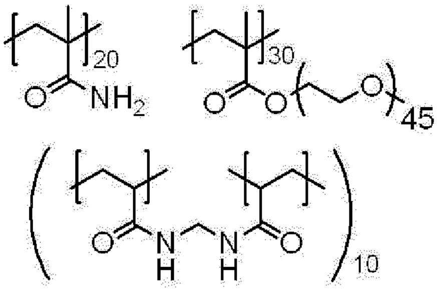

G-27

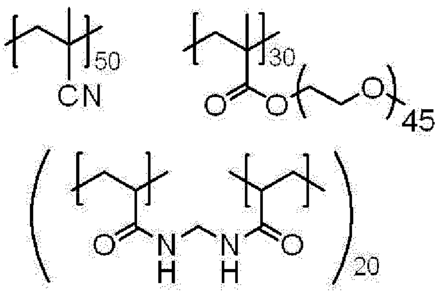

G-28

Further, specific examples of compound B contained in the core shell particles are shown below, but the resin used in the present disclosure is not limited thereto.

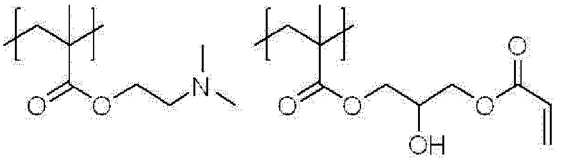

B-1

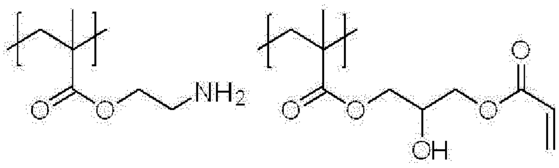

B-2

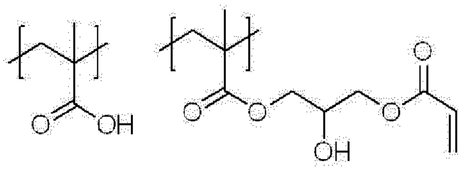

B-3

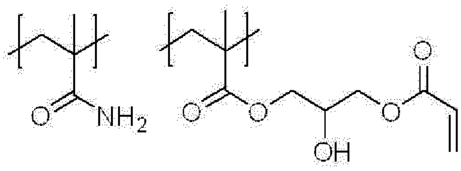

B-4

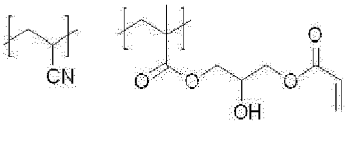

B-5

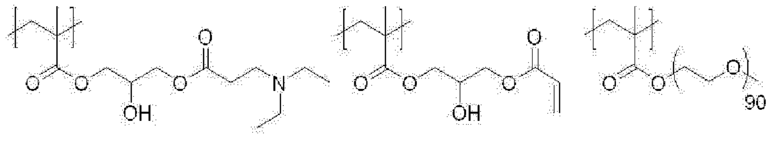

B-6

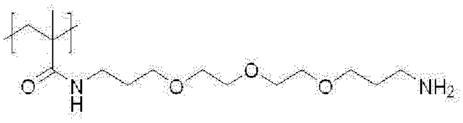
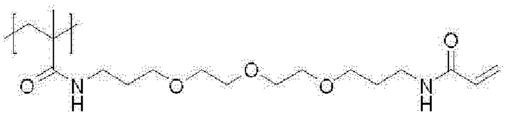
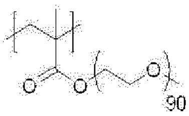

B-7

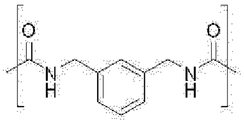
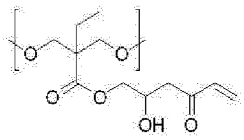

B-8

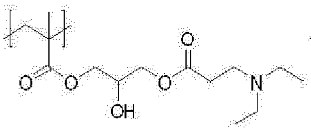
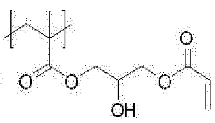
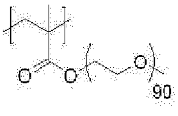
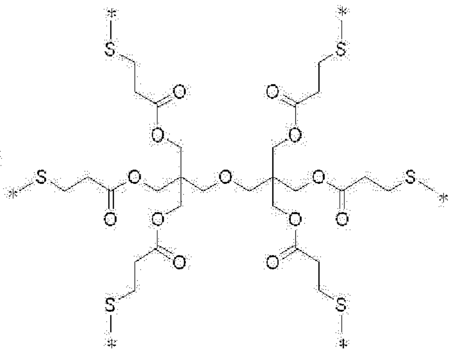

B-9

In addition, * in B-9 represents a binding position with respect to the polymer chain shown on the left side.

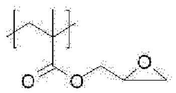
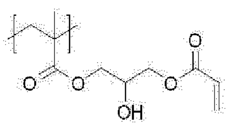

B-10

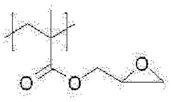
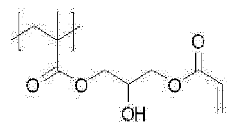
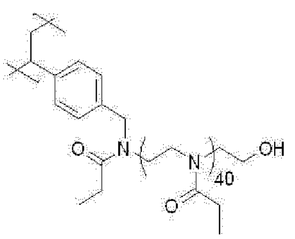

B-11

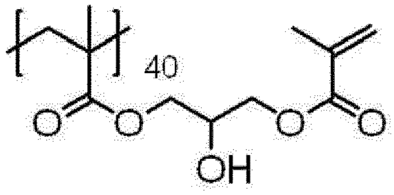
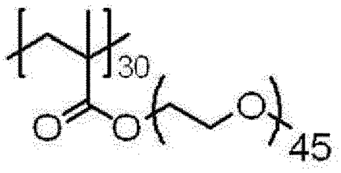
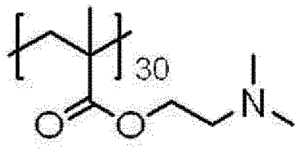

p-1

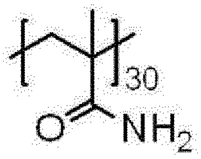
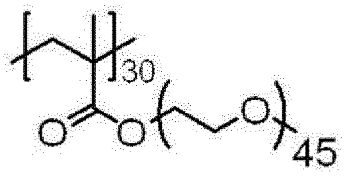
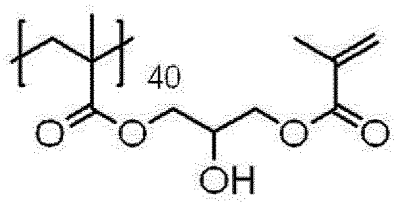

P-2

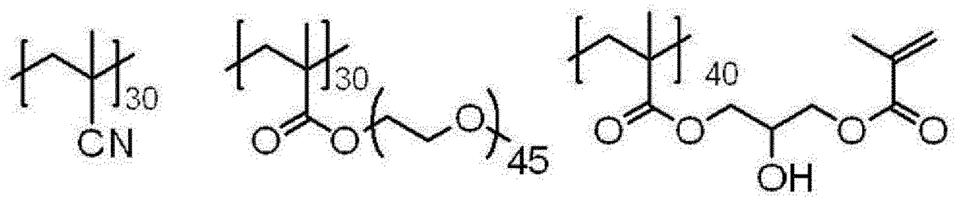

P-3

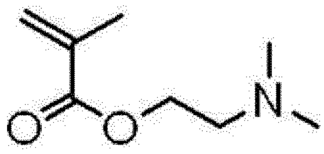

SM-1

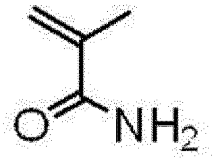

SM-2

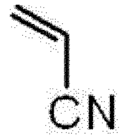

SM-3

- Specific examples -

Examples of specific polymer particles suitably used in the present disclosure include G-1 to G-25, and G-26 to G-28 and S-1 used in examples. Further, the content of each structural unit (the subscript on the lower right side of the parentheses) indicates the mass ratio, the subscript on the lower right side of the parentheses of a polyalkyleneoxy structure or a polyhydroxycarboxylic acid structure indicates the repetition number, and * represents a binding position with respect to another structure.

Further, the content of each structural unit of the specific polymer particles described above is the content of the structural unit before the addition of the polymerizable group. Specifically, for example, G-1 shows polymer particles obtained by preparing a polymer of a structural unit derived from methacrylamide, a structural unit derived from methylene bisacrylamide, a structural unit derived from methacrylic acid, and a structural unit derived from polyethylene glycol monomethyl ether methacrylate at a mass ratio of 30:20:20:30 and allowing 50% by mole of the structural unit derived from methacrylic acid to react with glycidyl methacrylate.

In this case, the reaction rate described above is 50%.

| Compound No | Structural formula | Median diameter (nm) | Coefficient of variation (%) |
|---|---|---|---|
| G-1 | 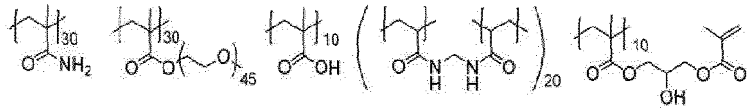 | 125 | 34.1 |
| G-2 | 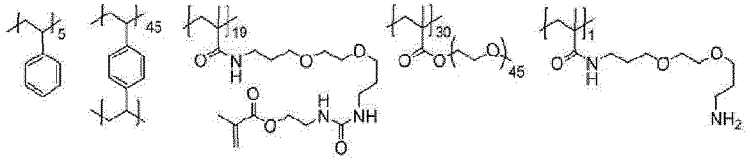 | 90 | 35.2 |
| G-3 | 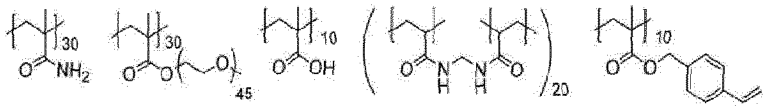 | 132 | 38.9 |
| G-4 | 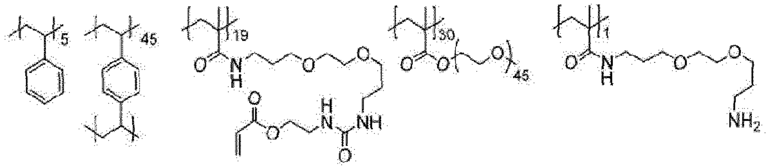 | 105 | 30.2 |
| G-5 | 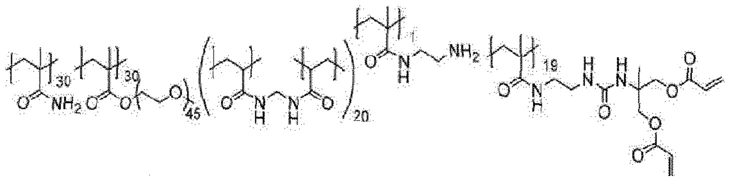 | 156 | 30.1 |
| G-6 | 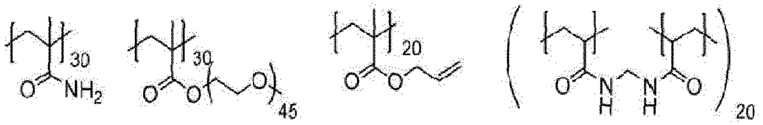 | 120 | 45.6 |
| G-7 | 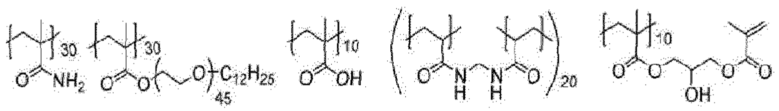 | 163 | 43.2 |

(continued)

| Compound No | Structural formula | Median diameter (nm) | Coefficient of variation (%) |
|---|---|---|---|
| G-8 | 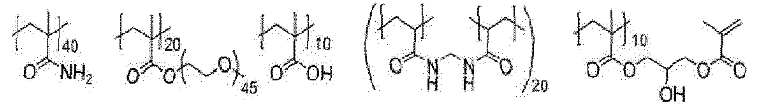 | 312 | 78.9 |
| G-9 | 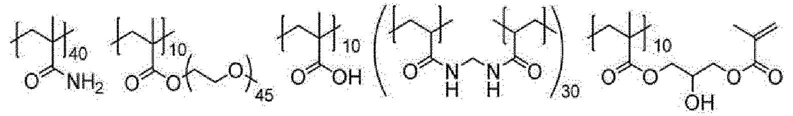 | 1153 | 125.3 |
| G-10 | 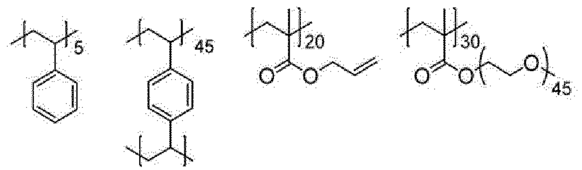 | 128 | 30.1 |
| G-11 | 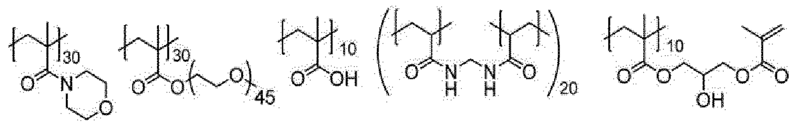 | 216 | 21.1 |
| G-12 | 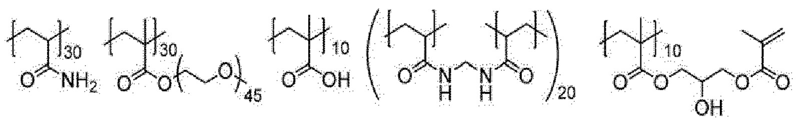 | 110 | 29.9 |
| G-13 | 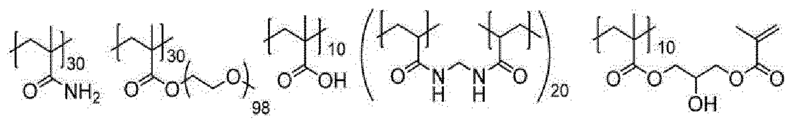 | 85 | 29.9 |
| G-14 | 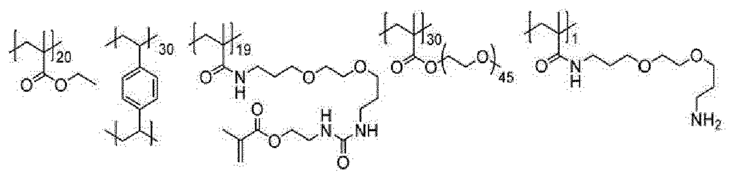 | 189 | 37.2 |

(continued)

| Compound No | Structural formula | Median diameter (nm) | Coefficient of variation (%) |
|---|---|---|---|
| G-15 | 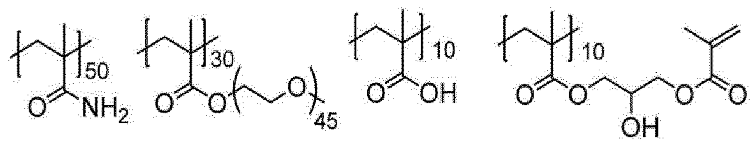 | 110 | 25.6 |
| G-16 | 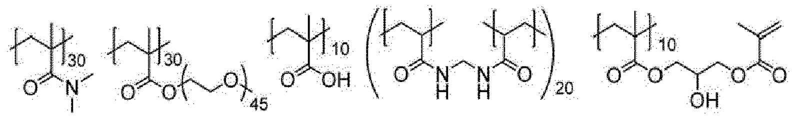 | 245 | 36.9 |
| G - 17 | 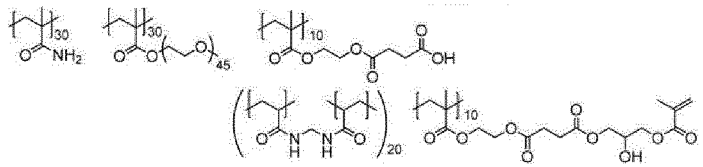 | 156 | 30.1 |
| G - 18 | 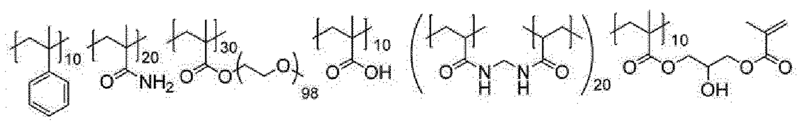 | 196 | 32.6 |
| G - 19 | 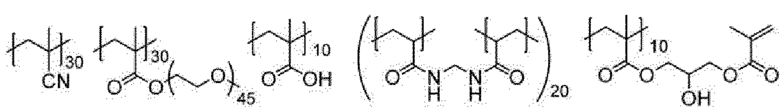 | 256 | 29.9 |
| G - 20 | 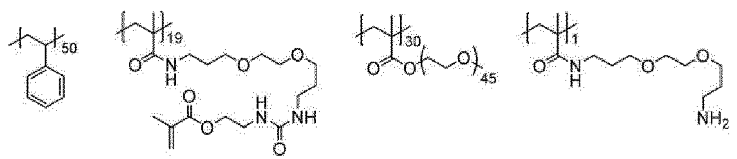 | 75 | 22.6 |
| G - 21 | 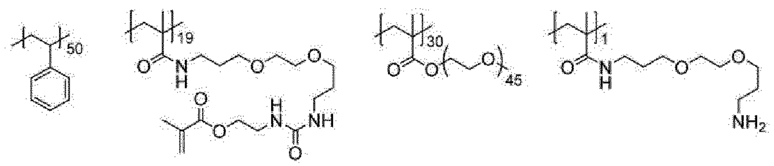 | 101 | 30.6 |

(continued)

| Compound No | Structural formula | Median diameter (nm) | Coefficient of variation (%) |
|---|---|---|---|
| G - 22 | 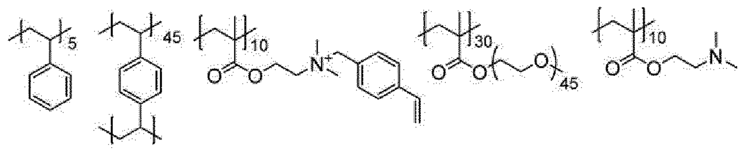 | 126 | 27.6 |
| G - 23 | 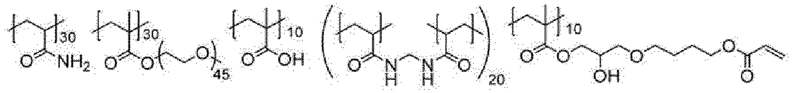 | 163 | 36.9 |
| G - 24 | 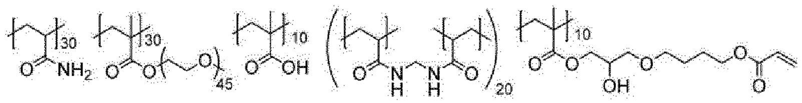 | 118 | 27.8 |
| G - 25 | 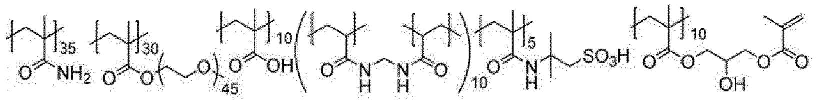 | 110 | 30.1 |
| S - 1 | 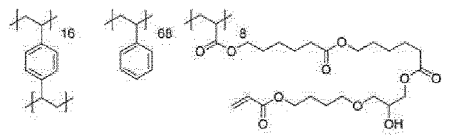 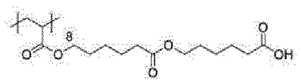 | 100 | 23.1 |

From the viewpoints of the UV printing durability and the on-press developability, the content of the specific polymer particles in the image recording layer of the planographic printing plate precursor according to the embodiment of the present disclosure is preferably in a range of 10% by mass to 90% by mass, more preferably in a range of 20% by mass to 80% by mass, still more preferably in a range of 30% by mass to 70% by mass, and particularly preferably in a range of 35% by mass to 65% by mass with respect to the total mass of the image recording layer.

- Infrared absorbing agent -

It is preferable that the image recording layer contains an infrared absorbing agent.
An infrared absorbing agent has a function of converting absorbed infrared rays into heat, a function of electron transfer to a polymerization initiator described below through excitation by infrared rays, and/or a function of energy transfer. It is preferable that the infrared absorbing agent used in the present disclosure is a dye having a maximum absorption at a wavelength of 750 nm to 1400 nm.
As the dye, commercially available dyes and known dyes described in the literatures such as "Dye Handbook" (edited by the Society of Synthetic Organic Chemistry, Japan, published in 1970) can be used. Specific examples thereof include dyes such as an azo dye, a metal complex salt azo dye, a pyrazolone azo dye, a naphthoquinone dye, an anthraquinone dye, a phthalocyanine dye, a carbonium dye, a quinone imine dye, a methine dye, a cyanine dye, a squarylium coloring agent, a pyrylium salt, and a metal thiolate complex.
Among the above-described dyes, a cyanine coloring agent, a squarylium coloring agent, a pyrylium salt, a nickel thiolate complex, and an indolenine cyanine coloring agent are preferable. Further, a cyanine coloring agent or an indolenine cyanine coloring agent is more preferable. Among these, a cyanine coloring agent is particularly preferable.
Specific examples of the cyanine coloring agent include compounds described in paragraphs 0017 to 0019 of JP2001-133969A and compounds described in paragraphs 0016 to 0021 of JP2002-023360A and paragraphs 0012 to 0037 of JP2002-040638A, preferred examples thereof include compounds described in paragraphs 0034 to 0041 of JP2002-278057A and paragraphs 0080 to 0086 of JP2008-195018A, and particularly preferred examples thereof include compounds described in paragraphs 0035 to 0043 of JP2007-090850A and compounds described in paragraphs 0105 to 0113 of JP2012-206495A.
Further, compounds described in paragraphs 0008 and 0009 of JP1993-005005A (JP-H05-005005A) and paragraphs 0022 to 0025 of JP2001-222101A can be preferably used.
As the pigments, compounds described in paragraphs 0072 to 0076 of JP2008-195018A are preferable.
The infrared absorbing agent may be used alone or in combination of two or more kinds thereof. Further, pigments and dyes may be used in combination as the infrared absorbing agent.
The content of the infrared absorbing agent in the image recording layer is preferably in a range of 0.1% by mass to 10.0% by mass and more preferably in a range of 0.5% by mass to 5.0% by mass with respect to total mass of the image recording layer.

- Polymerization initiator -

The image recording layer used in the present disclosure contains preferably a polymerization initiator (electron-receiving polymerization initiator) and more preferably a polymerization initiator and a polymerizable compound.
The polymerization initiator indicates a compound that initiates and promotes polymerization of a polymerizable compound. As the polymerization initiator, a known thermal polymerization initiator, a compound having a bond with small bond dissociation energy, or a photopolymerization initiator can be used. Specifically, radical polymerization initiators described in paragraphs 0092 to 0106 of JP2014-104631A can be used.
Preferred examples of compounds in the polymerization initiators include onium salts. Among these, iodonium salts and sulfonium salts are particularly preferable. Specific preferred examples of the compounds in each of the salts are the compounds described in paragraphs 0104 to 0106 of JP2014-104631A.
The content of the polymerization initiator is preferably in a range of 0.1% by mass to 50% by mass, more preferably in a range of 0.5% by mass to 30% by mass, and particularly preferably in a range of 0.8% by mass to 20% by mass with respect to the total mass of the image recording layer. In a case where the content thereof is in the above-described range, more satisfactory sensitivity and more satisfactory stain resistance of a non-image area during printing are obtained.

- Polymerizable compound -

It is preferable that the image recording layer used in the present disclosure contains a polymerizable compound.
The polymerizable compound in the present disclosure does not contain a compound corresponding to the above-described specific polymer.

The polymerizable compound used in the image recording layer may be, for example, a radically polymerizable compound or a cationically polymerizable compound, but it is preferable that the polymerizable compound is an addition polymerizable compound having at least one ethylenically unsaturated bond (ethylenically unsaturated compound). As the ethylenically unsaturated compound, a compound having at least one terminal ethylenically unsaturated bond is preferable, and a compound having two or more terminal ethylenically unsaturated bonds is more preferable. The polymerizable compound may have chemical forms such as a monomer, a pre-polymer, that is, a dimer, a trimer, an oligomer, and a mixture of these.

Examples of the monomer include unsaturated carboxylic acids (for example, acrylic acid, methacrylic acid, itaconic acid, crotonic acid, isocrotonic acid, and maleic acid), esters thereof, and amides thereof. Among these, esters of unsaturated carboxylic acids and polyhydric alcohol compounds, and amides of unsaturated carboxylic acids and polyvalent amine compounds are preferably used. Further, an addition reaction product of unsaturated carboxylic acid esters having a nucleophilic substituent such as a hydroxy group, an amino group, or a mercapto group or amides with monofunctional or polyfunctional isocyanates or epoxies, and a dehydration condensation reaction product with a monofunctional or polyfunctional carboxylic acid are also suitably used. Further, an addition reaction product of unsaturated carboxylic acid esters having an electrophilic substituent such as an isocyanate group or an epoxy group or amides with monofunctional or polyfunctional alcohols, amines, and thiols, and a substitution reaction product of unsaturated carboxylic acid esters having a releasable substituent such as a halogen group or a tosyloxy group or amides with monofunctional or polyfunctional alcohols, amines, and thiols are also suitable. As another example, a compound group in which the unsaturated phosphonic acid, styrene, vinyl ether, or the like is substituted for the unsaturated carboxylic acid can also be used. These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493, JP2002-275129A, JP2003-64130A, JP2003-280187A, and JP1998-333321A(JP-H10-333321A).

Specific examples of the monomer of the ester of a polyhydric alcohol compound and an unsaturated carboxylic acid include acrylic acid ester such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate, and a polyester acrylate oligomer. Examples of the methacrylic acid ester include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane, and bis[p-(methacryloxyethoxy) phenyl]dimethylmethane. Further, specific examples of the monomer of the amide of a polyvalent amine compound and an unsaturated carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, and xylylene bismethacrylamide.

Further, a urethane-based addition-polymerizable compound produced by the addition reaction of an isocyanate and a hydroxy group is also suitable, and specific examples thereof include a vinyl urethane compound containing two or more polymerizable vinyl groups in one molecule, which is obtained by adding a vinyl monomer containing a hydroxy group represented by Formula (M) to a polyisocyanate compound containing two or more isocyanate groups in one molecule described in JP1973-041708B (JP-S48-041708B).

$$CH_2{=}C(R^{M4})C({=}O)OCH_2CH(R^{M5})OH \quad (M)$$

In Formula (M), $R^{M4}$ and $R^{M5}$ each independently represent a hydrogen atom or a methyl group.

Further, suitable examples of the urethane compound include urethane acrylates described in JP1976-037193A (JP-S51-037193A), JP1990-032293B (JP-H02-032293B), JP1990-016765B (JP-H02-016765B), JP2003-344997A, and JP2006-065210A, urethane compounds having an ethylene oxide skeleton described in JP1983-049860B (JP-S58-049860B), JP1981-017654B (JP-S56-017654B), JP1987-039417B (JP-S62-039417B), JP1987-039418B (JP-S62-039418B), JP2000-250211A, and JP2007-094138A, and urethane compounds containing a hydrophilic group described in US7153632A, JP1996-505958A (JP-H08-505958A), JP2007-293221A, and JP2007-293223A.

The content of the polymerizable compound is preferably in a range of 5% by mass to 75% by mass, more preferably in a range of 10% by mass to 70% by mass, and particularly preferably in a range of 15% by mass to 60% by mass with respect to the total mass of the image recording layer.

- Binder polymer -

It is preferable that the image recording layer used in the present disclosure contains a binder polymer. As the binder polymer, a (meth)acrylic resin, a polyvinyl acetal resin, and a polyurethane resin are preferable. In the present specification, the concept of "(meth)acryl" includes "acryl" and "methacryl".

Among these, as the binder polymer, a known binder polymer used in the image recording layer of the planographic printing plate precursor can be suitably used. As an example, the binder polymer used in the on-press development type planographic printing plate precursor (hereinafter, also referred to as a binder polymer for on-press development) will be described in detail.

As the binder polymer for on-press development, a binder polymer having an alkylene oxide chain is preferable. The binder polymer having an alkylene oxide chain may have a poly(alkylene oxide) moiety in the main chain or in a side chain. Further, the binder polymer may be a graft polymer having poly(alkylene oxide) in a side chain or a block copolymer of a block formed of a poly(alkylene oxide)-containing repeating unit and a block formed of an (alkylene oxide)-free repeating unit.

A polyurethane resin is preferable in a case where the binder polymer has a poly(alkylene oxide) moiety in the main chain. Examples of the polymer of the main chain in a case of having a poly(alkylene oxide) moiety in a side chain include a (meth)acrylic resin, a polyvinyl acetal resin, a polyurethane resin, a polyurea resin, a polyimide resin, a polyamide resin, an epoxy resin, a polystyrene resin, a novolak type phenol resin, a polyester resin, synthetic rubber, and natural rubber. Among these, a (meth)acrylic resin is particularly preferable.

As the alkylene oxide, alkylene oxide having 2 to 6 carbon atoms is preferable, and ethylene oxide or propylene oxide is particularly preferable.

The repetition number of alkylene oxide in a poly(alkylene oxide) moiety is preferably in a range of 2 to 120, more preferably in a range of 2 to 70, and still more preferably in a range of 2 to 50.

It is preferable that the repetition number of the alkylene oxide is 120 or less because degradation of both the printing durability due to abrasion and the printing durability due to the ink receiving property is suppressed.

It is preferable that the poly(alkylene oxide) moiety is contained in the polymer using a structure represented by Formula (AO) as a side chain of the binder polymer and more preferable that the poly(alkylene oxide) moiety is contained in the polymer using a structure represented by Formula (AO) as a side chain of a (meth)acrylic resin.

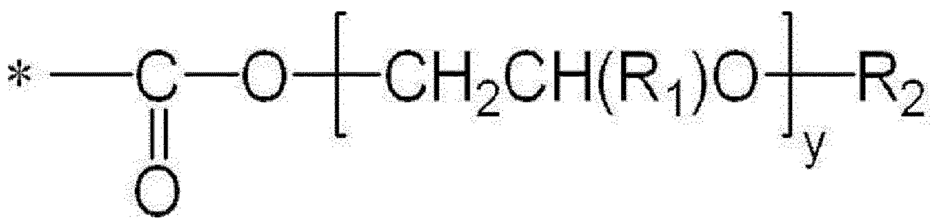

(AO)

In Formula (AO), y represents 2 to 120, $R_1$ represents a hydrogen atom or an alkyl group, and $R_2$ represents a hydrogen atom or a monovalent organic group.

As the monovalent organic group, an alkyl group having 1 to 6 carbon atoms is preferable, and examples thereof include a methyl group, an ethyl group, an n-propyl group, an isopropyl group, an n-butyl group, a sec-butyl group, an isobutyl group, a tert-butyl group, an n-pentyl group, an isopentyl group, a neopentyl group, an n-hexyl group, an isohexyl group, a 1,1-dimethylbutyl group, a 2,2-dimethylbutyl group, a cyclopentyl group, and a cyclohexyl group.

In Formula (AO), y represents preferably 2 to 70 and more preferably 2 to 50. $R_1$ represents preferably a hydrogen atom or a methyl group and particularly preferably a hydrogen atom. It is particularly preferable that $R_2$ represents a hydrogen atom or a methyl group.

The binder polymer may have crosslinking properties in order to improve coated-film hardness of an image area. In order to impart the crosslinking properties to the polymer, a crosslinkable functional group such as an ethylenically unsaturated bond may be introduced to the main chain or a side chain of the polymer. The crosslinkable functional group may be introduced by copolymerization or a polymer reaction.

Examples of the polymer having an ethylenically unsaturated bond in the main chain of a molecule include poly-1,4-butadiene and poly-1,4-isoprene.

Examples of the polymer having an ethylenically unsaturated bond in a side chain of a molecule include a polymer of an ester or amide of acrylic acid or methacrylic acid, in which the residue of the ester or amide (R of -COOR or -CONHR) has an ethylenically unsaturated bond.

Examples of the residue (R described above) having an ethylenically unsaturated bond include $-(CH_2)_nCR^{1A}=CR^{2A}R^{3A}$, $-(CH_2O)_nCH_2CR^{1A}=CR^{2A}R^{3A}$, $-(CH_2CH_2O)_nCH_2CR^{1A}=CR^{2A}R^{3A}$, $-(CH_2)_nNH-CO-O-CH_2CR^{1A}=CR^{2A}R^{3A}$, $-(CH_2)_n-O-CO-CR^{1A}=CR^{2A}R^{3A}$, and $-(CH_2CH_2O)_2-X$ (in the formulae, $R^{A1}$ to $R^{A3}$ each independently represent a hydrogen atom, a halogen atom, an alkyl group having 1 to 20 carbon atoms, an aryl group, an alkoxy group, or an aryloxy group, $R^{A1}$ and $R^{A2}$ or $R^{A3}$ may be bonded to each other to form a ring, n represents an integer of 1 to 10, and X represents a dicyclopentadienyl residue).

Specific examples of the ester residue include $-CH_2CH=CH_2$, $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$, and $-CH_2CH_2O-X$ (in the formulae,

X represents a dicyclopentadienyl residue).

Specific examples of the amide residue include $-CH_2CH=CH_2$, $-CH_2CH_2-Y$ (in the formula, Y represents a cyclohexene residue), and $-CH_2CH_2-OCO-CH=CH_2$.

The crosslinkable binder polymer is cured by performing addition of free radicals (polymerization initiation radicals or growing radicals during the polymerization process of the polymerizable compound) to the crosslinkable functional group thereof and performing addition polymerization directly between the polymers or through a polymerization chain to form crosslinking between polymer molecules. Alternatively, the binder polymer is cured by drawing out atoms in the polymer (for example, hydrogen atoms on carbon atoms adjacent to the functional crosslinked group) using free radicals to generate polymer radicals and bonding these radicals to each other to form crosslinking between polymer molecules.

From the viewpoints of satisfactory sensitivity and satisfactory storage stability, the content of the crosslinkable group in the binder polymer (the content of the unsaturated double bond capable of radical polymerization according to iodometric titration) is preferably in a range of 0.1 mmol to 10.0 mmol, more preferably in a range of 1.0 mmol to 7.0 mmol, and particularly preferably in a range of 2.0 mmol to 5.5 mmol per 1 g of the binder polymer.

Specific examples 1 to 11 of the binder polymer for on-press development are shown below, but the present disclosure is not limited thereto. In the following exemplified compounds, the numerical value shown along with each repeating unit (the numerical value shown along with a repeating unit in the main chain) represents the mole percentage of the repeating unit described above. The numerical value shown along with the repeating unit in a side chain indicates the repetition number of the repeating unit described above. Further, Me represents a methyl group, Et represents an ethyl group, and Ph represents a phenyl group.

(1)

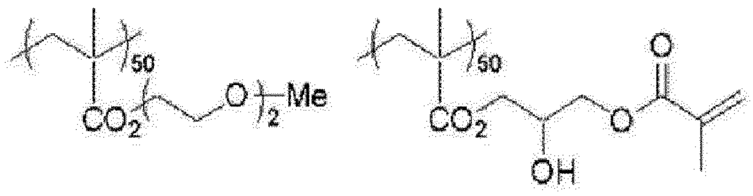

(2)

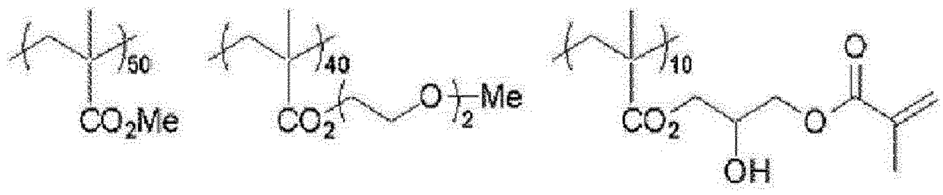

(3)

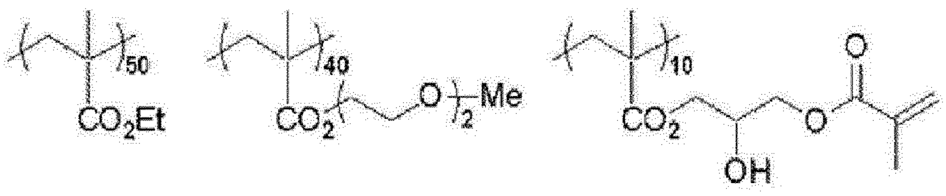

(4)

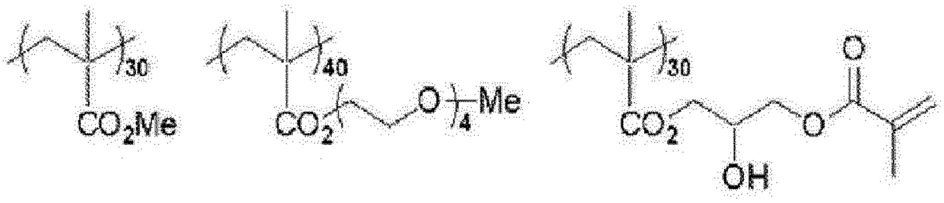

(5)

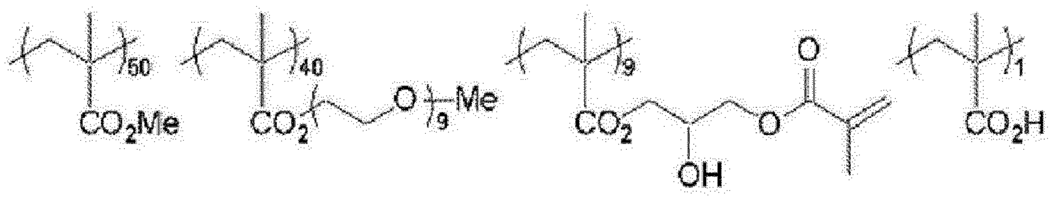

(6)

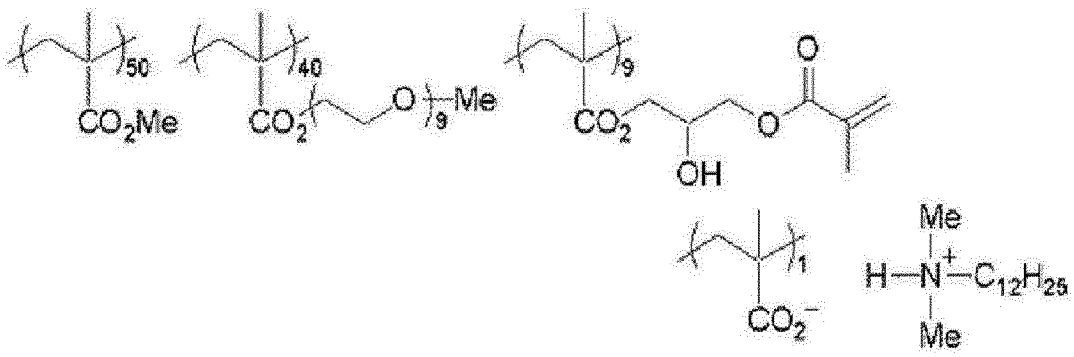

(7)

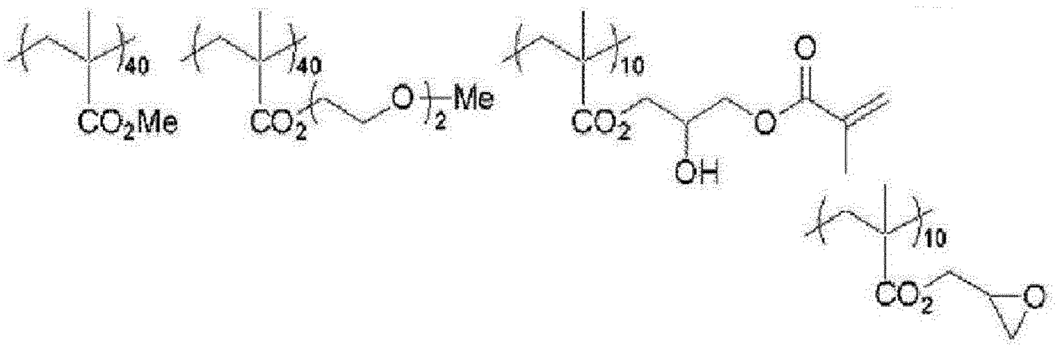

(8)

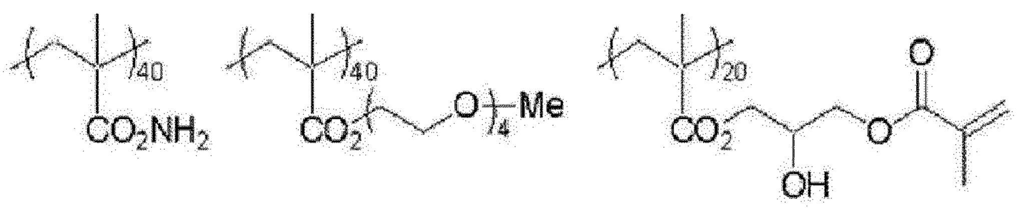

(9)

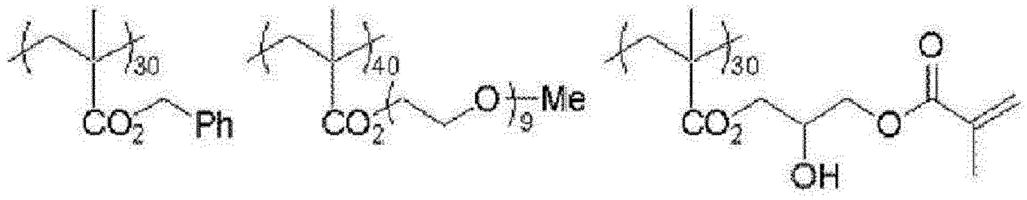

(10)

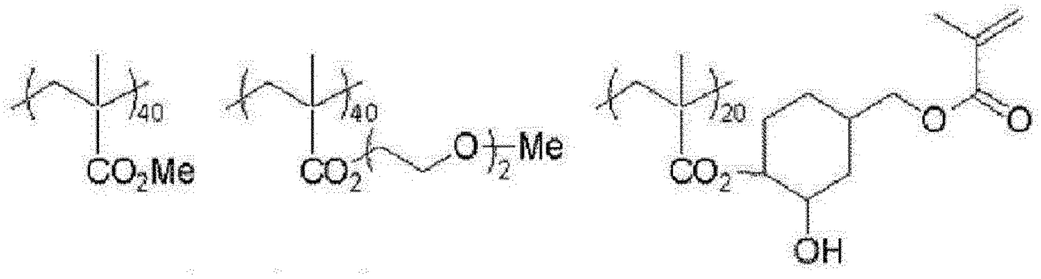

(11)

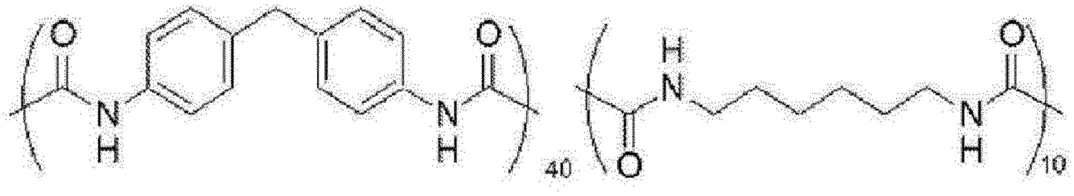

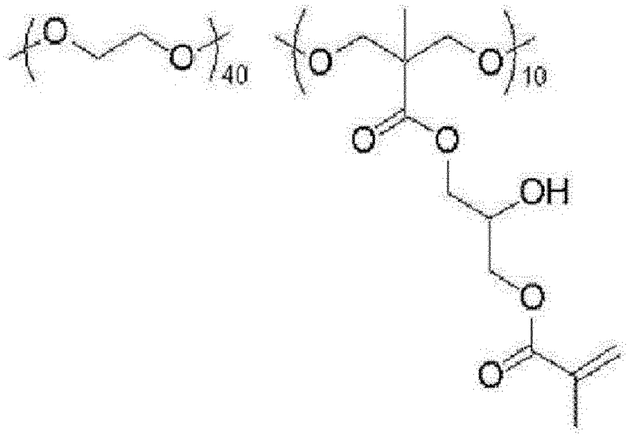

The weight-average molecular weight (Mw) of the binder polymer in terms of polystyrene that is measured according to the GPC method is preferably 2000 or greater, more preferably 5000 or greater, and still more preferably in a range of 10000 to 300000.

As necessary, hydrophilic polymers such as polyvinyl alcohol and polyacrylic acid described in JP2008-195018A can be used in combination. Further, a lipophilic polymer and a hydrophilic polymer can be used in combination.

The binder polymer may be present in the image recording layer as a polymer that functions as a binder of each component or may be present in the form of particles. In a case where the binder polymer is present in the form of particles, the average primary particle diameter thereof is preferably 1000 nm or less, more preferably in a range of 10 nm to 500 nm, and still more preferably in a range of 50 nm to 300 nm.

Further, the compound corresponding to the above-described specific polymer particle or other polymer particle described below does not correspond to the binder polymer.

In the image recording layer used in the present disclosure, the binder polymer may be used alone or in combination of two or more kinds thereof.

The image recording layer may contain an optional amount of the binder polymer. The content of the binder polymer can be appropriately selected depending on the applications of the image recording layer, but is preferably in a

range of 1% by mass to 90% by mass and more preferably in a range of 5% by mass to 80% by mass with respect to the total mass of the image recording layer.

- Electron-donating polymerization initiator -

The image recording layer used in the present disclosure may contain an electron-donating polymerization initiator (radical generation assistant). The electron-donating polymerization initiator contributes to improvement of the printing durability of the planographic printing plate. Examples of the electron-donating polymerization initiator include the following 5 kinds of agents.

(i) Alkyl or arylate complex: It is considered that a carbon-hetero bond is cleaved by oxidation to generate an active radical. Specific examples thereof include a borate compound.
(ii) Aminoacetic acid compound: It is considered that a C-X bond on a carbon adjacent to nitrogen is cleaved by oxidation to generate an active radical. It is preferable that X represents a hydrogen atom, a carboxy group, a trimethylsilyl group, or a benzyl group. Specific examples thereof include N-phenylglycines (the phenyl group may have a substituent) and N-phenyliminodiacetic acid (the phenyl group may have a substituent).
(iii) Sulfur-containing compound: The nitrogen atom of the above-described aminoacetic acid compound can be replaced with a sulfur atom to generate an active radical by the same action as described above. Specific examples thereof include phenylthioacetic acid (the phenyl group may have a substituent).
(iv) Tin-containing compound: The nitrogen atom of the above-described aminoacetic acid compound can be replaced with a tin atom to generate an active radical by the same action as described above.
(v) Sulfinates: An active radical can be generated by oxidation. Specific examples thereof include sodium arylsulfinate.

Among these electron-donating polymerization initiators, it is preferable that the image recording layer contains a borate compound. As the borate compound, a tetraarylborate compound or a monoalkyltriarylborate compound is preferable, a tetraarylborate compound is more preferable from the viewpoints of the stability of the compound and the potential difference described below, and a tetraarylborate compound that contains one or more aryl groups containing an electron-withdrawing group is particularly preferable from the viewpoint of the potential difference described below.
As the electron-withdrawing group, a group in which the $\sigma$ value of the Hammett's rule is positive is preferable, and a group in which the $\sigma$ value of the Hammett's rule is in a range of 0 to 1.2 is more preferable. The $\sigma$ value ($\sigma$p value and $\sigma$m value) of the Hammett's rule is specifically described in Hansch, C.; Leo, A.; Taft, R. W., Chem. Rev., 1991, 91, 165 to 195.
As the electron-withdrawing group, a halogen atom, a trifluoromethyl group, or a cyano group is preferable, and a fluorine atom, a chlorine atom, a trifluoromethyl group, or a cyano group is more preferable.
As a counter cation of the borate compound, an alkali metal ion or a tetraalkylammonium ion is preferable, a sodium ion, a potassium ion, or a tetrabutylammonium ion is more preferable.
Further, the counter cation may be an iodonium cation or the like in an onium salt of the above-described polymerization initiator (electron-receiving polymerization initiator) or may be a coloring agent structure in the above-described infrared absorbing agent. Preferred examples of the salt of an iodonium cation and a borate anion include iodonium borate described in paragraph 0048 of JP5129242B.
Further, It is preferable that the image recording layer in the present disclosure further contains a compound represented by Formula I as the electron-donating polymerization initiator (borate compound) and also preferable that the image recording layer further contains the infrared absorbing agent described above and a compound represented by Formula I.

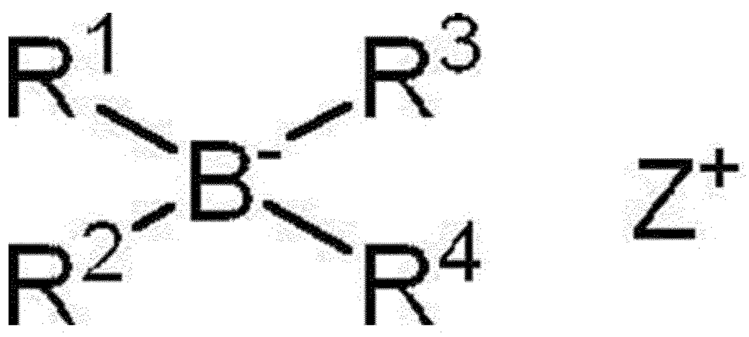

Formula I

In Formula I, $R^1$, $R^2$, $R^3$, and $R^4$ each independently represent an alkyl group, an aryl group, an alkenyl group, an alkynyl group, a cycloalkyl group, or a heterocyclyl group, two or more of $R^1$, $R^2$, $R^3$, and $R^4$ represent a structure forming a heterocycle in which a boron atom in Formula I is included as a ring member, and $Z^+$ represents a cation.

In Formula I, $R^1$, $R^2$, $R^3$, and $R^4$ each independently represent preferably an alkyl group having 1 to 12 carbon atoms, an aryl group having 6 to 10 carbon atoms, an alkenyl group having 2 to 12 carbon atoms, an alkynyl group having 2 to 12 carbon atoms, a cycloalkyl group having 3 to 8 carbon atoms, or a heterocyclyl group in which the total number of carbon atoms, oxygen atoms, sulfur atoms, and nitrogen atoms is in a range of 5 to 10 and more preferably an alkyl group having 1 to 12 carbon atoms or an aryl group having 6 to 10 carbon atoms. Examples of the heterocyclyl group include a pyridyl ring, a pyrimidine ring, and a triazole ring.

The alkyl group, the aryl group, the alkenyl group, the alkynyl group, the cycloalkyl group, or the heterocyclyl group may have a substituent. Preferred examples of the substituent include an electron-withdrawing group in an aryl group containing the electron-withdrawing group described above.

Further, it is preferable that at least three of $R^1$, $R^2$, $R^3$, and $R^4$ represent an aryl group, more preferable that at least three thereof represent an aryl group and the remaining one represents an alkyl group, and still more preferable that all four represent an aryl group.

Examples of the heterocycle in which a boron atom in Formula I is included as a ring member include a carbon ring having a boron atom. The number of ring members in the heterocycle is preferably 7 or less.

In Formula I, $Z^+$ represents a monovalent cation or a polyvalent cation and preferably a monovalent cation.

Further, in Formula I, $Z^+$ represents preferably an alkali metal ion or a tetraalkylammonium ion and more preferably a sodium ion, a potassium ion, or a tetrabutylammonium ion.

Further, $Z^+$ may be an iodonium cation or the like in an onium salt in the above-described polymerization initiator (electron-receiving polymerization initiator) or may be a coloring agent structure in the infrared absorbing agent described above.

Specific examples of the borate compound include compounds shown below. Here, $X_c^+$ represents a counter cation in the borate compound described above, preferably an alkali metal ion or a tetraalkylammonium ion, and more preferably an alkali metal ion or a tetrabutylammonium ion. Further, Bu represents an n-butyl group.

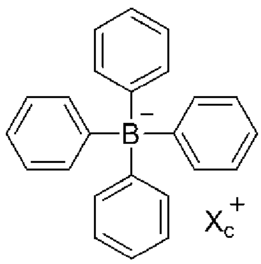
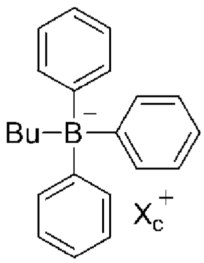
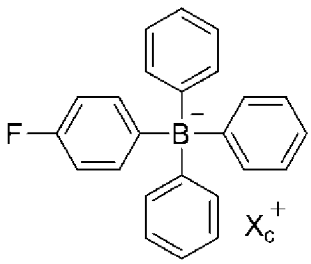
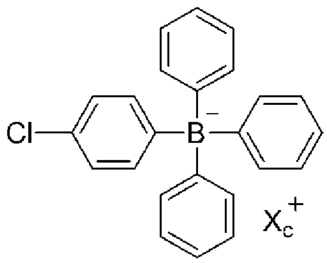

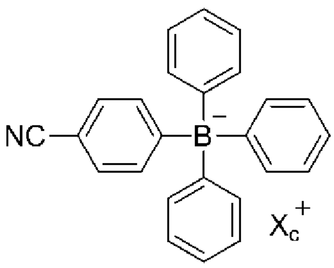
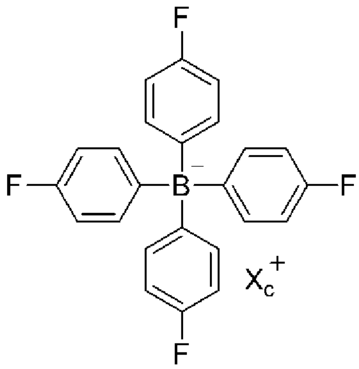
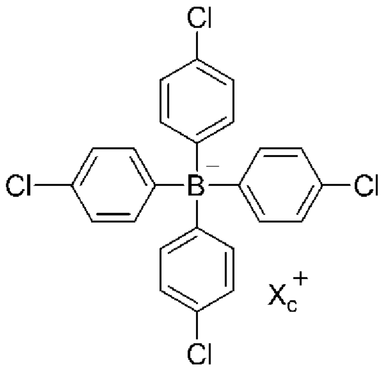

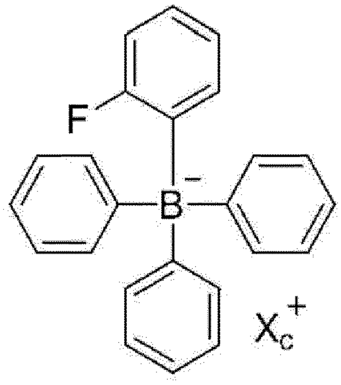

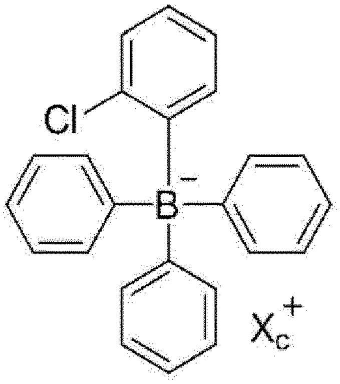

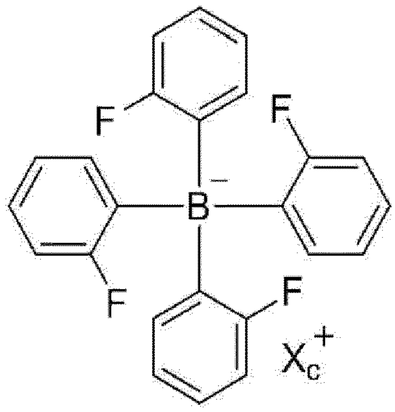

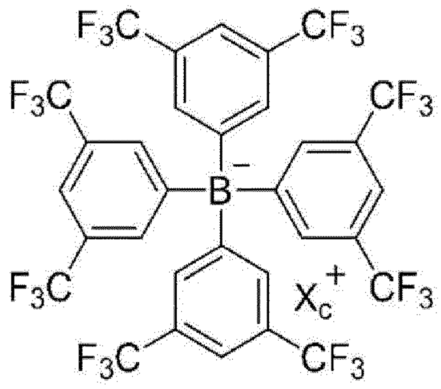

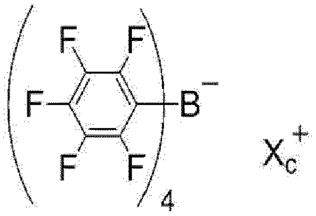

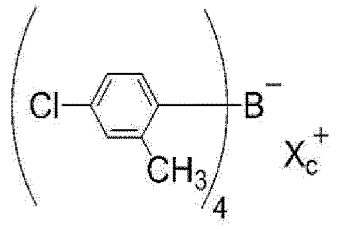

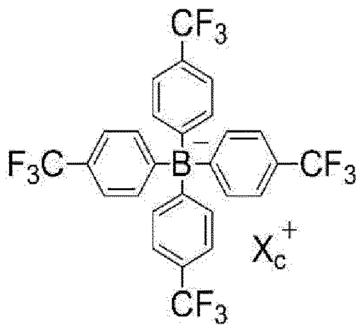

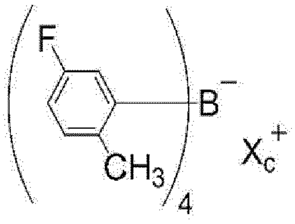

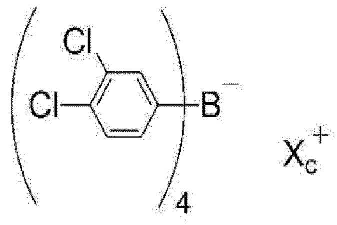

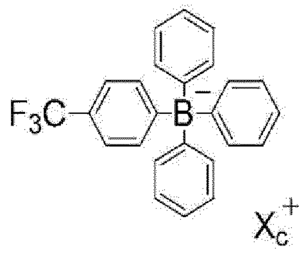

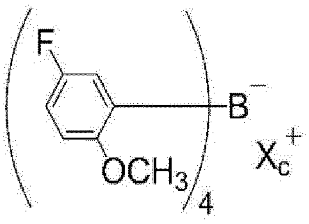

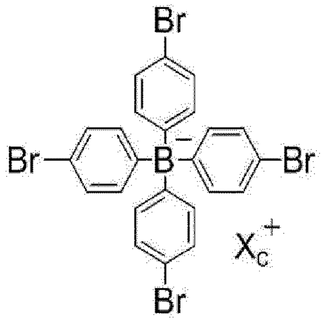

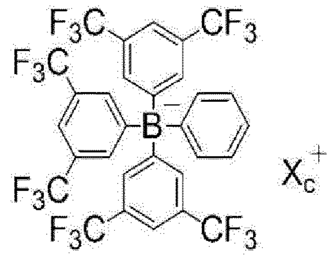

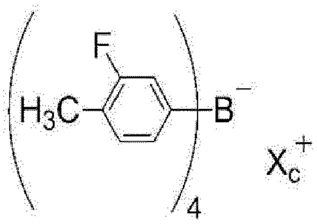

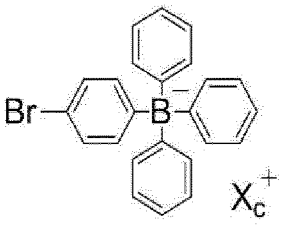

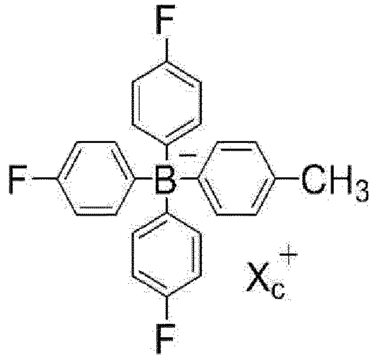

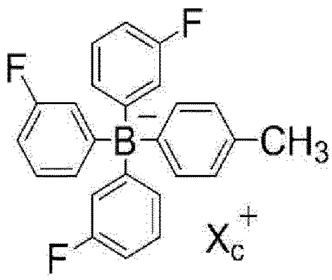

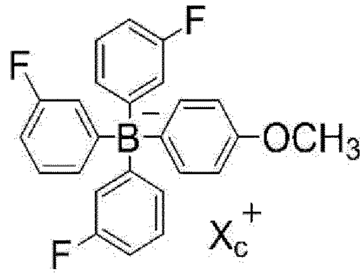

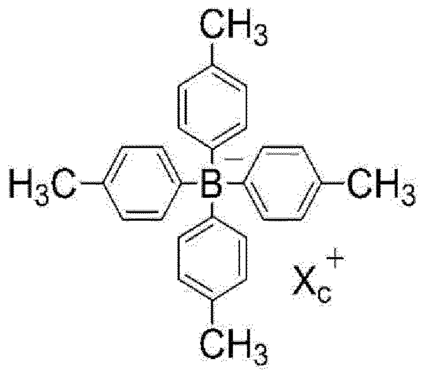
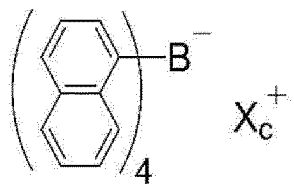
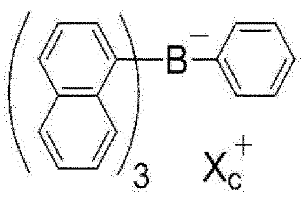

The electron-donating polymerization initiator may be used alone or in combination of two or more kinds thereof.

The content of the electron-donating polymerization initiator is preferably in a range of 0.01% by mass to 30% by mass, more preferably in a range of 0.05% by mass to 25% by mass, and still more preferably in a range of 0.1% by mass to 20% by mass with respect to the total mass of the image recording layer.

- Chain transfer agent -

The image recording layer used in the present disclosure may contain a chain transfer agent. The chain transfer agent contributes to improvement of the printing durability of the planographic printing plate.

As the chain transfer agent, a thiol compound is preferable, a thiol having 7 or more carbon atoms is more preferable from the viewpoint of the boiling point (difficulty in volatilization), and a compound containing a mercapto group on an aromatic ring (aromatic thiol compound) is still more preferable. It is preferable that the thiol compound is a monofunctional thiol compound.

Specific examples of the chain transfer agent include the following compounds.

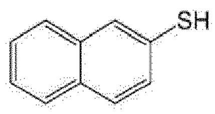

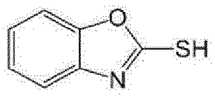
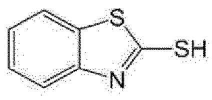
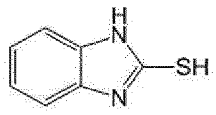

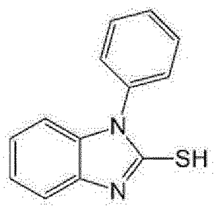
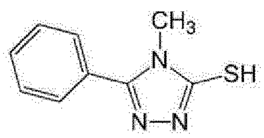
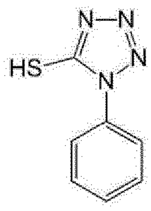

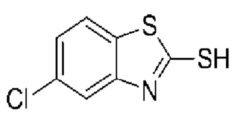
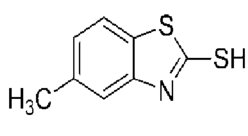
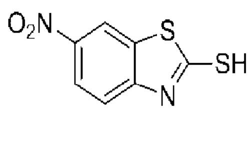
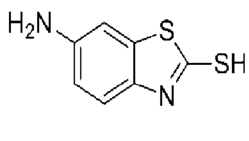

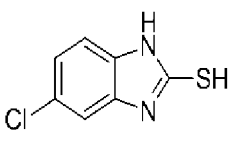
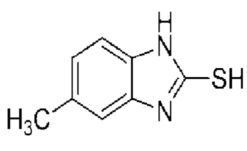
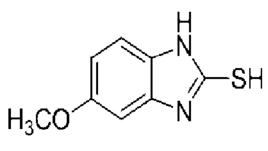
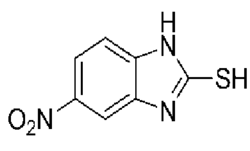

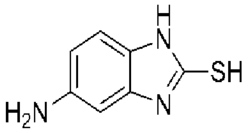
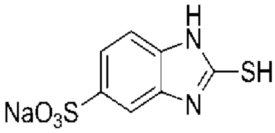
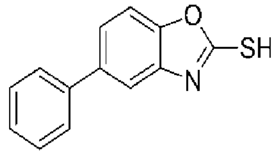

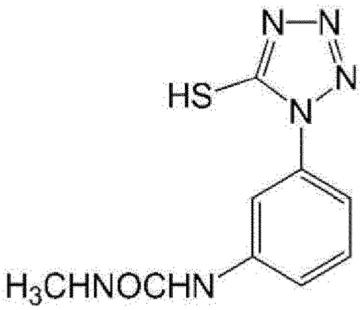
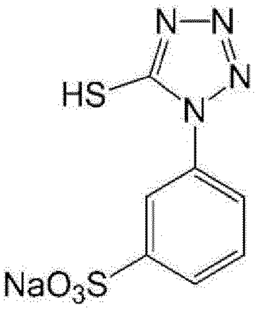

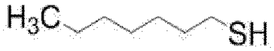
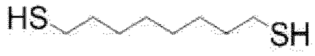
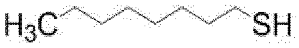
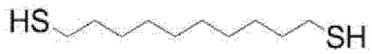
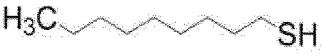
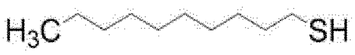
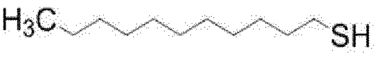
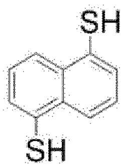
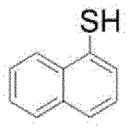
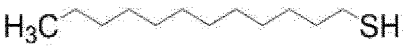
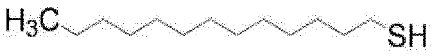
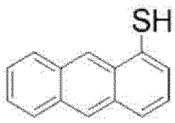
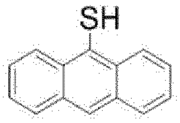
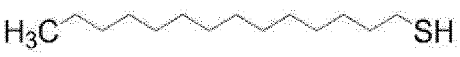
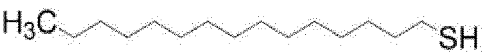
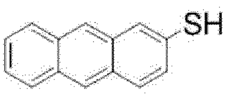
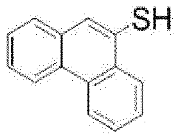
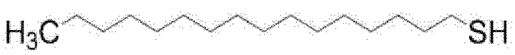
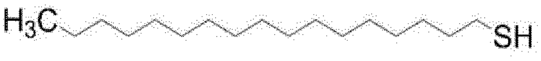
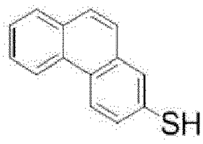
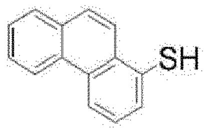
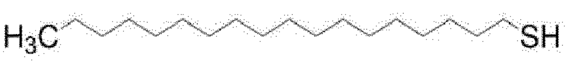
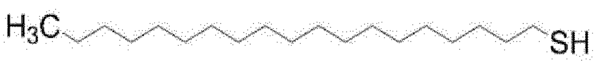
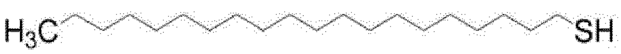
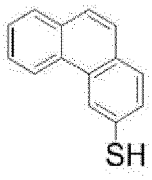
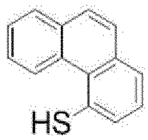
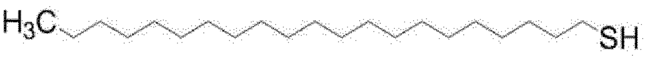
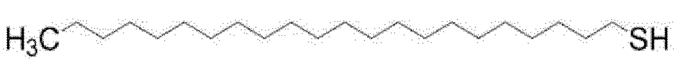

The chain transfer agent may be used alone or in combination of two or more kinds thereof.

The content of the chain transfer agent is preferably in a range of 0.01% by mass to 50% by mass, more preferably in a range of 0.05% by mass to 40% by mass, and still more preferably in a range of 0.1% by mass to 30% by mass with respect to total mass of the image recording layer.

- Other polymer particles -

In order to improve the on-press developability of the planographic printing plate precursor, the image recording layer may contain other polymer particles. It is preferable that other polymer particles are polymer particles that can convert the image recording layer to be hydrophobic in a case where heat is applied thereto. The polymer particles corresponding to the above-described polymer particles do not correspond to other polymer particles. It is preferable that other polymer particles are at least one selected from hydrophobic thermoplastic polymer particles, thermally reactive polymer particles, polymer particles containing a polymerizable group, a microcapsule encapsulating a hydrophobic compound, and a microgel (crosslinked polymer particle). Among these, polymer particles having a polymerizable group and a microgel are preferable.

Suitable examples of the hydrophobic thermoplastic polymer particles include hydrophobic thermoplastic polymer particles described in Research Disclosure No. 33303 on January, 1992, JP1997-123387A (JP-H09-123387A), JP1997-131850A (JP-H09-131850A), JP1997-171249A (JP-H09-171249A), JP1997-171250A (JP-H09-171250A), and EP931647B.

Specific examples of the polymer constituting the hydrophobic thermoplastic polymer particles include homopolymers or copolymers of monomers such as acrylate or methacrylate having structures of ethylene, styrene, vinyl chloride, methyl acrylate, ethyl acrylate, methyl methacrylate, ethyl methacrylate, vinylidene chloride, acrylonitrile, vinyl carbazole, and polyalkylene, and mixtures thereof. Among these, copolymers containing polystyrene, styrene, and acrylonitrile, and polymethyl methacrylate are preferable. The volume average particle diameter of the hydrophobic thermoplastic polymer particles is preferably in a range of 0.01 μm to 2.0 μm.

Examples of the thermally reactive polymer particles include polymer particles having a thermally reactive group. The polymer particles containing a thermally reactive group are crosslinked by a thermal reaction and have hydrophobic regions formed by a change in functional groups during the crosslinking.

As the thermally reactive group in polymer particles having a thermally reactive group, a functional group that performs any reaction may be used as long as a chemical bond is formed, but a polymerizable group is preferable. Suitable examples of the polymerizable group include an ethylenically unsaturated group that performs a radical polymerization reaction (such as an acryloyl group, a methacryloyl group, a vinyl group, or an allyl group); a cationically polymerizable group (such as a vinyl group, a vinyloxy group, an epoxy group, or an oxetanyl group); an isocyanate group that performs an addition reaction or a block body thereof, an epoxy group, a vinyloxy group, and a functional group having active hydrogen atoms as the reaction partners of these (such as an amino group, a hydroxy group, or a carboxy group); a carboxy group that performs a condensation reaction and a hydroxy group or an amino group as a reaction partner thereof; and an acid anhydride that performs a ring-opening addition reaction and an amino group or a hydroxy group as a reaction partner thereof.

Examples of the microcapsule include those obtained by encapsulating all or some of the constituent components of the image recording layer in a microcapsule as described in JP2001-277740A and JP2001-277742A. Further, the constituent components of the image recording layer may be contained in a portion other than the microcapsule. Moreover, a preferred embodiment of the image recording layer containing the microcapsule is an embodiment in which hydrophobic constituent components are encapsulated by a microcapsule and hydrophilic constituent components are contained in a portion other than the microcapsule.

The microgel (crosslinked polymer particles) may contain some constituent components of the image recording layer in at least one of the surface or the inside thereof. From the viewpoints of the image forming sensitivity and the printing durability, a reactive microgel which is obtained to contain a radically polymerizable group on the surface thereof is particularly preferable.

The constituent components of the image recording layer can be made into microcapsules or microgels using a known method.

The average particle diameter of the microcapsules or microgels is preferably in a range of 0.01 μm to 3.0 μm, more preferably in a range of 0.05 μm to 2.0 μm, and particularly preferably in a range of 0.10 μm to 1.0 μm. In a case where the average particle diameter thereof is in the above-described range, a satisfactory resolution and satisfactory temporal stability are obtained.

The content of other polymer particles is preferably in a range of 5% by mass to 90% by mass with respect to the total mass of the image recording layer.

- Low-molecular-weight hydrophilic compound -

In order to improve the on-press developability while suppressing degradation of the printing durability, the image recording layer may contain a low-molecular-weight hydrophilic compound. As the low-molecular-weight hydrophilic compound, a compound having a molecular weight of less than 1000 is preferable, a compound having a molecular weight of less than 800 is more preferable, and a compound having a molecular weight of less than 500 is still more preferable.

As the low-molecular-weight hydrophilic compound, examples of a water-soluble organic compound include glycols such as ethylene glycol, diethylene glycol, triethylene glycol, propylene glycol, dipropylene glycol, and tripropylene glycol and ether or ester derivatives thereof; polyols such as glycerin, pentaerythritol, and tris(2-hydroxyethyl) isocyanurate; organic amines such as triethanolamine, diethanolamine, and monoethanolamine and salts thereof; organic sulfonic acids such as alkylsulfonic acid, toluenesulfonic acid, and benzenesulfonic acid and salts thereof; organic sulfamic acids such as alkyl sulfamic acid and salts thereof; organic sulfuric acids such as alkyl sulfuric acid and alkyl ether sulfuric acid and salts thereof; organic phosphonic acids such as phenyl phosphonic acid and salts thereof; organic carboxylic acids such as tartaric acid, oxalic acid, citric acid, malic acid, lactic acid, gluconic acid, and amino acids and salts thereof; and betaines.

Among these, it is preferable that the low-molecular-weight hydrophilic compound contains at least one selected from polyols, organic sulfates, organic sulfonates, and betaines.

Specific examples of the organic sulfonates include an alkyl sulfonate such as sodium n-butyl sulfonate, sodium n-hexyl sulfonate, sodium 2-ethylhexyl sulfonate, sodium cyclohexyl sulfonate, or sodium n-octyl sulfonate; an alkyl sulfonate containing an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, or sodium 5,8,11,14-tetraoxatetradecosane-1-sulfonate; an aryl sulfonate such as sodium benzene sulfonate, sodium p-toluene sulfonate, sodium p-hydroxybenzene sulfonate, sodium p-styrene sulfonate, sodium isophthalic acid dimethyl-5-sulfonate, sodium 1-naphthyl sulfonate, sodium 4-hydroxynaphthyl sulfonate, disodium 1,5-naphthalene disulfonate, or trisodium 1,3,6-naphthalene trisulfonate; and compounds described in paragraphs 0026 to 0031 of JP2007-276454A and paragraphs 0020 to 0047 of JP2009-154525A. The salt may be potassium salt or lithium salt.

Examples of the organic sulfates include an alkyl, an alkenyl, an alkynyl, and an aryl of polyethylene oxide and a sulfate of heterocyclic monoether. The number of ethylene oxide units is preferably in a range of 1 to 4. As a salt, a sodium salt, a potassium salt, or a lithium salt is preferable. Specific examples thereof include compounds described in paragraphs 0034 to 0038 of JP2007-276454A.

As betaines, compounds having 1 to 5 carbon atoms of hydrocarbon substituents to nitrogen atoms are preferable. Specific examples thereof include trimethyl ammonium acetate, dimethyl propyl ammonium acetate, 3-hydroxy-4-trimethyl ammonio butyrate, 4-(1-pyridinio)butyrate, 1-hydroxyethyl-1-imidazolioacetate, trimethyl ammonium methane sulfonate, dimethyl propyl ammonium methane sulfonate, 3-trimethylammonio-1-propane sulfonate, and 3-(1-pyridinio)-1-propane sulfonate.

Since the low-molecular-weight hydrophilic compound has a small structure of a hydrophobic portion and does not almost exhibit a surfactant action, the hydrophobicity or coated-film hardness of an image area is not degraded by dampening water permeating into an exposed portion (image area) of the image recording layer and the ink receiving property or printing durability of the image recording layer can be maintained satisfactorily.

The content of the low-molecular-weight hydrophilic compounds is preferably in a range of 0.5% by mass to 20% by mass, more preferably in a range of 1% by mass to 15% by mass, and still more preferably in a range of 2% by mass to 10% by mass with respect to the total mass of the image recording layer. In a case where the content thereof is in the above-described range, excellent on-press developability and printing durability can be obtained.

The low-molecular-weight hydrophilic compounds may be used alone or in mixture of two or more kinds thereof.

- Sensitizing agent -

In order to improve the impressing property, the image recording layer may contain a sensitizing agent such as a phosphonium compound, a nitrogen-containing low-molecular-weight compound, or an ammonium group-containing polymer. Particularly, in a case where a protective layer contains an inorganic layered compound, these compounds function as a surface coating agent of the inorganic layered compound and suppress degradation of the impressing property due to the inorganic layered compound during the printing.

As the sensitizing agent, it is preferable that a phosphonium compound, a nitrogen-containing low-molecular-weight compound, and an ammonium group-containing polymer are used in combination and more preferable that a phosphonium compound, quaternary ammonium salts, and an ammonium group-containing polymer are used in combination.

Examples of the phosphonium compound include phosphonium compounds described in JP2006-297907A and JP2007-050660A. Specific examples thereof include tetrabutyl phosphonium iodide, butyl triphenyl phosphonium bromide, tetraphenyl phosphonium bromide, 1,4-bis(triphenylphosphonio)butane=di(hexafluorophosphate), 1,7-bis(triphenylphosphonio)heptane=sulfate, and 1,9-bis(triphenylphosphonio)nonane=naphthalene-2,7-disulfonate.

Examples of the nitrogen-containing low-molecular-weight compound include amine salts and quaternary ammonium salts. Further, examples thereof include imidazolinium salts, benzimidazolinium salts, pyridinium salts, and quinolinium salts. Among these, quaternary ammonium salts and pyridinium salts are preferable. Specific examples thereof include tetramethyl ammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, and compounds described in paragraphs 0021 to 0037 of JP2008-284858A and paragraphs 0030 to 0057 of JP2009-090645A.

The ammonium group-containing polymer is not limited as long as the polymer contains an ammonium group in the structure thereof, but a polymer that contains, as a copolymerization component, 5% by mole to 80% by mole of (meth) acrylate containing an ammonium group in a side chain is preferable. Specific examples thereof include polymers described in paragraphs 0089 to 0105 of JP2009-208458A.

The reduced specific viscosity (unit: ml/g) of the ammonium salt-containing polymer which is acquired by the measuring method described in JP2009-208458A is preferably in a range of 5 to 120, more preferably in a range of 10 to 110, and particularly preferably in a range of 15 to 100. In a case where the reduced specific viscosity is converted to the weight-average molecular weight (Mw), the value thereof is preferably in a range of 10000 to 150000, more preferably in a range of 17000 to 140000, and particularly preferably in a range of 20000 to 130000.

Hereinafter, specific examples of the ammonium group-containing polymer will be described.

(1) A 2-(trimethylammonio)ethylmethacrylate=p-toluenesulfonate/3,6-dioxaheptylmethacrylate copolymer (molar ratio of 10/90, Mw of 45000);

(2) A 2-(trimethylammonio)ethylmethacrylate=hexafluorophosphate/3,6-dioxaheptylmethacrylate copolymer (molar ratio of 20/80, Mw of 60000);

(3) A 2-(ethyldimethylammonio)ethylmethacrylate=p-toluenesulfonate/hexylmethacrylate copolymer (molar ratio of 30/70, Mw of 45000);

(4) A 2-(trimethylammonio)ethylmethacrylate=hexafluorophosphate/2-ethylhexylmethacrylate copolymer (molar ratio of 20/80, Mw of 60000);

(5) A 2-(trimethylammonio)ethylmethacrylate=methylsulfate/hexylmethacrylate copolymer (molar ratio of 40/60, Mw of 70000);

(6) A 2-(butyldimethylammonio)ethylmethacrylate=hexafluorophosphate/3,6-dioxaheptylmethacryla te copolymer (molar ratio of 25/75, Mw of 65000);

(7) A 2-(butyldimethylammonio)ethylacrylate=hexafluorophosphate/3,6-dioxaheptylmethacrylate copolymer (molar ratio of 20/80, Mw of 65000);

(8) A 2-(butyldimethylammonio)ethylmethacrylate=13-ethyl-5,8,11-trioxa-1-heptadecanesulfonate/3 ,6-dioxaheptylmethacrylate copolymer (molar ratio of 20/80, Mw of 75000); and

(9) A 2-(butyldimethylammonio)ethylmethacrylate=hexafluorophosphate/3,6-dioxaheptylmethacryla te/2-hydroxy-3-methacryloxypropylmethacrylate copolymer (molar ratio of 15/80/5, Mw of 65000)

The content of the sensitizing agent is preferably in a range of 0.01% by mass to 30.0% by mass, more preferably in a range of 0.1% by mass to 15.0% by mass, and still more preferably in a range of 1% by mass to 10% by mass with respect to the total mass of the image recording layer.

- Acid color former -

It is preferable that the image recording layer used in the present disclosure contains an acid color former.

The "acid color former" used in the present disclosure indicates a compound that exhibits a color-developing property by being heated in a state of receiving an electron-receiving compound (for example, a proton such as an acid). As the acid color former, a colorless compound which has a partial skeleton such as a lactone, a lactam, a sultone, a spiropyran, an ester, or an amide and in which these partial skeletons are rapidly ring-opened or cleaved in a case of being brought into contact with an electron-receiving compound is preferable.

Examples of such an acid color former include phthalides such as 3,3-bis(4-dimethylaminophenyl)-6-dimethylaminophthalide (referred to as "crystal violet lactone"), 3,3-bis(4-dimethylaminophenyl)phthalide, 3-(4-dimethylaminophenyl)-3-(4-diethylamino-2-methylphenyl)-6-dimethylaminophthalide, 3-(4-dimethylaminophenyl)-3-(1,2-dimethylindol-3-yl)phthalide, 3-(4-dimethylaminophenyl)-3-(2-methylindol-3-yl)phthalide, 3,3-bis(1,2-dimethylindol-3-yl)-5-dimethylaminophthalide, 3,3-bis(1,2-dimethylindol-3-yl)-6-dimethylaminophthalide, 3,3-bis(9-ethylcarbazol-3-yl)-6-dimethylaminophthalide, 3,3-bis(2-phenylindol-3-yl)-6-dimethylaminophthalide, and 3-(4-dimethylaminophenyl)-3-(1-methylpyrrol-3-yl)-6-dimethylaminophthalide,

3,3-bis[1,1-bis(4-dimethylaminophenyl)ethylene-2-yl]-4,5,6,7-tetrachlorophthalide, 3,3-bis[1,1-bis(4-pyrrolidinophenyl)ethylene-2-yl]-4,5,6,7-tetrabromophthalide, 3,3-bis[1-(4-dimethylaminophenyl)-1-(4-methoxyphenyl)ethylene-2-yl]-4,5,6,7-tetrachloropht halide, 3,3-bis[1-(4-pyrrolidinophenyl)-1-(4-methoxyphenyl)ethylene-2-yl]4,5,6,7-tetrachlorophthalid e, 3-[1,1-di(1-ethyl-2-methylindol-3-yl)ethylene-2-yl]-3-(4-diethylaminophenyl)phthalide, 3-[1,1-di(1-ethyl-2-methylindol-3-yl)ethylene-2-yl]-3-(4-N-ethyl-N-phenylaminophenyl)phtha lide, 3-(2-ethoxy-4-diethylaminophenyl)-3-(1-n-octyl-2-methylindol-3-yl)-phthalide, 3,3-bis(1-n-octyl-2-methylindol-3-yl)-phthalide, and 3-(2-methyl-4-diethylaminophenyl)-3-(1-n-octyl-2-methylindol-3-yl)-phthalide,

4,4-bis-dimethylaminobenzhydrinbenzylether, N-halophenyl-leucoauramine, N-2,4,5-trichlorophenyl leucoauramine, rhodamine-B-anilinolactam, rhodamine-(4-nitroanilino)lactam, rhodamine-B-(4-chloroanilino)lactam, 3,7-bis(diethylamino)-10-benzoylphenoxazine, benzoyl leucomethylene blue, and 4-nitrobenzoyl methylene blue,

fluorans such as 3,6-dimethoxyfluoran, 3-dimethylamino-7-methoxyfluoran, 3-diethylamino-6-methoxyfluoran, 3-diethylamino-7-methoxyfluoran, 3-diethylamino-7-chlorofluoran, 3-diethylamino-6-methyl-7-chlorofluoran, 3-diethylamino-6,7-dimethylfluoran, 3-N-cyclohexyl-N-n-butylamino-7-methylfluoran, 3-diethylamino-7-dibenzylaminofluoran, 3-diethylamino-7-octylaminofluoran, 3-diethylamino-7-di-n-hexylaminofluoran, 3-diethylamino-7-anilinofluoran, 3-diethylamino-7-(2'-fluorophenylamino)fluoran, 3-diethylamino-7-(2'-chlorophenylamino)fluoran, 3-diethylamino-7-(3'-chlorophenylamino)fluoran, 3-diethylamino-7-(2',3'-dichlorophenylamino)fluoran, 3-diethylamino-7-(3'-trifluoromethylphenylamino)fluoran, 3-di-n-butylamino-7-(2'-fluorophenylamino)fluoran, 3-di-n-butylamino-7-(2'chlorophenylamino)fluoran, 3-N-isopentyl-N-ethylamino-7-(2'-chlorophenylamino)fluoran,

3-N-n-hexyl-N-ethylamino-7-(2'-chlorophenylamino)fluoran, 3-diethylamino-6-chloro-7-anilinofluoran, 3-di-n-butylamino-6-chloro-7-anilinofluoran, 3-diethylamino-6-methoxy-7-anilinofluoran, 3-di-n-butylamino-6-ethoxy-7-anilinofluoran, 3-pyrrolidino-6-methyl-7-anilinofluoran, 3-pyrrolidino-6-methyl-7-anilinofluoran, 3-morpholino-6-methyl-7-anilinofluran, 3-dimethylamino-6-methyl-7-anilinofluoran, 3-diethylamino-6-methyl-7-anilinofluoran, 3-di-n-butylamino-6-methyl-7-anilinofluoran, 3-di-n-pentylamino-6-methyl-7-anilinofluoran, 3-N-ethyl-N-methylamino-6-methyl-7-anilinofluoran, 3-N-n-propyl-N-methylamino-6-methyl-7-anilinofluoran, 3-N-n-propyl-N-ethylamino-6-methyl-7-anilinofluoran, 3-N-n-butyl-N-methylamino-6-methyl-7-anilinofluoran, 3-N-n-butyl-N-ethylamino-6-methyl-7-anilinofluoran, 3-N-isobutyl-N-methylamino-6-methyl-7-anilinofluoran, 3-N-isobutyl-N-ethylamino-6-methyl-7-anilinofluoran, 3-N-isopentyl-N-ethylamino-6-methyl-7-anilinofluoran, 3-N-n-hexyl-N-methylamino-6-methyl-7-anilinofluoran, 3-N-cyclohexyl-N-ethylamino-6-methyl-7-anilinofluoran, 3-N-cyclohexyl-N-n-propylamino-6-methyl-7-anilinofluoran, 3-N-cyclohexyl-N-n-butylamino-6-methyl-7-anilinofluoran, 3-N-cyclohexyl-N-n-hexylamino-6-methyl-7-anilinofluoran, 3-N-cyclohexyl-N-n-octylamino-6-methyl-7-anilinofluoran,

3-N-(2'-methoxyethyl)-N-methylamino-6-methyl-7-anilinofluoran, 3-N-(2'-methoxyethyl)-N-ethylamino-6-methyl-7-anilinofluoran, 3-N-(2'-methoxyethyl)-N-isobutylamino-6-methyl-7-anilinofluoran, 3-N-(2'-ethoxyethyl)-N-methylamino-6-methyl-7-anilinofluoran, 3-N-(2'-ethoxyethyl)-N-ethylamino-6-methyl-7-anilinofluoran, 3-N-(3'-methoxypropyl)-N-methylamino-6-methyl-7-anilinofluoran, 3-N-(3'methoxypropyl)-N-ethylamino-6-methyl-7-anilinofluoran, 3-N-(3'-ethoxypropyl)-N-methylamino-6-methyl-7-anilinofluoran, 3-N-(3'ethoxypropyl)-N-ethylamino-6-methyl-7-anilinofluoran, 3-N-(2'-tetrahydrofurfuryl)-N-ethylamino-6-methyl-7-anilinofluoran, 3-N-(4'-methylphenyl)-N-ethylamino-6-methyl-7-anilinofluoran, 3-diethylamino-6-ethyl-7-anilinofluoran, 3-diethylamino-6-methyl-7-(3'-methylphenylamino) fluoran, 3-diethylamino-6-methyl-7-(2',6'-dimethylphenylamino)fluoran, 3-di-n-butylamino-6-methyl-7-(2',6'-dimethylphenylamino)fluoran, 3-di-n-butylamino-7-(2',6'-dimethylphenylamino)fluoran, 2,2-bis[4'-(3-N-cyclohexyl-N-methylamino-6-methylfluoran)-7-ylaminophenyl]propane, 3-[4'-(4-phenylaminophenyl)aminophenyl]amino-6-methyl-7-chlorofluoran, and 3-[4'(dimethylaminophenyl)]amino-5,7-dimethylfluoran,

phthalides such as 3-(2-methyl-4-diethylaminophenyl)-3-(1-ethyl-2-methylindol-3-yl)-4-azaphthalide, 3-(2-n-propoxycarbonylamino-4-di-n-propylaminophenyl)-3-(1-ethyl-2-methylindol-3-yl)-4-a zaphthalide, 3-(2-methylamino-4-di-n-propylaminophenyl)-3-(1-ethyl-2-methylindol-3-yl)-4-azaphthalide, 3-(2-methyl-4-di-n-hexylaminophenyl)-3-(1-n-octyl-2-methylindol-3-yl)-4,7-diazaphthalide, 3,3-bis(2-ethoxy-4-diethylaminophenyl)-4-azaphthalide, 3,3-bis(1-n-octyl-2-methylindol-3-yl)-4-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-octyl-2-methylindol-3-yl)-4-azaphthalide, 3-(2-ethoxy-4-diethylaminophenyl)-3-(1-octyl-2-methylindol-3-yl)-7-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-ethyl-2-methylindol-3-yl)-7-azaphthalide, 3-(2-hexyloxy-4-diethylaminophenyl)-3-(1-ethyl-2-methylindol-3-yl)-4-azaphthalide, 3-(2-hexyloxy-4-diethylaminophenyl)-3-(1-ethyl-2-methylindol-3-yl)-7-azaphthalide, 3-(2-ethoxy-4-diethylaminophenyl)-3-(1-ethyl-2-phenylindol-3-yl)-4-azaphthalide, 3-(2-ethoxy-4-diethylaminophenyl)-3-(1-ethyl-2-phenylindol-3-yl)-7-azaphthalide, 3-(2-butoxy-4-diethylaminophenyl)-3-(1-ethyl-2-phenylindol-3-yl)-4-azaphthalide, 3-(2-butoxy-4-diethylaminophenyl)-3-(1-ethyl-2-phenylindol-3-yl)-7-azaphthalide, 3-methyl-spiro-dinaphthopyran, 3-ethyl-spiro-dinaphthopyran, 3-phenyl-spiro-dinaphthopyran, 3-benzyl-spiro-dinaphthopyran, 3-methyl-naphtho-(3-methoxybenzo)spiropyran, 3-propyl-spiro-dibenzopyran-3,6-bis(dimethylamino) fluorene-9-spiro-3'-(6'-dimethylamino)p hthalide, and 3,6-bis(diethylamino)fluorene-9-spiro-3'-(6'-dimethylamino)phthalide.

Further, other examples thereof include 2-anilino-6'-(N-ethyl-N-isopentyl)amino-3'-methylspiro[isobenzofuran-1(3H),9'-(9H)xanthen e]-3-one, 2'-anilino-6'-(N-ethyl-N-(4-methylphenyl))amino-3'-methylspiro[isobenzofuran-1(3H),9'-(9H )xanthene]-3-one, 3'-N,N-dibenzylamino-6'-N,N-diethylaminospiro[isobenzofuran-1(3H),9'-(9H) xanthene]-3-o ne, and 2'-(N-methyl-N-phenyl)amino-6'-(N-ethyl-N-(4-methylphenyl))aminospiro[isobenzofuran-1( 3H),9'-(9H)xanthene]-3-one.

Among these, it is preferable that the acid color former used in the present disclosure is at least one compound selected from the group consisting of a spiropyran compound, a spirooxazine compound, a spirolactone compound, and a

spirolactam compound.

From the viewpoint of the visibility, it is preferable that the color tone of the dye after color development is green, blue, or black.

As the acid color former, a commercially available product can be used, and examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals Inc.), and Crystal Violet Lactone (manufactured by Tokyo Chemical Industry Co., Ltd.). Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and Crystal Violet Lactone are preferable from the viewpoint that the visible light absorbance of a film to be formed is satisfactory.

These acid color formers may be used alone or in combination of two or more kinds thereof.

- Colorant -

The image recording layer of the planographic printing plate precursor according to the embodiment of the present disclosure may contain a dye having a large absorption in a visible light region as a colorant for an image. Specific examples thereof include dyes such as Oil Yellow #101, Oil Yellow #103, Oil Pink #312, Oil Green BG, Oil Blue BOS, Oil Blue #603, Oil Black BY, Oil Black BS, and Oil Black T-505 (all manufactured by Orient Chemical Industries Co., Ltd.), Victoria Pure Blue, Crystal Violet (CI42555), Methyl Violet (CI42535), Ethyl Violet, Ethyl Violet 6HNAPS, Rhodamine B (CI145170B), Malachite Green (CI42000), Methylene Blue (CI52015), and dyes described in JP1987-293247A (JP-S62-293247A). Further, pigments such as a phthalocyanine-based pigment, an azo-based pigment, carbon black, and titanium oxide can also be suitably used. It is preferable that the image recording layer contains a colorant because the image area is unlikely to be distinguished from the non-image area after the image formation.

The addition amount of the colorant is preferably in a range of 0.005% by mass to 10% by mass with respect to the total mass of the image recording layer.

- Other components -

The image recording layer may contain, as other components, a surfactant, a polymerization inhibitor, a higher fatty acid derivative, a plasticizer, inorganic particles, an inorganic layered compound, and the like. Specifically, the description in paragraphs 0114 to 0159 of JP2008-284817A can be referred to.

- Formation of image recording layer -

The image recording layer of the planographic printing plate precursor according to the embodiment of the present disclosure can be formed by dispersing or dissolving each of the above-described required components in a known solvent (coating solvent) to prepare a coating solution, coating a support with the coating solution using a known method such as a bar coater coating method, and drying the coating solution, as described in paragraphs 0142 and 0143 of JP2008-195018A. The coating amount (solid content) of the image recording layer after the coating and the drying varies depending on the applications thereof, but is preferably in a range of 0.3 $g/m^2$ to 3.0 $g/m^2$. In a case where the coating amount thereof is in the above-described range, excellent sensitivity and excellent film-coating characteristics of the image recording layer are obtained.

Examples of the coating solvent include a mixed solvent of MEK, MFG, and methanol at a ratio of 48:30:22 (mass ratio, SP value of 11.1), a mixed solvent of 1-propanol and water at a ratio of 1:1 (mass ratio, SP value of 17.7), and a single alcoholic organic solvent.

<Support>

The support in the planographic printing plate precursor according to the embodiment of the present disclosure can be appropriately selected from known hydrophilic supports for planographic printing plate precursors. As the support, a support having a hydrophilic surface (hydrophilic support) is preferable. As the hydrophilic surface, a surface whose contact angle with water is less than 10° is preferable, and a surface whose contact angle with water is less than 5° is more preferable. In the present disclosure, the contact angle of the surface with water is obtained by adding 1 $\mu L$ of pure water dropwise to a surface of an antifogging layer, measuring the contact angle five times according to the $\theta/2$ method using a fully automatic contact angle meter (model number: DM-701, manufactured by Kyowa Interface Science Co., Ltd.) as a

measuring device under conditions of an ambient temperature of 25°C and a relative humidity of 50%, and calculating the arithmetic average value of the obtained values. As the hydrophilic support, an aluminum plate which has been subjected to a roughening treatment and an anodization treatment according to known methods is preferable.

The aluminum plate may be further subjected to a treatment appropriately selected from an expansion treatment or a sealing treatment of micropores of an anodized film described in JP2001-253181A or JP2001-322365A; a surface hydrophilization treatment using alkali metal silicate described in US2714066A, US3181461A, US3280734A, and US3902734A; or a surface hydrophilization treatment using polyvinyl phosphonic acid described in US3276868A, US4153461A, and US4689272A as necessary.

The center line average roughness of the support is preferably in a range of 0.10 μm to 1.2 μm.

The support may have a back coat layer containing an organic polymer compound described in JP1993-045885A (JP-H05-045885A)) or an alkoxy compound of silicon described in JP1994-035174A (JP-H06-035174A) on the surface opposite to a side where the image recording layer is provided, as necessary.

<Undercoat layer>

It is preferable that the planographic printing plate precursor according to the embodiment of the present disclosure includes an undercoat layer (also referred to as an interlayer) between the image recording layer and the support. Since adhesion of the support to the image recording layer is stronger in an exposed portion and the image recording layer is easily peeled off from the support in an unexposed portion, the undercoat layer contributes to improvement of the developability without degrading the printing durability. Further, in a case of infrared laser exposure, since the undercoat layer functions as a heat insulating layer, the undercoat layer also has an effect of preventing heat generated by exposure from being diffused in the support, and thus the sensitivity is not degraded.

Examples of the compound used for the undercoat layer include a polymer containing an adsorptive group which can be adsorbed on the surface of the support and a hydrophilic group. A polymer which contains an adsorptive group and a hydrophilic group for the purpose of improving the adhesiveness to the image recording layer and further contains a crosslinkable group is preferable. The compound used for the undercoat layer may be a low-molecular-weight compound or a polymer. The compound used for the undercoat layer may be used in the form of a mixture of two or more kinds thereof as necessary.

In a case where the compound used for the undercoat layer is a polymer, a copolymer of a monomer containing an adsorptive group, a monomer containing a hydrophilic group, and a monomer containing a crosslinkable group is preferable.

Preferred examples of the adsorptive group that can be adsorbed on the surface of the support include a phenolic hydroxy group, a carboxy group, $-PO_3H_2$, $-OPO_3H_2$, $-CONHSO_2-$, $-SO_2NHSO_2-$, and $-COCH_2COCH_3$. As the hydrophilic group, a sulfo group or a salt thereof, or a salt of a carboxy group is preferable. As the crosslinkable group, an acrylic group, a methacrylic group, an acrylamide group, a methacrylamide group, or an allyl group is preferable.

The polymer may contain a crosslinkable group introduced by forming salts between a polar substituent of the polymer and a compound that has a substituent having the opposite charge to the polar substituent and an ethylenically unsaturated bond or may be formed by further copolymerization of monomers other than the monomers described above and preferably hydrophilic monomers.

Specifically, a silane coupling agent having an ethylenic double bond reactive group, which can be addition-polymerized, described in JP1998-282679A (JP-H10-282679A); and a phosphorous compound having an ethylenic double bond reactive group described in JP1990-304441A (JP-H02-304441A) are suitably exemplified. Further, crosslinkable groups (preferably ethylenically unsaturated bond groups) described in JP2005-238816A, JP2005-125749A, JP2006-239867A, and JP2006-215263A, and low-molecular-weight or high-molecular-weight compounds containing functional groups and hydrophilic groups that interact with the surface of a support are preferably used.

More preferred examples thereof include high-molecular-weight polymers containing adsorptive groups which can be adsorbed on the surface of a support, hydrophilic groups, and crosslinkable groups described in JP2005-125749A and JP2006-188038A.

The content of the ethylenically unsaturated bond group in the polymer used for the undercoat layer is preferably in a range of 0.1 mmol to 10.0 mmol and more preferably in a range of 0.2 mmol to 5.5 mmol with respect to 1 g of the polymer.

The weight-average molecular weight (Mw) of the polymer used for the undercoat layer is preferably 5000 or greater and more preferably in a range of 10000 to 300000.

For the purpose of preventing stain over time, the undercoat layer may contain a chelating agent, a secondary or tertiary amine, a polymerization inhibitor, a compound that includes an amino group or a functional group having polymerization inhibiting ability and a group interacting with the surface of a support (for example, 1,4-diazabicyclo [2.2.2]octane (DABCO), 2,3,5,6-tetrahydroxy-p-quinone, chloranil, sulfophthalic acid, hydroxyethyl ethylene diamine triacetic acid, dihydroxyethyl ethylene diamine diacetic acid, or hydroxyethyl imino diacetic acid) in addition to the

compounds for an undercoat layer described above.

The undercoat layer is applied according to a known method. The coating amount (solid content) of the undercoat layer is preferably in a range of 0.1 $mg/m^2$ to 100 $mg/m^2$ and more preferably in a range of 1 $mg/m^2$ to 30 $mg/m^2$.

<Protective layer>

It is preferable that the planographic printing plate precursor according to the embodiment of the present disclosure has a protective layer (also referred to as an overcoat layer) on the image recording layer. The protective layer has a function of suppressing a reaction of inhibiting image formation through oxygen blocking, a function of preventing generation of damage to the image recording layer, and a function of preventing ablation in a case of exposure to a high illuminance laser.

Such a protective layer having the above-described characteristics is described in US3458311A and JP1980-049729B (JP-S55-049729B). As a polymer with low oxygen permeability which is used for a protective layer, any of a water-soluble polymer and a water-insoluble polymer is appropriately selected and then used and two or more kinds thereof can be used in the form of a mixture as necessary. Specific examples thereof include polyvinyl alcohol, modified polyvinyl alcohol, polyvinylpyrrolidone, a water-soluble cellulose derivative, and poly(meth)acrylonitrile.

As the modified polyvinyl alcohol, acid-modified polyvinyl alcohol containing a carboxy group or a sulfo group is preferably used. Specific examples thereof include modified polyvinyl alcohol described in JP2005-250216A and JP2006-259137A.

It is preferable that the protective layer contains an inorganic layered compound in order to improve the oxygen-blocking property. The inorganic layered compound indicates a particle having a thin tabular shape, and examples thereof include a mica group such as natural mica and synthetic mica, talc represented by Formula: $3MgO \cdot 4SiO \cdot H_2O$, teniolite, montmorillonite, saponite, hectorite, and zirconium phosphate.

An inorganic layered compound which has been preferably used is a mica compound. Examples of the mica compound include a mica group such as synthetic mica and natural mica represented by Formula: $A(B,C)_{2-5}D_4O_{10}(OH,F,O)_2$ [here, A represents any of K, Na, or Ca, B and C represent any of Fe (II), Fe (III), Mn, Al, Mg, or V, and D represents Si or Al].

In the mica group, examples of the natural mica include muscovite, soda mica, phlogopite, biotite, and lepidolite. Examples of the synthetic mica include non-swellable mica such as fluorophogopite $KMg_3(AlSi_3O_{10})F_2$ or potassium tetrasilicic mica $KMg_{2.5}Si_4O_{10})F_2$; and swellable mica such as Na tetrasilicic mica $NaMg_{2.5}(Si_4O_{10})F_2$, Na or Li teniolite $(Na,Li)Mg_2Li(Si_4O_{10})F_2$, or montmorillonite-based Na or Li hectorite $(Na,Li)_{1/8}Mg_{2/5}Li_{1/8}(Si_4O_{10})F_2$. Further, synthetic smectite is also useful.

Among the above-described mica compounds, fluorine-based swellable mica is particularly useful. In other words, swellable synthetic mica has a laminated structure formed of unit crystal lattice layers having a thickness of 10 Å to 15 Å (1 Å = 0.1 nm), and substitution of metal atoms in the lattice is significantly larger than that in other clay minerals. As the result, the lattice layers causes shortage of a positive charge. In order to compensate for this, cations such as $Li^+$, $Na^+$, $Ca^{2+}$, and $Mg^{2+}$ are adsorbed between layers. Cations interposed between layers are referred to as exchangeable cations and can be exchanged for various cations. Particularly, in a case where interlayer cations are $Li^+$ and $Na^+$, since the ion radii thereof is small, bonds between layered crystal lattices are weak and largely swollen due to water. In a case where shearing is applied in this state, cleavage easily occurs so that a sol stabilized in water is formed. The swellable synthetic mica has such a strong tendency and is particularly preferably used.

As the shape of the mica compound, from the viewpoint of controlling diffusion, it is preferable that the thickness thereof is as small as possible and the plane size thereof is as large as possible within a range where the smoothness of the coating surface or the permeability of actinic rays is not inhibited. Therefore, the aspect ratio thereof is preferably 20 or greater, more preferably 100 or greater, and particularly preferably 200 or greater. The aspect ratio is a ratio of the major diameter to the thickness of a particle and can be measured using, for example, a projection drawing obtained from a microphotograph of particles. The effects to be obtained increase as the aspect ratio increases.

In the particle diameter of the mica compound, the average major diameter thereof is preferably in a range of 0.3 μm to 20 μm, more preferably in a range of 0.5 μm to 10 μm, and particularly preferably in a range of 1 μm to 5 μm. The average thickness of the particles is preferably 0.1 μm or less, more preferably 0.05 μm or less, and particularly preferably 0.01 μm or less. Specifically, for example, as a preferable embodiment of swellable synthetic mica which is a representative compound, the thickness thereof is in a range of 1 nm to 50 nm and the surface size (major diameter) is in a range of 1 μm to 20 μm.

The content of the inorganic layered compound is preferably in a range of 0% by mass to 60% by mass and more preferably in a range of 3% by mass to 50% by mass with respect to the total solid content of the protective layer. In a case where a plurality of kinds of inorganic layered compounds are used in combination, it is preferable that the total amount of the inorganic layered compounds is the content described above. In a case where the content thereof is in the above-described range, the oxygen-blocking property is improved and satisfactory sensitivity is obtained. Further, degradation of

the impressing property can be prevented.

The protective layer may contain known additives such as a plasticizer for imparting flexibility, a surfactant for improving the coating properties, and inorganic particles for controlling the slipperiness of the surface. Further, the protective layer may contain a sensitizing agent described in the section of the image recording layer.

The protective layer is coated according to a known method. The coating amount (solid content) of the protective layer is preferably in a range of 0.01 $g/m^2$ to 10 $g/m^2$, more preferably in a range of 0.02 $g/m^2$ to 3 $g/m^2$, and particularly preferably in a range of 0.02 $g/m^2$ to 1 $g/m^2$.

(Method of preparing planographic printing plate and planographic printing method)

A planographic printing plate can be prepared by image-exposing the planographic printing plate precursor according to the embodiment of the present disclosure and performing a development treatment thereon.

A method of preparing a planographic printing plate according to an embodiment of the present disclosure includes a step of imagewise-exposing the planographic printing plate precursor according to the embodiment of the present disclosure to form an exposed portion and an unexposed portion (exposure step); and a step of supplying at least one of printing ink or dampening water to remove the unexposed portion (on-press development step) in order.

A planographic printing method according to an embodiment of the present disclosure includes a step of imagewise-exposing the planographic printing plate precursor according to the embodiment of the present disclosure to form an exposed portion and an unexposed portion (exposure step); a step of supplying at least one selected from the group consisting of printing ink and dampening water to remove the image recording layer of the non-image area on a printing press and preparing a planographic printing plate (on-press development step); and a step of performing printing using the obtained planographic printing plate.

A planographic printing method according to another embodiment of the present disclosure includes a step of imagewise-exposing the planographic printing plate precursor according to the embodiment of the present disclosure to form an exposed portion and an unexposed portion (exposure step); a step of supplying a developer having a pH of 2 to 11 to remove the unexposed portion (development step); and a step of performing printing using the obtained planographic printing plate in order.

Hereinafter, preferred embodiments of each step of the method of preparing a planographic printing plate according to embodiment of the present disclosure and each step of the planographic printing method according to the embodiment of the present disclosure will be sequentially described. Further, the planographic printing plate precursor according to the embodiment of the present disclosure can also be developed with a developer.

<Exposure step>

It is preferable that the method of preparing a planographic printing plate according to the embodiment of the present disclosure includes an exposure step of imagewise-exposing the planographic printing plate precursor according to the embodiment of the present disclosure to form an exposed portion and an unexposed portion. It is preferable that the planographic printing plate precursor according to the embodiment of the present disclosure is exposed to a laser through a transparent original picture having a line image, a halftone image, and the like or imagewise-exposed by laser beam scanning using digital data.

A light source having a wavelength of 750 nm to 1400 nm is preferably used. As the light source having a wavelength of 750 nm to 1400 nm, a solid-state laser or a semiconductor laser that radiates infrared rays is preferable. The output of the infrared laser is preferably 100 mW or greater, the exposure time per one pixel is preferably shorter than 20 microseconds, and the irradiation energy quantity is preferably in a range of 10 $mJ/cm^2$ to 300 $mJ/cm^2$. For the purpose of reducing the exposure time, it is preferable to use a multi-beam laser device. The exposure mechanism may be any of an internal drum system, an external drum system, or a flat bed system.

The image exposure can be performed using a plate setter according to a usual method. In a case of the on-press development, the planographic printing plate precursor may be mounted on the printing press and then imagewise-exposed on the printing press.

<On-press development step and development step>

It is preferable that the method of preparing a planographic printing plate according to the embodiment of the present disclosure includes an on-press development step of supplying at least one of printing ink or dampening water to remove the unexposed portion.

Further, the method of preparing a planographic printing plate according to the embodiment of the present disclosure may be performed by a method of performing development using a developer (developer treatment system).

For example, the method of preparing a planographic printing plate according to the embodiment of the present

disclosure may include a development step of supplying a developer having a pH of 2 to 11 to remove the unexposed portion.

Hereinafter, the on-press development method will be described.

- On-press development method -

According to the on-press development method, it is preferable that the planographic printing plate is prepared from the image-exposed planographic printing plate precursor by supplying oil-based ink and an aqueous component on the printing press to remove the image recording layer of the non-image area.

That is, in a case where the planographic printing plate precursor is image-exposed and then mounted on the printing press without performing any development treatment thereon or the planographic printing plate precursor is mounted on the printing press, image-exposed on the printing press, and oil-based ink and an aqueous component are supplied to perform printing, the uncured image recording layer is removed by being dissolved or dispersed by any or both the supplied oil-based ink and aqueous component in the non-image area at an initial state of the printing so that the hydrophilic surface is exposed to the portion thereof. Meanwhile, the image recording layer cured by exposure forms an oil-based ink receiving unit having a lipophilic surface in the exposed portion. The oil-based ink or the aqueous component may be initially supplied to the plate surface, but it is preferable that the oil-based ink is initially supplied from the viewpoint of preventing contamination of the aqueous component due to the component of the removed image recording layer. In this manner, the planographic printing plate precursor is on-press developed on the printing press and used as it is for printing a plurality of sheets. As the oil-based ink and the aqueous component, printing ink and dampening water for typical planographic printing are suitably used.

- Developer treatment system -

In the planographic printing plate precursor according to the present disclosure, a planographic printing plate can be prepared by performing a development treatment using a developer by appropriately selecting a binder polymer or the like serving as a constituent component of the image recording layer. According to an embodiment, the development treatment carried out using a developer is performed using a developer having a pH of 2 to 11 which may contain at least one compound selected from the group consisting of a surfactant and a water-soluble polymer compound (also referred to as a simple development treatment).

The development treatment and a gum liquid treatment step can be simultaneously performed by allowing a developer to contain a water-soluble polymer compound as necessary. Accordingly, a post-water washing step is not particularly required, and a drying step can be performed after the development treatment and the gum liquid treatment are performed using one liquid and one step. Therefore, it is preferable that the development treatment using a developer is performed according to the method of preparing a planographic printing plate, including a step of performing a development treatment on the image-exposed planographic printing plate precursor using a developer having a pH of 2 to 11. After the development treatment, it is preferable that the drying is performed after the excessive developer is removed using a squeeze roller.

In other words, in the development step of the method of preparing a planographic printing plate according to the present disclosure, it is preferable that the development treatment and the gum liquid treatment are performed using one liquid and one step.

The expression "the development treatment and the gum liquid treatment are performed using one liquid and one step" means that the development treatment and the gum liquid treatment are performed in one step using one liquid without separately performing the development treatment and the gum liquid treatment as individual steps.

The development treatment can be suitably performed using an automatic development treatment device provided with developer supply means and a rubbing member. As the rubbing member, an automatic development treatment device provided with a rotary brush roll is particularly preferable.

It is preferable that two or more rotary brush rolls are used. Further, it is preferable that an automatic development treatment device comprises means for removing the excessive developer, such as a squeeze roller, and drying means such as a hot air device on the rear side of the development treatment means. Further, the automatic development treatment device may comprises pre-heating means for performing a heating treatment on the image-exposed planographic printing plate precursor on the front side of the development treatment means.

The treatment carried out using such an automatic development treatment device has an advantage that it is no longer necessary to deal with development scum derived from a protective layer and/or an image recording layer which is generated in a case of a so-called on-press development treatment.

In a case where the development is carried out by performing a treatment manually, a method of allowing sponge or absorbent cotton to contain an aqueous solution, performing treatment while rubbing the entire plate surface, and drying the aqueous solution after the treatment is completed is suitably exemplified as the development treatment method. In a

case of an immersion treatment, for example, a method of immersing the planographic printing plate precursor in a tray, a deep tank, or the like containing an aqueous solution therein for approximately 60 seconds, stirring the solution, and drying the aqueous solution while rubbing the plate surface with absorbent cotton or sponge is suitably exemplified.

It is preferable that a device capable of simplifying the structure and the steps is used in the development treatment.

In the alkali development treatment, a protective layer is removed by the pre-water washing step, development is performed using an alkaline developer having a high pH, an alkali is removed by the post-water washing step, the gum treatment is performed by a gum coating step, and drying is performed by a drying step. In the simple development treatment, development and gum coating can be simultaneously performed using one liquid. Therefore, the post-water washing step and the gum treatment step can be omitted, and it is preferable that the drying step is performed as necessary after development and gum coating (gum liquid treatment) are performed using one liquid.

Further, it is preferable that removal of the protective layer, development, and gum coating are simultaneously performed using one liquid without performing the pre-water washing step. Further, it is preferable that the excessive developer is removed using a squeeze roller after the development and the gum coating and then drying is performed.

The development step may be performed according to a method of performing immersion in a developer once or a method of performing immersion twice or more times. Among these, a method of performing immersion in the developer once or twice is preferable.

The immersion may be carried out by passing the exposed planographic printing plate precursor through a developer tank in which the developer is stored or spraying the developer onto the plate surface of the exposed planographic printing plate precursor using a spray or the like.

Further, the development treatment is performed using one liquid (one liquid treatment) even in a case where the planographic printing plate precursor is immersed in the developer twice or more times or in a case where the planographic printing plate precursor is immersed, twice or more times, in the same developer as described above or a developer (fatigue liquid) obtained by dissolving or dispersing components of the image recording layer using the developer and the development treatment.

In the development treatment, it is preferable to use a rubbing member and also preferable that a rubbing member such as a brush is installed in a developing bath which removes a non-image area of the image recording layer.

The development treatment can be performed by immersing the planographic printing plate precursor which has been subjected to the exposure treatment and rubbing the plate surface with brushes or pumping up the treatment liquid added to an external tank using a pump, spraying the developer from a spray nozzle, and rubbing the plate surface with brushes at a temperature of preferably 0°C to 60°C and more preferably 15°C to 40°C, according to a conventional method. These development treatments can be continuously performed plural times. For example, the development treatment can be performed by pumping up the developer added to an external tank using a pump, spraying the developer from a spray nozzle, rubbing the plate surface with brushes, spraying the developer from the spray nozzle again, and rubbing the plate surface with the brushes. In a case where the development treatment is performed using an automatic developing machine, since the developer is fatigued as the treatment amount increases, it is preferable that the treatment capability is recovered using a replenisher or a fresh developer.

The development treatment can also be performed using a gum coater or an automatic developing machine which has been known to be used for a presensitized (PS) plate and computer-to-plate (CTP) in the related art. In a case where an automatic developing machine is used, for example, any system from among a system of performing the treatment by pumping the developer added to a developer tank or the developer added to an external tank using a pump and spraying the developer from a spray nozzle, a system of performing the treatment by immersing a printing plate in a tank filled with the developer and transporting the printing plate using a guide roller or the like in the developer, and a so-called disposable treatment system, which is a system of performing the treatment by supplying the substantially unused developer by an amount required for each plate can be employed. In all systems, it is more preferable that a rubbing mechanism using brushes or a molleton is provided. For example, commercially available automatic developing machines (Clean Out Unit C85/C125, Clean-Out Unit+ C85/120, FCF 85V, FCF 125V, FCF News (manufactured by Glunz & Jensen); and Azura CX85, Azura CX125, and Azura CX150 (manufactured by AGFA GRAPHICS) can be used. In addition, a device in which a laser exposure portion and an automatic developing machine portion are integrally incorporated can also be used.

The components and the like of the developer used for the development step will be described in detail.

[pH]

The pH of the developer is preferably in a range of 2 to 11, more preferably in a range of 5 to 9, and still more preferably in a range of 7 to 9. From the viewpoints of the developability and the dispersibility of the image recording layer, it is advantageous that the value of the pH is set to be higher. However, from the viewpoints of the printability and suppression of stain, it is effective that the value of the pH is set to be low.

Here, the pH is a value obtained by performing measurement at 25°C using a pH meter (model number: HM-31, manufactured by DKK-TOA Corporation).

[Surfactant]

The developer may contain a surfactant such as an anionic surfactant, a non-ionic surfactant, a cationic surfactant, or an amphoteric surfactant.

From the viewpoint of blanket stain properties, it is preferable that the developer contains at least one selected from the group consisting of an anionic surfactant and an amphoteric surfactant.

Further, it is preferable that the developer contains a non-ionic surfactant and more preferable that the developer contains at least one selected from the group consisting of a non-ionic surfactant, an anionic surfactant, and an amphoteric surfactant.

Preferred examples of the anionic surfactant include compounds represented by Formula (I).

$$R^1\text{-}Y^1\text{-}X^1 \qquad \text{(I)}$$

In Formula (I), $R^1$ represents an alkyl group, a cycloalkyl group, an alkenyl group, an aralkyl group, or an aryl group which may have a substituent.

As the alkyl group, an alkyl group having 1 to 20 carbon atoms is preferable, and preferred specific examples thereof include a methyl group, an ethyl group, a propyl group, an n-butyl group, a sec-butyl group, a hexyl group, a 2-ethylhexyl group, an octyl group, a decyl group, a dodecyl group, a hexadecyl group, and a stearyl group.

The cycloalkyl group may be monocyclic or polycyclic. As the monocyclic cycloalkyl group, a monocyclic cycloalkyl group having 3 to 8 carbon atoms is preferable, and a cyclopropyl group, a cyclopentyl group, a cyclohexyl group, or a cyclooctyl group is more preferable. Preferred examples of the polycyclic cycloalkyl group include an adamantyl group, a norbornyl group, an isobornyl group, a camphanyl group, a dicyclopentyl group, an $\alpha$-pinel group, and a tricyclodecanyl group.

As the alkenyl group, for example, an alkenyl group having 2 to 20 carbon atoms is preferable, and preferred specific examples thereof include a vinyl group, an allyl group, a butenyl group, and a cyclohexenyl group.

As the aralkyl group, for example, an aralkyl group having 7 to 12 carbon atoms is preferable, and preferred specific examples thereof include a benzyl group, a phenethyl group, and a naphthylmethyl group.

As the aryl group, for example, an aryl group having 6 to 15 carbon atoms is preferable, and preferred specific examples thereof include a phenyl group, a tolyl group, a dimethylphenyl group, a 2,4,6-trimethylphenyl group, a naphthyl group, an anthryl group, and a 9,10-dimethoxyanthryl group.

As the substituent, a monovalent nonmetallic atom group excluding a hydrogen atom is used, and preferred examples thereof include a halogen atom (F, Cl, Br, or I), a hydroxy group, an alkoxy group, an aryloxy group, an acyl group, an amide group, an ester group, an acyloxy group, a carboxy group, a carboxylic acid anion group, and a sulfonic acid anion group.

As specific examples of the alkoxy group in the substituent, a methoxy group, an ethoxy group, a propyloxy group, an isopropyloxy group, a butyloxy group, a pentyloxy group, a hexyloxy group, a dodecyloxy group, a stearyloxy group, a methoxyethoxy group, a poly(ethyleneoxy) group, and a poly(propyleneoxy) group, respectively having 1 to 40 carbon atoms, are preferable; and these groups respectively having 1 to 20 carbon atoms are more preferable. Examples of the aryloxy group include a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group, and a naphthyloxy group, respectively having 6 to 18 carbon atoms. Examples of the acyl group include an acetyl group, a propanoyl group, a butanoyl group, a benzoyl group, and a naphthoyl group, respectively having 2 to 24 carbon atoms. Examples of the amide group include an acetamide group, a propionic acid amide group, a dodecanoic acid amide group, a palmitic acid amide group, a stearic acid amide group, a benzoic acid amide group, and a naphthoic acid amide group, respectively having 2 to 24 carbon atoms. Examples of the acyloxy group include an acetoxy group, a propanoyloxy group, a benzoyloxy group, and a naphthoyloxy group, respectively having 2 to 20 carbon atoms. Examples of the ester group include a methyl ester group, an ethyl ester group, a propyl ester group, a hexyl ester group, an octyl ester group, a dodecyl ester group, and a stearyl ester group, respectively having 1 to 24 carbon atoms. The substituent may be formed by combining two or more substituents described above.

$X^1$ represents a sulfonate group, a sulfate monoester group, a carboxylate group, or a phosphate group.

$Y^1$ represents a single bond, $-C_nH_n-$, $-C_{n-m}H_{2(n-m)}OC_mH_{2m}-$, $-O-(CH_2CH_2O)_n-$, $-O-\{CH_2CH(CH_3)O\}_n-$, $-O-\{CH(CH_3)CH_2O\}_n-$, $-O-(CH_2CH_2CH_2O)_n-$, -CO-NH-, or a divalent linking group formed by combining two or more of these, and the expressions of "$n \geq 1$" and "$n \geq m \geq 0$" are satisfied.

Among examples of the compound represented by Formula (I), from the viewpoint of scratch and stain resistance, a compound represented by Formula (I-A) or Formula (I-B) is preferable.

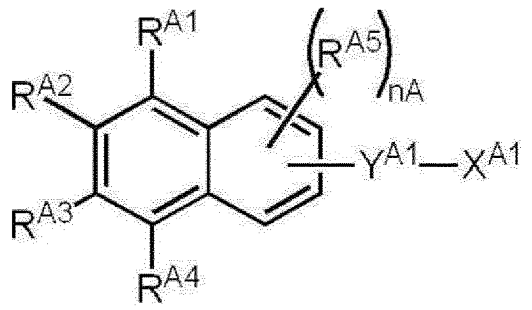

(I-A)

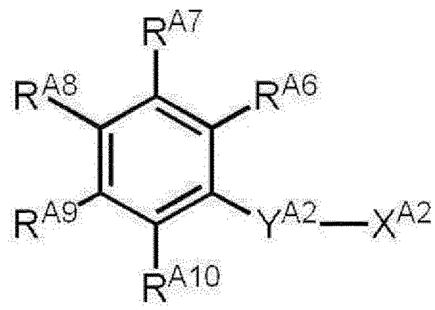

(I-B)

In Formulae (I-A) and (I-B), $R^{A1}$ to $R^{A10}$ each independently represent a hydrogen atom or an alkyl group, nA represents an integer of 1 to 3, $X^{A1}$ and $X^{A2}$ each independently represent a sulfonate group, a sulfate monoester group, a carboxylate group, or a phosphate group, and $Y^{A1}$ and $Y^{A2}$ each independently represent a single bond, $-C_nH_{2n}-$, $-C_{n-m}H_{2(n-m)}OC_mH_{2m}-$, $-O-(CH_2CH_2O)_n-$, $-O-\{CH_2CH(CH_3)O\}_n-$, $-O-\{CH(CH_3)CH_2O\}_n-$, $-O-(CH_2CH_2CH_2O)_n-$, -CO-NH-, or a divalent linking group formed by combining two or more of these and the expressions of "$n \geq 1$" and "$n \geq m \geq 0$" are satisfied. The total number of carbon atoms in $R^{A1}$ to $R^{A5}$ or $R^{A6}$ to $R^{A10}$ and $Y^{A1}$ or $Y^{A2}$ is 3 or greater.

The total number of carbon atoms in $R^{A1}$ to $R^{A5}$ and $Y^{1A}$ or $R^{A6}$ to $R^{A10}$ and $Y^{A2}$ in the compound represented by Formula (I-A) or (I-B) is preferably 25 or less and more preferably in a range of 4 to 20. The structure of the above-described alkyl group may be linear or branched.

It is preferable that $X^{A1}$ and $X^{A2}$ in the compound represented by Formula (I-A) or (I-B) represent a sulfonate group or a carboxylate group. Further, the salt structure in $X^{A1}$ and $X^{A2}$ is preferable from the viewpoint that the solubility of the alkali metal salt in a water-based solvent is particularly excellent. Among the salt structures, a sodium salt or a potassium salt is particularly preferable.

As the compound represented by Formula (I-A) or (I-B), the description in paragraphs 0019 to 0037 of JP2007-206348A can be referred to.

As the anionic surfactant, the compounds described in paragraphs 0023 to 0028 of JP2006-065321A can be suitably used.

The amphoteric surfactant used for the developer is not particularly limited, and examples thereof include an amine oxide-based surfactant such as alkyl dimethylamine oxide; a betaine-based surfactant such as alkyl betaine, fatty acid amide propyl betaine, or alkyl imidazole; and an amino acid-based surfactant such as sodium alkylamino fatty acid.

Particularly, alkyl dimethylamine oxide which may have a substituent, alkyl carboxy betaine which may have a substituent, or alkyl sulfobetaine which may have a substituent is preferably used. Specific examples of these include compounds represented by Formula (2) in paragraph 0256 of JP2008-203359A, compounds represented by Formulae (I), (II), and (VI) in paragraph 0028 of JP2008-276166A, and compounds described in paragraphs 0022 to 0029 of JP2009-047927A.

As the amphoteric surfactant used for the developer, a compound represented by formula (1) or a compound represented by Formula (2) is preferable.

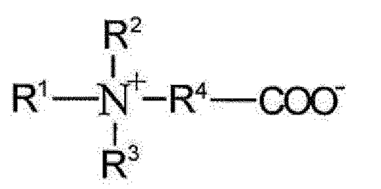

(1)

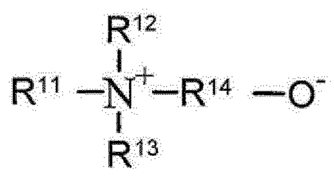

(2)

In Formulae (1) and (2), $R^1$ and $R^{11}$ each independently represent an alkyl group having 8 to 20 carbon atoms or an alkyl group that contains a linking group having 8 to 20 carbon atoms.

$R^2$, $R^3$, $R^{12}$, and $R^{13}$ each independently represent a hydrogen atom, an alkyl group, or a group containing an

ethylene oxide structure.

$R^4$ and $R^{14}$ each independently represent a single bond or an alkylene group.

Further, two groups from among $R^1$, $R^2$, $R^3$, and $R^4$ may be bonded to each other to form a ring structure, and two groups from among $R^{11}$, $R^{12}$, $R^{13}$, and $R^{14}$ may be bonded to each other to form a ring structure.

In the compound represented by Formula (1) or the compound represented by Formula (2), the size of the hydrophobic portion increases as the total number of carbon atoms increases, and the solubility in a water-based developer is degraded. In this case, the solubility is improved by mixing an organic solvent such as alcohol that assists dissolution with water as a dissolution assistant, but the surfactant cannot be dissolved within a proper mixing range in a case where the total number of carbon atoms becomes extremely large. Accordingly, the total number of carbon atoms of $R^1$ to $R^4$ or $R^{11}$ to $R^{14}$ is preferably in a range of 10 to 40 and more preferably in a range of 12 to 30.

The alkyl group containing a linking group represented by $R^1$ or $R^{11}$ has a structure in which a linking group is present between alkyl groups. In other words, in a case where one linking group is present, the structure can be represented by "-alkylene group-linking group-alkyl group". Examples of the linking group include an ester bond, a carbonyl bond, and an amide bond. The structure may have two or more linking groups, but it is preferable that the structure has one linking group, and an amide bond is particularly preferable as the linking group. The total number of carbon atoms of the alkylene group bonded to the linking group is preferably in a range of 1 to 5. The alkylene group may be linear or branched, but a linear alkylene group is preferable. The number of carbon atoms of the alkyl group bonded to the linking group is preferably in a range of 3 to 19, and the alkyl group may be linear or branched, but a linear alkyl group is preferable.

In a case where $R^2$ or $R^{12}$ represents an alkyl group, the number of carbon atoms thereof is preferably in a range of 1 to 5 and particularly preferably in a range of 1 to 3. The alkyl group may be linear or branched, but a linear alkyl group is preferable.

In a case where $R^3$ or $R^{13}$ represents an alkyl group, the number of carbon atoms thereof is preferably in a range of 1 to 5 and particularly preferably in a range of 1 to 3. The alkyl group may be linear or branched, but a linear alkyl group is preferable.

As the group containing an ethylene oxide structure represented by $R^3$ or $R^{13}$, a group represented by $-R^a(CH_2CH_2O)_nR^b$ is exemplified. Here, $R^a$ represents a single bond, an oxygen atom, or a divalent organic group (preferably having 10 or less carbon atoms), $R^b$ represents a hydrogen atom or an organic group (preferably having 10 or less carbon atoms), and n represents an integer of 1 to 10.

In a case where $R^4$ and $R^{14}$ represents an alkylene group, the number of carbon atoms thereof is preferably in a range of 1 to 5 and particularly preferably in a range of 1 to 3. The alkylene group may be linear or branched, but a linear alkylene group is preferable.

The compound represented by Formula (1) or the compound represented by Formula (2) has preferably an amide bond and more preferably an amide bond as a linking group represented by $R^1$ or $R^{11}$.

Representative examples of the compound represented by Formula (1) or the compound represented by Formula (2) are as follows, but the present disclosure is not limited thereto.

I-a)

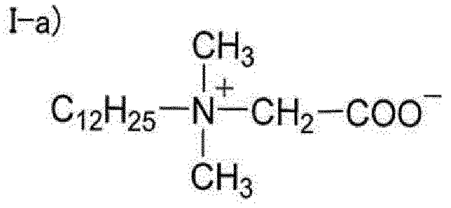

I-b)

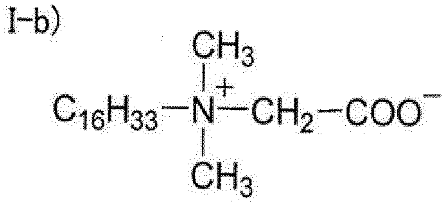

I-c)

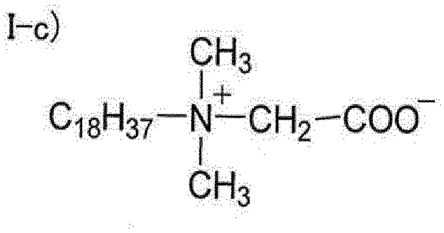

I-d)

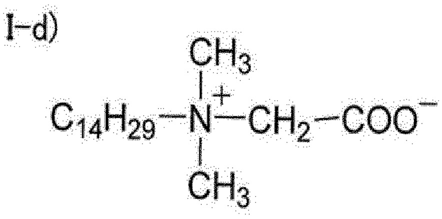

I-e)

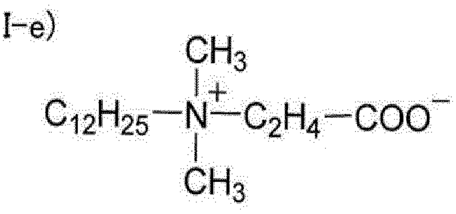

I-f)

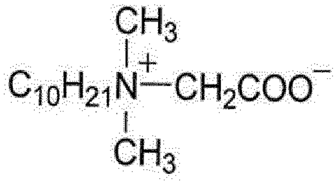

I-g)

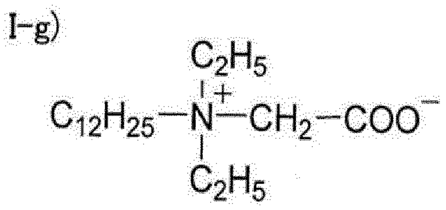

I-h)

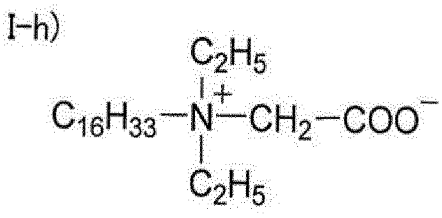

I-i)

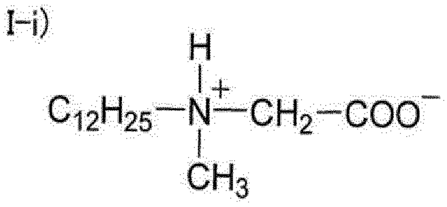

I-j)

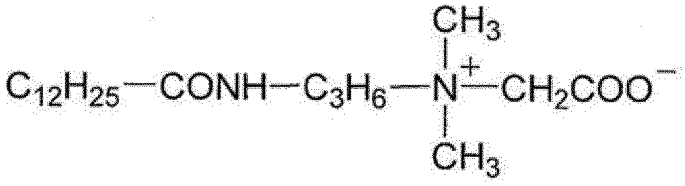

I-k)

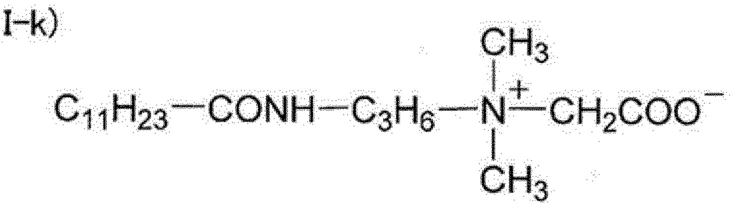

I-l)

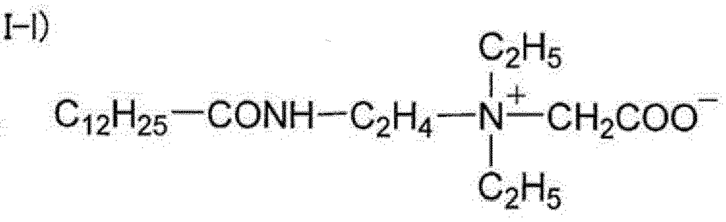

I-m)

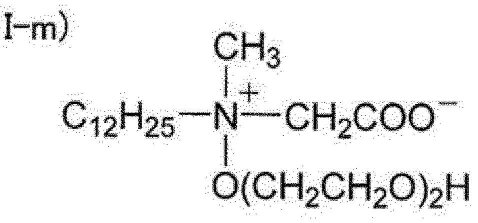

I-n)

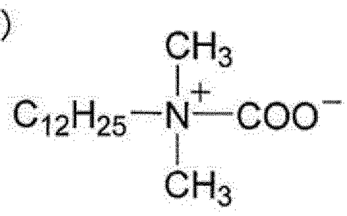

I-o)

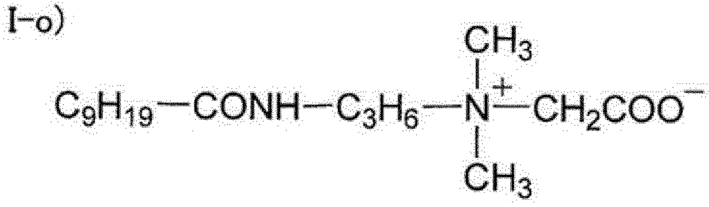

I-p)

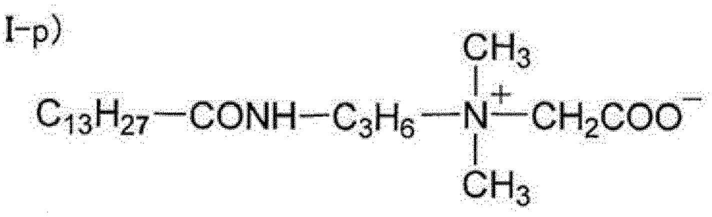

I-q)

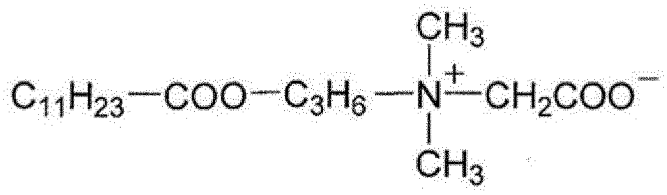

II-a)

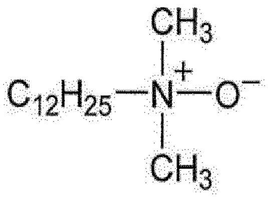

II-b)

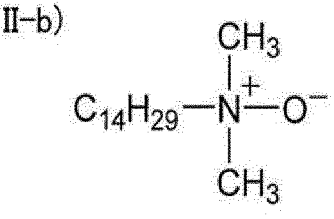

II-c)

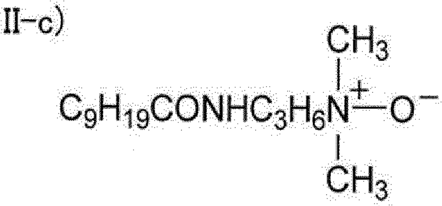

II-d)

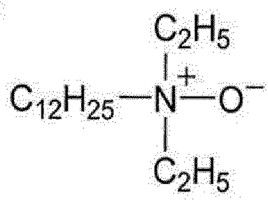

II-e)

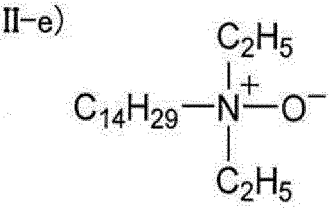

II-f)

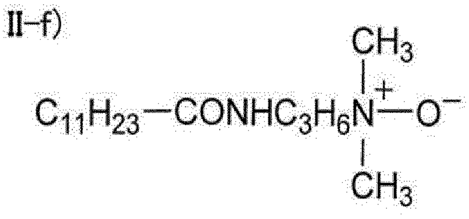

II-g)

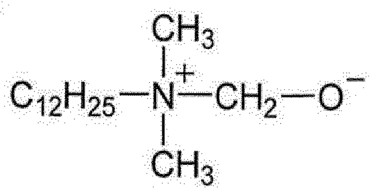

The compound represented by Formula (1) or (2) can be synthesized according to a known method. Further, commercially available products may be used. Examples of the commercially available products of the compound represented by Formula (1) include SOFRAZOLINE LPB, SOFTAZOLINE LPB-R, and VISTA MAP (manufactured by Kawaken Fine Chemicals Co., Ltd.), and TAKESAAF C-157L (manufactured by TAKEMOTO OIL & FAT Co., Ltd.). Examples of the commercially available products of the compound represented by Formula (2) include SOFTAZOLINE LAO (manufactured by Kawaken Fine Chemicals Co., Ltd.) and AMOGEN AOL (manufactured by DKS Co., Ltd.).

The amphoteric surfactant may be used alone or in combination of two or more kinds thereof in a developer.

Examples of non-ionic surfactant include polyoxyethylene alkyl ethers, polyoxyethylene alkyl phenyl ethers, polyoxyethylene polystyryl phenyl ether, glycerin fatty acid partial esters, sorbitan fatty acid partial esters, pentaerythritol fatty acid partial esters, propylene glycol monofatty acid ester, sucrose fatty acid partial ester, polyoxyethylene sorbitan fatty acid partial esters, polyoxyethylene sorbitol fatty acid partial esters, polyethylene glycol fatty acid esters, polyglycerin fatty acid partial esters, polyoxyethylene glycerin fatty acid partial esters, polyoxyethylene diglycerins, fatty acid diethanolamides, N,N-bis-2-hydroxyalkylamines, polyoxyethylene alkylamine, triethanolamine fatty acid ester, trialkylamine oxide, polyoxyethylene alkyl phenyl ethers, and polyoxyethylene-polyoxypropylene block copolymers.

Further, acetylene glycol-based and acetylene alcohol-based oxyethylene adducts, and fluorine-based surfactants can also be used. These surfactants can be used in combination of two or more kinds thereof.

Particularly preferred examples of the non-ionic surfactant include a non-ionic aromatic ether-based surfactant represented by Formula (N1).

$$X^N\text{-}Y^N\text{-}O\text{-}(A^1)_{nB}\text{-}(A^2)_{mB}\text{-}H \qquad (N1)$$

In the formula, $X^N$ represents an aromatic group which may have a substituent, $Y^N$ represents a single bond or an alkylene group having 1 to 10 carbon atoms, $A^1$ and $A^2$ are different groups and represent any of $-CH_2CH_2O-$ or $-CH_2CH(CH_3)O-$, nB and mB each independently represent an integer of 0 to 100, where both nB and mB do not represent 0 at the same time. Further, both nB and mB do not represent 1 at the same time in a case where any of nB or mB represents 0.

In the formula, examples of the aromatic group as $X^N$ include a phenyl group, a naphthyl group, and an anthranyl group. These aromatic groups may have a substituent. As the substituent, an organic group having 1 to 100 carbon atoms is exemplified. Further, in the formula, this may represent a random or block copolymer in a case where both A and B are present.

Specific examples of the organic group having 1 to 100 carbon atoms include aliphatic hydrocarbon groups and aromatic hydrocarbon groups, which may be saturated or unsaturated and linear or branched, such as an alkyl group, an alkenyl group, an alkynyl group, an aryl group, an aralkyl group, an alkoxy group, an aryloxy group, a N-alkylamino group, a N,N-dialkylamino group, a N-arylamino group, a N,N-diarylamino group, a N-alkyl-N-arylamino group, an acyloxy group, a carbamoyloxy group, a N-alkylcarbamoyloxy group, a N-arylcarbamoyloxy group, a N,N-dialkylcarbamoyloxy group, a N,N-diarylcarbamoyloxy group, a N-alkyl-N-arylcarbamoyloxy group, an acylamino group, a N-alkylacylamino group, a N-arylacylamino group, an acyl group, an alkoxycarbonylamino group, an alkoxycarbonyl group, an aryloxycarbonyl group, a carbamoyl group, a N-alkylcarbamoyl group, a N,N-dialkylcarbamoyl group, a N-arylcarbamoyl group, a N,N-diarylcarbamoyl group, a N-alkyl-N-arylcarbamoyl group, a polyoxyalkylene chain, and the above-described organic group to which a polyoxyalkylene chain is bonded. The alkyl group may be linear or branched.

Further, as the non-ionic surfactants, compounds described in paragraphs 0030 to 0040 of JP2006-065321A can also be suitably used.

The cationic surfactant is not particularly limited, and known surfactants of the related art can be used. Examples thereof include alkylamine salts, quaternary ammonium salts, alkylimidazolinium salts, polyoxyethylene alkylamine salts, and a polyethylene polyamine derivative.

The surfactant may be used alone or in combination of two or more kinds thereof.

The content of the surfactant is preferably in a range of 1% by mass to 25% by mass, more preferably in a range of 2% by mass to 20% by mass, still more preferably in a range of 3% by mass to 15% by mass, and particularly preferably in a range of 5% by mass to 10% by mass with respect to the total mass of the developer. In a case where the content thereof is in the above-described range, the scratch and stain resistance is excellent, the dispersibility of the development scum is

excellent, and the ink impressing property of the planographic printing plate to be obtained is excellent.

[Water-soluble polymer compound]

From the viewpoints of adjusting the viscosity of the developer and protecting the plate surface of the planographic printing plate to be obtained, the developer may contain a water-soluble polymer compound.
Examples of the water-soluble polymer compound which can be contained in the developer include soybean polysaccharides, modified starch, arabic gum, dextrin, a fiber derivative (such as carboxymethyl cellulose, carboxyethyl cellulose, or methyl cellulose) and a modified product thereof, pullulan, polyvinyl alcohol and a derivative thereof, polyvinylpyrrolidone, polyacrylamide and an acrylamide copolymer, a vinyl methyl ether/maleic anhydride copolymer, a vinyl acetate/maleic anhydride copolymer, and a styrene/maleic anhydride copolymer.
As the soybean polysaccharides, those which have been known in the related art can be used. For example, SOYAFIBE (trade name, manufactured by FUJI OIL, CO., LTD.) can be used as a commercially available product, and various grades of products can be used. Preferred examples thereof include products in which the viscosity of a 10 mass% aqueous solution is in a range of 10 mPa·s to 100 mPa·s.
As the modified starch, starch represented by Formula (III) is preferable. Any of starch such as corn, potato, tapioca, rice, or wheat can be used as the starch represented by Formula (III). The modification of the starch can be performed according to a method of decomposing 5 to 30 glucose residues per one molecule with an acid or an enzyme and adding oxypropylene to an alkali.

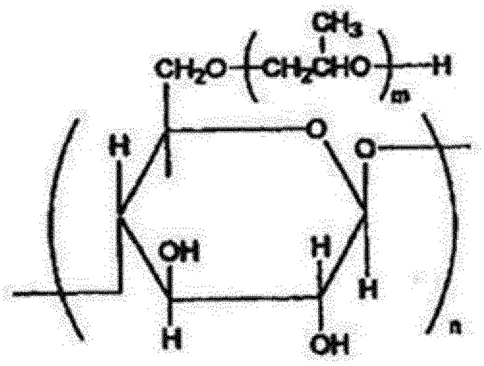

(III)

In the formula, the etherification degree (degree of substitution) is in a range of 0.05 to 1.2 per glucose unit, n represents an integer of 3 to 30, and m represents an integer of 1 to 3.
Among the examples of the water-soluble polymer compound, soybean polysaccharides, modified starch, arabic gum, dextrin, carboxymethyl cellulose, and polyvinyl alcohol are particularly preferable.
The water-soluble polymer compound can be used in combination of two or more kinds thereof.
In a case where the developer contains a water-soluble polymer compound, the content of the water-soluble polymer compound is preferably 3% by mass or less and more preferably 1% by mass or less with respect to the total mass of the developer. In a case where the content thereof is in the above-described range, the viscosity of the developer is moderate, and deposition of development scum and the like on a roller member of an automatic developing machine can be suppressed.

[Other additives]

The developer used in the present disclosure may contain a wetting agent, a preservative, a chelate compound, an antifoaming agent, an organic acid, an organic solvent, an inorganic acid, and an inorganic salt in addition to those described above.
Suitable examples of the wetting agent include ethylene glycol, propylene glycol, triethylene glycol, butylene glycol, hexylene glycol, diethylene glycol, dipropylene glycol, glycerin, trimethylolpropane, and diglycerin. The wetting agent may be used alone or in combination of two or more kinds thereof. The content of the wetting agent is preferably in a range of 0.1% by mass to 5% by mass with respect to the total mass of the developer.
Preferred examples of the preservative include phenol and a derivative thereof, formalin, an imidazole derivative, a sodium dehydroacetate, 4-isothiazoline-3-one derivative, benzoisothiazolin-3-one, 2-methyl-4-isothiazolin-3-one, a benzotiazole derivative, an amidine guanidine derivative, derivatives of quaternary ammonium salts, pyridine, quinoline, and guanidine, diazine, a triazole derivative, oxazole, an oxazole derivative, nitrobromo alcohol-based 2-bromo-2-nitropropane-1,3-diol, 1,1-dibromo-1-nitro-2-ethanol, and 1,1-dibromo-1-nitro-2-propane.

The amount of the preservative to be added is an amount of stably exhibiting the efficacy for bacteria, molds, yeasts, or the like, and is preferably in a range of 0.01% by mass to 4% by mass with respect to the total mass of the developer even though the amount thereof varies depending on the type of bacteria, molds, and the yeasts. Further, it is preferable that the preservative is used in combination of two or more kinds thereof so as to be effective for sterilizing various molds.

Examples of the chelate compound include ethylenediamine tetraacetic acid, a potassium salt thereof, and a sodium salt thereof; diethylenetriamine pentaacetic acid, a potassium salt thereof, and a sodium salt thereof; triethylenetetraminehexaacetic acid, a potassium salt thereof, and a sodium salt thereof; hydroxyethylethylenediamine triacetic acid, a potassium salt thereof, and a sodium salt thereof; nitrilotriacetic acid and a sodium salt thereof; and organic phosphonic acids such as 1-hydroxyethane-1,1-diphosphonic acid, a potassium salt thereof, and a sodium salt thereof; and aminotri(methylenephosphonic acid), a potassium salt, and a sodium salt thereof. A salt of an organic amine is effectively used in place of a sodium salt or a potassium salt of a chelating agent.

A chelating agent which is stably present in the composition of the treatment liquid and does not disturb the printability is preferable as the chelating agent. The content of the chelating agent is preferably in a range of 0.001% by mass to 1.0% by mass with respect to the total mass of the developer.

As the antifoaming agent, a typical silicone-based self-emulsifying type compound, an emulsifying type compound, a non-ionic compound having a hydrophilic-lipophilic balance (HLB) of 5 or less can be used. A silicone antifoaming agent is preferable.

Further, a silicone-based surfactant is regarded as an antifoaming agent.

The content of the antifoaming agent is suitably in a range of 0.001% by mass to 1.0% by mass with respect to the total mass of the developer.

Examples of the organic acid include citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, and organic phosphonic acid. The organic acid can be used in the form of an alkali metal salt or ammonium salt thereof. The content of the organic acid is preferably in a range of 0.01% by mass to 0.5% by mass with respect to the total mass of the developer.

Examples of the organic solvent include aliphatic hydrocarbons (hexane, heptane, "ISOPAR E, H, G" (manufactured by Exxon Chemical Japan Ltd.), and the like), aromatic hydrocarbons (toluene, xylene, and the like), halogenated hydrocarbon (methylene dichloride, ethylene dichloride, trichlene, monochlorobenzene, or the like), and a polar solvent.

Examples of the polar solvent include alcohols (such as methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol, and methyl amyl alcohol), ketones (such as acetone, methyl ethyl ketone, ethyl butyl ketone, methyl isobutyl ketone, and cyclohexanone), esters (such as ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, and butyl levulinate), and others (such as triethyl phosphate, tricresyl phosphate, N-phenylethanolamine, and N-phenyldiethanolamine).

In a case where the organic solvent is insoluble in water, the organic solvent can be used by being solubilized in water using a surfactant or the like. In a case where the developer contains an organic solvent, from the viewpoints of safety and inflammability the concentration of the solvent in the developer is preferably less than 40% by mass.

Examples the inorganic acid and inorganic salt include phosphoric acid, methacrylic acid, primary ammonium phosphate, secondary ammonium phosphate, primary sodium phosphate, secondary sodium phosphate, primary potassium phosphate, secondary potassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogensulfate, and nickel sulfate. The content of the inorganic salt is preferably in a range of 0.01% by mass to 0.5% by mass with respect to the total mass of the developer.

The developer is prepared by dissolving or dispersing each of the above-described components in water as necessary. The concentration of solid contents in the developer is preferably in a range of 2% by mass to 25% by mass. The developer can be used by preparing a concentrate and diluting the concentrate with water at the time of use.

It is preferable that the developer is an aqueous developer.

From the viewpoint of the dispersibility of the development scum, it is preferable that the developer contains an alcohol compound.

Examples of the alcohol compound include methanol, ethanol, propanol, isopropanol, and benzyl alcohol. Among these, benzyl alcohol is preferable.

From the viewpoint of the dispersibility of the development scum, the content of the alcohol compound is

preferably in a range of 0.01% by mass to 5% by mass, more preferably in a range of 0.1% by mass to 2% by mass, and particularly preferably in a range of 0.2% by mass to 1% by mass with respect to the total mass of the developer.

<Printing step>

The planographic printing method according to the embodiment of the present disclosure includes a printing step of supplying printing ink to the planographic printing plate developed in the on-press development step or the development step to print a recording medium.

The printing ink is not particularly limited, and various known inks can be used as desired. Further, preferred examples of the printing ink include oil-based ink and ultraviolet curable ink (UV ink). Among these, UV ink is more preferable.

In the printing step, dampening water may be supplied as necessary.

Further, the printing step may be performed continuously with the on-press development step without stopping the printing press.

The recording medium is not particularly limited, and a known recording medium can be used as desired.

In the method of preparing a planographic printing plate from the planographic printing plate precursor according to the embodiment of the present disclosure and the planographic printing method according to the embodiment of the present disclosure, the entire surface of the planographic printing plate precursor may be heated before the exposure, during the exposure, and between the exposure and the development as necessary. In a case where the surface is heated in the above-described manner, there is an advantage that the image forming reaction in the image recording layer is promoted, the sensitivity and the printing durability are improved, and the sensitivity is stabilized. In a case where the surface is heated before the development, it is preferable that the heating is performed under a mild temperature condition of 150°C or lower. In this manner, problems of curing the non-image area and the like can be prevented. In a case where the surface is heated after the development, it is preferable that the heating is performed under an extremely high temperature condition of 100°C to 500°C. In a case where the temperature is in the above-described range, a sufficient image strengthening effect can be obtained, and problems such as deterioration of the support and thermal decomposition of the image area can be suppressed.

(Polymer particles)

The polymer particles according to the present disclosure contain a polymerizable group and an addition polymerization type resin having a crosslinked structure.

The polymer particles according to the present disclosure have the same definition as that for the specific polymer particles contained in the image recording layer of the planographic printing plate precursor described above, and the preferred embodiments thereof are also the same as described above.

(Curable composition)

The curable composition according to the embodiment of the present disclosure contains the polymer particles according to the present disclosure.

Further, the curable composition according to the embodiment of the present disclosure further contains preferably a polymerization initiator and more preferably an infrared absorbing agent, a polymerization initiator, and a polymerizable compound. In this manner, the curable composition can be suitably used as a curable composition and can also be suitably used for forming the image recording layer in the planographic printing plate precursor according to the embodiment of the present disclosure.

The infrared absorbing agent, the polymerizable compound, and the polymerization initiator contained in the curable composition according to the embodiment of the present disclosure each have the same definition as that for the infrared absorbing agent, the polymerizable compound, and the polymerization initiator contained in the image recording layer of the planographic printing plate precursor according to the embodiment of the present disclosure, and the preferred embodiments are also the same as described above.

Further, the curable composition according to the embodiment of the present disclosure may further contain at least one selected from the group consisting of the binder polymer, the electron-donating polymerization initiator, the chain transfer agent, other polymer particles, the low-molecular-weight hydrophilic compound, the sensitizing agent, the acid color former, and known solvents (the above-described coating solvent and the like) described above.

The content of each component contained in the composition according to the present disclosure corresponds to the amount obtained by converting the content of each component contained in the image recording layer of the planographic printing plate precursor to the solid content in the curable composition.

It is preferable that the curable composition according to the embodiment of the present disclosure is a curable

composition used for producing a planographic printing plate precursor.

That is, the planographic printing plate precursor can be suitably obtained by using the curable composition according to the embodiment of the present disclosure.

Examples

Hereinafter, the present invention will be described in detail with reference to examples, but the present invention is not limited thereto. In the present examples, "%" and "part" respectively indicate "% by mass" and "part by mass" unless otherwise specified. Further, in a polymer compound, the molecular weight indicates the weight-average molecular weight (Mw) and the proportion of repeating structural units indicates mole percentage unless otherwise specified. Further, the weight-average molecular weight (Mw) is a value in terms of polystyrene obtained by performing measurement using gel permeation chromatography (GPC).

Further, specific polymer particles G-1 to G-25 used in the examples are respectively the same as the specific polymer particles G-1 to G-25 described above.

<Synthesis of polymer particle G-1, organic solvent-based>

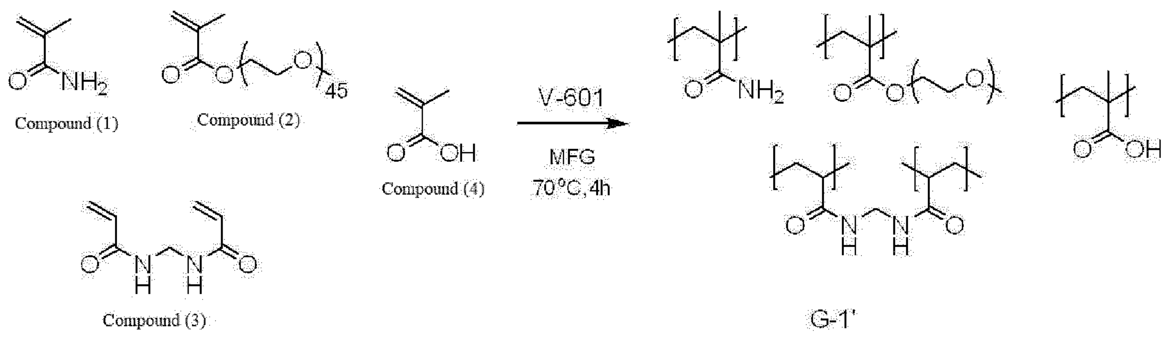


Compound (1) Compound (2) Compound (4) Compound (3) G-1'

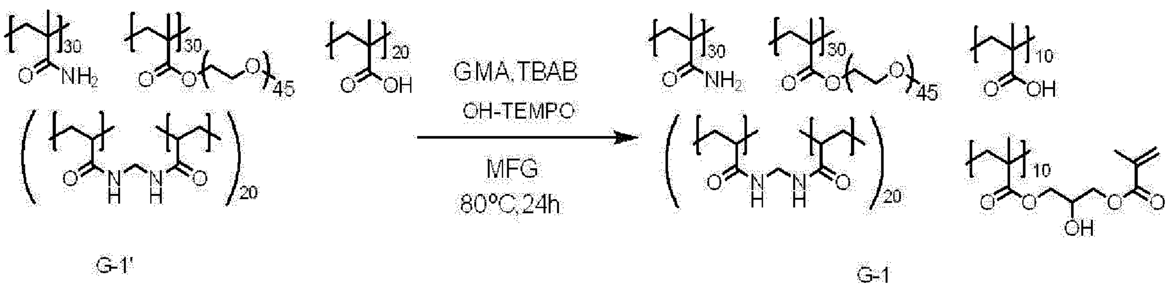


G-1' G-1

1.5 g of the compound (1), 1.5 g of the compound (2), 1.0 g of the compound (3), 1.0 g of methacrylic acid, and 90 g of MFG (1-methoxy-2-propanol) were added to a three-neck flask, stirred in a nitrogen atmosphere, and heated to 70°C. Next, 2.4 g of V-601 (manufactured by FUJIFILM Wako Pure Chemical Corporation) was added to the mixture, and the mixture was stirred for 4 hours and then further stirred at 90°C for 4 hours. After the completion of the stirring, the reaction solution was allowed to be naturally cooled to room temperature (25°C, the same applies hereinafter), thereby obtaining a dispersion liquid of polymer particles G-1' (solid content of approximately 5%). The median diameter of the polymer particles G-1' in the dispersion liquid, which was acquired by light scattering, was 125 nm.

5.4 g of glycidyl methacrylate, 0.12 g of tetrabutylammonium bromide (TBAB), and 50 mg of OH-TEMPO (4-hydroxy-2,2,6,6-tetramethylpiperidine-1-oxyl) were added to 100 g of the dispersion liquid of the obtained polymer particles G-1' (solid content of 5%), and the mixture was stirred at 80°C for 24 hours. The reaction solution was allowed to be naturally cooled to room temperature, thereby obtaining a dispersion liquid of specific polymer particles G-1 (solid content of approximately 6.5%).

<Synthesis of polymer particles G-2, functional groups: amine group and hydroxy group>

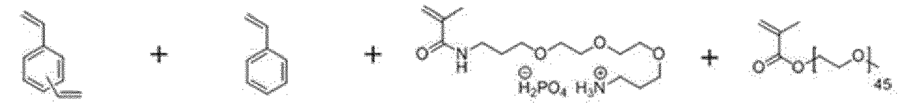

Compound (1) Compound (2) Compound (3) Compound (4)

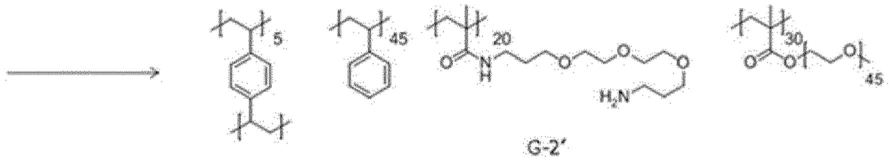

G-2'

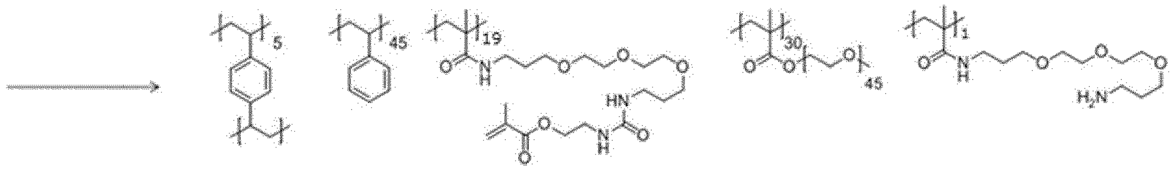

G-2

0.25 g of the compound (1), 2.25 g of the compound (2), 1.0 g of the compound (3), 1.5 g of the compound (4), 0.38 g of sodium lauryl sulfate, and 90 g of distilled water were added a three-neck flask, stirred in a nitrogen atmosphere, and heated to 70°C. Next, 0.245 g of VA-057 (manufactured by FUJIFILM Wako Pure Chemical Corporation) and 5.0 g of distilled water were added to the mixture, and the mixture was stirred for 4 hours. Thereafter, the solution was heated to 90°C and stirred for 2 hours. After the reaction solution was allowed to be naturally cooled to room temperature (25°C, the same applies hereinafter), sodium bicarbonate (sodium hydrogen carbonate) was added to the reaction solution until the pH thereof reached 8.5, thereby obtaining a dispersion liquid of polymer particles G-2' (solid content of 5%). The median diameter of the polymer particles G-2' in the dispersion liquid was 90 nm.

100 g of the obtained dispersion liquid of the polymer particles G-2' (solid content of 5%) was stirred in air and heated to 50°C. After the completion of the stirring, 2.00 g of Karenz MOI (2-isocyanatoethyl methacrylate, manufactured by Showa Denko K. K.) and 0.004 g of 4OH-TEMPO were added thereto, and the solution was stirred for 3 hours, thereby obtaining a dispersion liquid of polymer particles G-2 (solid content of 5%).

<Synthesis of other polymer particles G-3 to G-25, H-1, and H-2>

Other polymer particles G-3 to G-25, H-1, and H-2 were synthesized according to the same method as in the synthesis of the polymer particles G-1 or G-2 except that the monomer serving as a raw material and the amount used were changed. Further, the polymer particles G-3 to G-25 are particles having the structures described above, and the polymer particles H-1 and H-2 are particles having structures shown below. Further, the median diameters and the coefficients of variation in the polymer particles H-1 and H-2 are as follows.

<Synthesis of polymer particles H-3 and H-4>

Polymer particles H-3 were synthesized according to the example of JP2010-234587A (production of the polymer fine particle dispersion liquid (A)). Further, polymer particles H-4 were synthesized according to the example (preparation 1) of JP2013-503365A. The polymer particles H-3 and H-4 are particles having structures shown below (In the polymer particles H-3, commercially available SBX-6 is used as styrene and divinylbenzene particles, and the proportion of styrene and divinylbenzene is unclear).

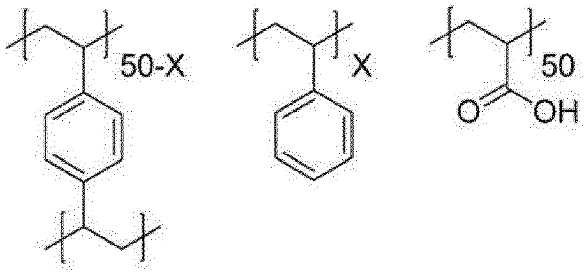

H-3
Median diameter : 90nm
Coefficient of variation : 23.3

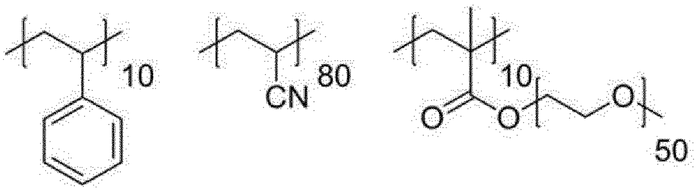

H-4
Median diameter : 90nm
Coefficient of variation : 36.4

<Synthesis of polymer particles S-1>

77.3 g of distilled water, 0.1543 g of Rongalit, 0.5144 g of a 1 mass% ethylenediaminetetraacetic acid aqueous solution, and 0.643 g of 0.2 mass% iron (II) sulfate heptahydrate were added to a three-neck flask, stirred in a nitrogen atmosphere, and heated to 60°C. An emulsion containing 27.4 g of the compound (1), 8.23 g of the compound (2), 2.057 g of ADEKA REASOAP (product name: SR-10, manufactured by ADEKA Corporation), 0.203 g of a 70 mass% t-butyl hydroperoxide aqueous solution, and 20.61 g of distilled water was added dropwise to the mixture for 30 minutes, and the solution was heated and stirred for 30 minutes.

Subsequently, an emulsion containing 2.061 g of the compound (2), 8.24 g of the compound (3), 0.052 g of ADEKA REASOAP (SR-10), 0.025 g of a 70 mass% t-butyl hydroperoxide aqueous solution, and 5.15 g of distilled water was added dropwise to polymer particles S-1' for 10 minutes during dispersion, and the solution was heated and stirred for 2 hours.

The median diameter of the obtained polymer particles S-1' during the dispersion was 100 nm.

20 g of the obtained dispersion liquid (solid content of 34%) of the polymer particles S-1', 0.168 g of tetrabutylammonium bromide (TBAB), 0.001 g of 4OH-TEMPO (4-hydroxy-2,2,6,6-tetramethylpiperidine-1-oxyl), and 0.344 g of 4-HBAGE (4-hydroxybutyl acrylate glycidyl ether) were added to the solution, and the solution was stirred for 8 hours. The reaction solution was allowed to be naturally cooled to room temperature, thereby obtaining a dispersion liquid (solid content of 34%) of polymer particles S-1 as the specific polymer particles.

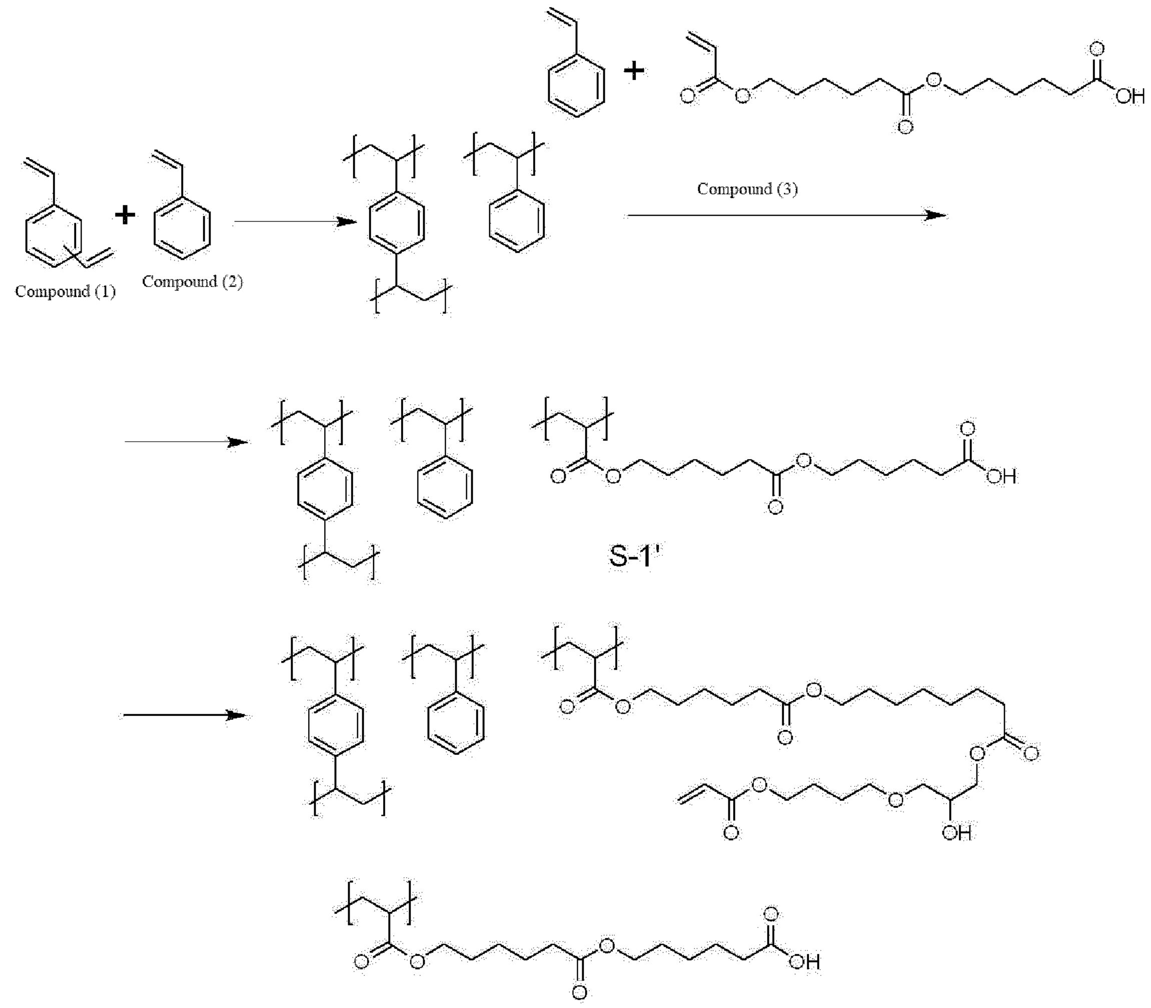


S-1

<Evaluation of dispersion stability of polymer particles>

The dispersibility of the obtained polymer particles G-1 to G-25, H-1 to H-4, and S-1 in a mixed solvent of methyl ethyl ketone (MEK)/1-methoxy-2-propanol (MFG)/methanol (MA) and the dispersibility in water were evaluated.

1 mL of each of the obtained polymer particle dispersion liquids was added to 100 mL of each solvent (MEK/MFG/MA=48/30/22 (% by mass), distilled water), and the solution was stirred under a temperature condition of 20°C for 10 minutes. Thereafter, the solid content dispersion state of the mixed solution which had been allowed to stand at 20°C for 1 hour was visually evaluated. The evaluation index of the dispersibility is as follows. A is the highest rating, and D is the lowest rating in order of A, B, C, and D. The evaluation results are listed in Table 1.

A: A precipitate was not visually confirmed, and the dispersibility was satisfactory.
B: A small amount of precipitate was visually confirmed, but the precipitate was in a re-dispersible state in a case of stirring the solution for 5 minutes.
C: A large amount of precipitate was visually confirmed, but the precipitate was in a re-dispersible state in a case of stirring the solution for 10 minutes even through the precipitate was not able to be re-dispersed in a case of stirring the solution for 5 minutes.
D: A precipitate or adhered matter was visually confirmed and was not able to be re-dispersed in a case of stirring the solution for 10 minutes.

[Table 1]

| Compound No. | Evaluation of dispersion stability | |
|---|---|---|
| | Dispersibility in MEK/MFG/MA | Dispersibility in water |
| G-1 | A | A |
| S-1 | A | A |
| G-2 | A | A |
| G-3 | A | A |
| G-4 | A | A |
| G-5 | A | A |
| G-6 | A | A |
| G-7 | A | D |
| G-8 | B | B |
| G-9 | C | B |
| G-10 | A | A |
| G-11 | B | B |
| G-12 | A | A |
| G-13 | A | A |
| G-14 | B | A |
| G-15 | A | A |
| G-16 | B | A |
| G-17 | A | A |
| G-18 | A | A |
| G-19 | B | B |
| G-20 | A | A |
| G-21 | A | A |
| G-22 | A | A |
| G-23 | A | A |
| G-24 | A | A |
| G-25 | A | A |
| H-1 | A | A |
| H-2 | C | C |
| H-3 | C | A |
| H-4 | B | B |

<Preparation of support>

In order to remove rolling oil on a surface of an aluminum plate (Material JIS A 1050) having a thickness of 0.3 mm, a degreasing treatment was performed using a 10 mass% sodium aluminate aqueous solution at 50°C for 30 seconds, the surface of the aluminum plate was grained using three bundled nylon brushes having a diameter of 0.3 mm and a pumice water suspension (specific gravity of 1.1 g/cm$^3$) having a median diameter of 25 μm and then sufficiently washed with water. The aluminum plate was immersed in a 25 mass% sodium hydroxide aqueous solution at 45°C for 9 seconds, etched, washed with water, and further immersed in a 20 mass% nitric acid aqueous solution at 60°C for 20 seconds, and then washed with water. The etching amount of the grained surface was approximately 3 g/m$^2$.

Next, an electrochemical roughening treatment was continuously performed using an AC voltage of 60 Hz. As the

electrolytic solution, a 1 mass% nitric acid aqueous solution (including 0.5% by mass of aluminum ions) was used at a liquid temperature of 50°C. Using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. As an auxiliary anode, ferrite was used. The current density was 30 A/dm$^2$ in terms of the peak current value, and 5% of the current from the power source was separately flowed to the auxiliary anode. The electric quantity in the nitric acid electrolysis was 175 C/dm$^2$ which is an electric quantity in a case where the aluminum plate was an anode. Thereafter, the aluminum plate was washed with water using a spray.

Next, an electrochemical roughening treatment was performed according to the same method as the method for nitric acid electrolysis under the condition of an electric quantity of 50 C/dm$^2$ in a case where an aluminum plate is an anode in a 0.5 mass% hydrochloric acid aqueous solution (including 0.5% by mass of aluminum ions) and an electrolytic solution at a liquid temperature of 50°C. Subsequently, washing with water using a spray was performed.

Next, 2.5 g/m$^2$ of a DC anodized film was formed on the aluminum plate at a current density of 15 A/dm$^2$ using a 15 mass% nitric acid aqueous solution (including 0.5% by mass of aluminum ions) at a liquid temperature of 54°C as an electrolytic solution, washed with water, and then dried, thereby preparing a support A. The average pore diameter (surface average pore diameter) in the surface layer of the anodized film was 10 nm.

The pore diameter in the surface layer of the anodized film was measured by observing the surface at a magnification of 150000 times using an ultra-high resolution type SEM (S-900, manufactured by Hitachi, Ltd.) without performing a vapor deposition treatment and the like to impart the conductivity at a relatively low acceleration voltage of 12 V, randomly extracting 50 pores, and acquiring the average value. The standard deviation was ± 10% or less.

Thereafter, in order to ensure the hydrophilicity of a non-image area, a silicate treatment was performed by dipping the aluminum plate obtained using 2.5% by mass of a No. 3 sodium silicate aqueous solution at 50°C for 7 seconds, and the aluminum plate was washed with water, thereby preparing a support B. The adhesion amount of Si was 11 mg/m$^2$.

A support C was prepared according to the same method as the method of preparing the support A except that the electrolytic solution in a case of forming a DC anodized film was changed to a 22 mass% phosphoric acid aqueous solution in the preparation of the support A. The average pore diameter (surface average pore diameter) in the surface layer of the anodized film was 25 nm as measured according to the same method as described above.

Thereafter, in order to ensure the hydrophilicity of a non-image area, a silicate treatment was performed on the support B using 2.5% by mass of a No. 3 sodium silicate aqueous solution at 60°C for 10 seconds, and the support was washed with water, thereby preparing a support D. The adhesion amount of Si was 10 mg/m$^2$. The center line average roughness (Ra) of the support D was measured using a needle having a diameter of 2 μm, and the value was 0.52 μm.

<Preparation of undercoat layer coating solution>

- Polymer (UC-1) [structure shown below]: 0.18 parts by mass
- Hydroxyethyliminodiacetic acid: 0.10 parts by mass
- Water: 61.4 parts by mass

(U C - 1)

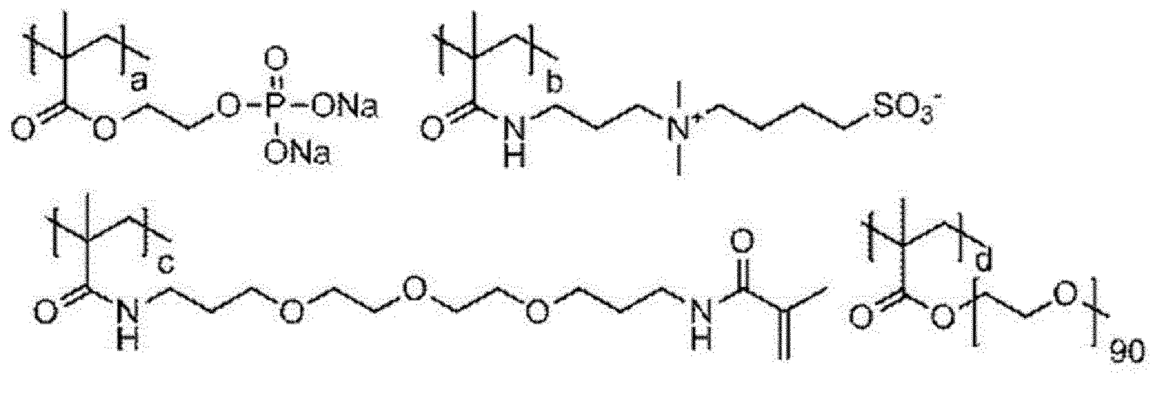

a/b/c/d=14.2/71.8/9.0/5.0(% by mass)

a / b / c / d = 19.0/72.8/7.8/ 0.4 (% by mole) Weight-average molecular weight = 200000

<Preparation of protective layer coating solution>

[Protective layer coating solution]

· Inorganic layered compound dispersion liquid (1) (shown below): 1.5 parts by mass
· Polyvinyl alcohol (CKS50, manufactured by Nippon Synthetic Chemical Industry Co., Ltd., sulfonic acid-modified, saponification degree of 99% by mole or greater, degree of polymerization of 300), 6 mass% aqueous solution: 0.55 parts by mass
· Polyvinyl alcohol (PVA-405, manufactured by Kuraray Co., Ltd., saponification degree of 81.5% by mole, degree of polymerization of 500), 6 mass% aqueous solution: 0.03 parts by mass
· Surfactant (EMALEX (registered trademark) 710, manufactured by Nihon Emulsion Co., Ltd., polyoxyethylene lauryl ether), 1 mass% aqueous solution): 0.86 parts by mass
· Ion exchange water: 6.0 parts by mass

The method of preparing the inorganic layered compound dispersion liquid (1) used in the protective layer coating solution is shown below.

[Preparation of inorganic layered compound dispersion liquid (1)]

6.4 g of synthetic mica (SOMASIF ME-100, manufactured by CO-OP CHEMICAL CO., LTD.) was added to 193.6 g of ion exchange water and dispersed such that the average particle diameter (laser scattering method) was set to 3 mm using a homogenizer. The aspect ratio of the obtained dispersed particles was 100 or greater.

<Preparation of image recording layer coating solution>

An image recording layer coating solution was prepared according to the following image recording layer coating solution (1) and Table 2 or Table 3. The content of each compound listed in Table 2 or Table 3 is the solid content (parts by mass). Further, the image recording layer coating solution containing polymer particles was prepared by mixing a photosensitive liquid obtained by mixing the components described in the following image recording layer coating solution (1) other than the polymer particles with the polymer particle dispersion liquid immediately before the coating such that the composition thereof reached the value listed in Table 2 or Table 3 and stirring the solution.

[Image recording layer coating solution (1)]

· Binder polymer (B-1): 0.240 parts by mass
· Infrared absorbing agent (compound listed in Tables 2 to 4): 0.024 parts by mass
· Polymerization initiator (I-1): 0.245 parts by mass
· Electron-donating polymerization initiator (compound listed in Tables 2 to 4): amount listed in Tables 2 to 4
· Polymerizable compound (compound listed in Tables 2 to 4): 0.192 parts by mass
· Low-molecular-weight hydrophilic compound (compound listed in Tables 2 to 4): 0.062 parts by mass
· Sensitizing agent (compound listed in Tables 2 to 4): 0.008 parts by mass
· Fluorine-based surfactant (1): 0.008 parts by mass
Acid color former (S-205, 2'-anilino-6'-(N-ethyl-N-isopentylamino)-3'-methylspiro[phthalide-3,9'-xanthene] (manufactured by Fukui Yamada Chemical Co., Ltd.)): 0.060 parts by mass
· 2-Butanone: 1.091 parts by mass
· 1-Methoxy-2-propanol: 8.609 parts by mass
· Distilled water: 2.425 parts by mass
· Specific polymer particle liquid: the amount listed in Tables 2 to 4

(Examples 1 to 28, Example 101, and Comparative Examples 1 to 4)

<Preparation of planographic printing plate precursor A>

The planographic printing plate precursors of Examples 1 to 28, Example 101, and Comparative Examples 1 to 4 were respectively prepared by the following method.

The support B was coated with the undercoat layer coating solution having the above-described composition such that the dry coating amount thereof was set to 20 mg/$m^2$, thereby forming an undercoat layer. The undercoat layer was bar-coated with each image recording layer coating solution (1) described above and dried in an oven at 120° for 40 seconds, thereby forming an image recording layer having a dry coating amount of 1.0 g/$m^2$.

The image recording layer coating solution was prepared by mixing polymer particles immediately before the coating and stirring the solution.

The image recording layer was bar-coated with the protective layer coating solution having the above-described composition and dried in an oven at 120°C for 60 seconds, thereby forming a protective layer having a dry coating amount of 0.15 g/$m^2$.

In the examples in which the protective layers were formed, "present" is noted in the columns of the protective layers in Tables 2 to 4.

<Evaluation of planographic printing plate precursor A>

The planographic printing plate precursor prepared in the above-described manner was exposed with Kodak Magnus 800 Quantum (manufactured by Kodak Japan Ltd.) equipped with an infrared semiconductor laser under conditions of an external drum rotation speed of 450 rpm (revolutions per minute), an output of 27 W, and a resolution of 2400 dpi (dot per inch, 1 inch = 2.54 cm) (irradiation energy of approximately 110 mJ/$cm^2$). The exposed image had a solid image and an AM screen (Amplitude Modulation Screen) 3% halftone dot chart.

(1) On-press developability

The obtained exposed precursor was attached to the cylinder of a printing press SX-74 (manufactured by Heidelberg Co.) having a medium octavo size (636 mm × 939 mm) without being subjected to a development treatment. The present printing press was connected to a dampening water circulation tank having a capacity of 100 L and including a nonwoven fabric filter and a temperature control device. The circulation device was charged with 80 L of dampening water containing 2.0% by mass of dampening water S-Z1 (manufactured by FUJIFILM Corporation), dampening water and ink were supplied using ultraviolet curable ink T & K UV OFS K-HS ink GE-M (manufactured by T&K TOKA Co., Ltd.) as printing ink according to a standard automatic printing star method, and printing was performed on 500 sheets of Tokubishi Art (ream weight of 76.5 kg) paper at a printing speed of 10000 sheets per hour.

In the on-press development, the number of printed sheets required until the ink was not transferred to the non-image area was measured as the on-press developability. It can be said that the on-press developability is more excellent as the number of sheets decreases. The measurement results are listed in Tables 2 to 4. In a case where 100 printed sheets were used and the development was not able to be performed thereon, it was noted as "100 or more sheets".

(2) UV printing durability

After the evaluation of the on-press developability described above, printing was further continued. As the number of printed sheets increased, the image area was gradually worn, and thus the ink density on the printed material decreased. The number of printed sheets in a case where the value obtained by measuring the halftone dot area ratio of AM screen 3% halftone dots using a Gretag densitometer (manufactured by GretagMacbeth) in the printed material was decreased by 1% than the measured value of the 500th printed sheet was defined as the number of completely printed sheets, and the UV printing durability was evaluated. The evaluation was performed based on the relative printing durability in which a case where the number of printed sheets was 50000 was rated as 100. The UV printing durability is more excellent as the numerical value increases. The evaluation results are listed in Tables 2 to 4. In a case where the on-press development of the planographic printing plate precursor was not able to be performed and the UV printing durability was not able to be evaluated, it was noted as "impossible to evaluate".

Relative printing durability = (number of printed sheets of target planographic printing plate precursor)/50000 x 100

(3) Property of suppressing on-press development scum

As described above, after printing was performed in the evaluation of the printing durability, the state of adhesion of the removed scum on the dampening roller was evaluated at the same time. The index is as follows. The evaluation

results are listed in Tables 2 to 4.

- Evaluation standards -

A: Scum was not found from the dampening roller
B: A trace amount of scum was found from the dampening roller
C: A large amount of scum was found from the dampening roller.

(4) Thermal temporal stability

The humidity of the planographic printing plate precursors of the examples and the comparative examples was adjusted in an environment of 25°C and a relative humidity of 60% for 1 hour, and the precursors were packaged. Next, the packaged products were aged at 60°C for 4 days. After the completion of thermal aging, the thermal temporal stability was evaluated by performing image exposure and on-press development and measuring the number of printed sheets in the same manner as in the evaluation of the on-press developability described above. The thermal temporal stability was more excellent as the number of sheets decreases.

[Table 2]

| | Support | Protective layer | Image recording layer coating solution (1) | | | | | | | | UV printing durability | On-press developability | On-press development scum | Thermal temporal stability |
|---|---|---|---|---|---|---|---|---|---|---|---|---|---|---|
| | | | Infrared absorbing agent | Electron-donating polymerization initiator | | Polymerizable compound | Low-molecular-weight hydrophilic compound | Sensitizing agent | Specific polymer particles | | | | | |
| | | | | Radical generation assistant | Content (parts by mass) | | | | Type | Content (parts by mass) | (Number of sheets) | (Number of sheets) | A/B/C | (Number of sheets) |
| Example 1 | B | Present | K-1 | R-1 | 0.01 | M-1 | T-1 | C-1 | G-1 | 8.6 | 80 | 10 | A | 15 |
| Example 2 | B | Present | K-1 | R-1 | 0.01 | M-1 | T-1 | C-1 | G-2 | 8.6 | 80 | 24 | A | 32 |
| Example 3 | B | Present | K-1 | R-1 | 0.01 | M-1 | T-1 | C-1 | G-3 | 8.6 | 82 | 15 | A | 18 |
| Example 4 | B | Present | K-1 | R-1 | 0.01 | M-1 | T-1 | C-1 | G-4 | 8.6 | 84 | 28 | A | 38 |
| Example 5 | B | Present | K-1 | R-1 | 0.01 | M-1 | T-1 | C-1 | G-5 | 8.6 | 92 | 16 | A | 30 |
| Example 6 | B | Present | K-1 | R-1 | 0.01 | M-1 | T-1 | C-1 | G-6 | 8.6 | 72 | 12 | A | 12 |
| Example 7 | B | Present | K-1 | R-1 | 0.01 | M-1 | T-1 | C-1 | G-7 | 8.6 | 85 | 30 | C | 35 |
| Example 8 | B | Present | K-1 | R-1 | 0.01 | M-1 | T-1 | C-1 | G-8 | 8.6 | 70 | 24 | B | 29 |
| Example 9 | B | Present | K-1 | R-1 | 0.01 | M-1 | T-1 | C-1 | G-9 | 8.6 | 55 | 65 | C | 68 |
| Example 10 | B | Present | K-1 | R-1 | 0.01 | M-1 | T-1 | C-1 | G-10 | 8.6 | 68 | 27 | A | 30 |
| Example 11 | B | Present | K-1 | R-1 | 0.01 | M-1 | T-1 | C-1 | G-11 | 8.6 | 71 | 25 | B | 28 |
| Example 12 | B | Present | K-1 | R-1 | 0.01 | M-1 | T-1 | C-1 | G-12 | 8.6 | 80 | 12 | A | 15 |
| Example 13 | B | Present | K-1 | R-1 | 0.01 | M-1 | T-1 | C-1 | G-13 | 8.6 | 80 | 8 | A | 10 |

(continued)

| | Support | Protective layer | Image recording layer coating solution (1) | | | | | | | | UV printing durability | On-press developability | On-press development scum | Thermal temporal stability |
|---|---|---|---|---|---|---|---|---|---|---|---|---|---|---|
| | | | Infrared absorbing agent | Electron-donating polymerization initiator | | Polymerizable compound | Low-molecular-weight hydrophilic compound | Sensitizing agent | Specific polymer particles | | | | | |
| | | | | Radical generation assistant | Content (parts by mass) | | | | Type | Content (parts by mass) | (Number of sheets) | (Number of sheets) | A/B/C | (Number of sheets) |
| Example 14 | B | Present | K-1 | R-1 | 0.01 | M-1 | T-1 | C-1 | G-14 | 8.6 | 75 | 20 | A | 30 |
| Example 15 | B | Present | K-1 | R-1 | 0.01 | M-1 | T-1 | C-1 | G-15 | 8.6 | 70 | 7 | A | 10 |
| Example 16 | B | Present | K-1 | R-1 | 0.01 | M-1 | T-1 | C-1 | G-16 | 8.6 | 77 | 12 | A | 12 |
| Example 17 | B | Present | K-1 | R-1 | 0.01 | M-1 | T-1 | C-1 | G-17 | 8.6 | 85 | 10 | A | 10 |
| Example 18 | B | Present | K-1 | R-1 | 0.01 | M-1 | T-1 | C-1 | G-18 | 8.6 | 66 | 15 | A | 15 |

[Table 3]

| | Support | Protective layer | Image recording layer coating solution (1) | | | | | | | | UV printing durability | On-press developability | On-press development scum | Thermal temporal stability |
|---|---|---|---|---|---|---|---|---|---|---|---|---|---|---|
| | | | Infrared absorbing agent | Electron-donating polymerization initiator | | Polymerizable compound | Low-molecular-weight hydrophilic compound | Sensitizing agent | Specific polymer particles | | | | | |
| | | | | Radical generation assistant | Content (parts by mass) | | | | Type | Content (parts by mass) | (Number of sheets) | (Number of sheets) | A/B/C | (Number of sheets) |
| Example 19 | B | Present | K-1 | R-1 | 0.01 | M-1 | T-1 | C-1 | G-20 | 8.6 | 65 | 17 | A | 20 |
| Example 20 | B | Present | K-1 | R-1 | 0.01 | M-1 | T-1 | C-1 | G-23 | 8.6 | 90 | 15 | A | 25 |
| Example 21 | B | Present | K-1 | R-1 | 0.01 | M-3 | T-1 | C-1 | G-3 | 8.6 | 88 | 30 | B | 40 |
| Example 22 | B | Present | K-1 | R-1 | 0.01 | M-1 | T-2 | C-1 | G-13 | 8.6 | 80 | 7 | A | 7 |
| Example 23 | B | Present | K-1 | R-1 | 0.01 | M-1 | T-1 | C-3 | G-17 | 8.6 | 85 | 8 | A | 8 |
| Example 24 | B | Present | K-3 | R-1 | 0.01 | M-4 | T-2 | C-2 | G-17 | 8.6 | 88 | 12 | A | 20 |
| Example 25 | B | Present | K-1 | R-1 | 0.03 | M-1 | T-1 | C-1 | G-1 | 8.6 | 90 | 15 | A | 25 |
| Example 26 | B | Present | K-3 | R-1 | 0.01 | M-1 | T-1 | C-1 | G-1 | 8.6 | 90 | 10 | A | 15 |
| Example 27 | B | Absent | K-1 | R-1 | 0.01 | M-1 | T-1 | C-1 | G-13 | 8.6 | 65 | 10 | A | 10 |
| Example 28 | B | Present | K-1 | R-1 | 0.01 | M-1 | T-1 | C-1 | G-25 | 8.6 | 88 | 12 | A | 20 |
| Comparative example 1 | B | Present | K-1 | R-1 | 0.01 | M-1 | T-1 | C-1 | H-1 | 8.6 | 45 | 15 | A | 20 |
| Comparative example 2 | B | Present | K-1 | R-1 | 0.01 | M-1 | T-1 | C-1 | H-2 | 8.6 | *50* | 32 | C | 35 |
| Comparative example 3 | B | Present | K-1 | R-1 | 0.01 | M-1 | T-1 | C-1 | H-3 | 8.6 | 42 | 45 | C | 50 |
| Comparative example 4 | B | Present | K-1 | R-1 | 0.01 | M-1 | T-1 | C-1 | H-4 | 8.6 | 53 | 30 | B | 35 |

[Table 4]

| | Support | Protective layer | Image recording layer coating solution (1) | | | | | | | | UV printing durability (number of sheets) | On-press developability (number of sheets) | Property of suppressing on-press development scum |
|---|---|---|---|---|---|---|---|---|---|---|---|---|---|
| | | | Infrared absorbing agent | Electron-donating polymerization initiator | | Polymerizable compound | Low-molecular-weight hydrophilic compound | Sensitizing agent | Specific polymer particles | | | | |
| | | | | Type | Content (parts by mass) | | | | Type | Content (parts by mass) | | | |
| Example 101 | B | Present | K-1 | R-1 | 0.01 | M-1 | T-1 | C-1 | S-1 | 8.6 | 100 | 14 | A |

As shown in the results listed in Tables 2 to 4, it was found that in the planographic printing plate precursors according to the embodiment of the present disclosure, the printing durability and the developability in a case of using ultraviolet curable ink were excellent in a case where polymer particles containing a polymerizable group and a hydrophilic structure were used, and the printing durability was further improved in a case where a crosslinked structure was provided.

Further, as shown in the comparison between Examples 7 and 9 with other examples, it was found that the polymer particles of the present disclosure which had a high hydrophilicity due to the amount of hydrophilic groups and the structure had improved developability and improved ability of suppressing development scum in a case obtaining the planographic printing plate precursor.

Further, it is clarified that the balance between the printing durability, the developability, and the development scum was excellent in the planographic printing plate precursors of Examples 1 to 28 and Example 101 as compared with the planographic printing plate precursors of Comparative Examples 1 to 4.

(Examples 29 to 48, Example 102, and Comparative Example 5 to 8)

<Preparation of planographic printing plate precursor B>

A planographic printing plate precursor B was prepared by bar-coating the support D in place of the support B with an image recording layer coating solution (2) in place of the image recording layer coating solution (1), drying the support in an oven at 70°C for 60 seconds form an image recording layer having a dry coating amount of 0.6 g/$m^2$ in the preparation of the planographic printing plate precursor A.

The image recording layer coating solution (2) was prepared by mixing polymer particles immediately before the coating and stirring the solution.

The image recording layer was bar-coated with the protective layer coating solution having the above-described composition and dried in an oven at 120°C for 60 seconds, thereby forming a protective layer having a dry coating amount of 0.15 g/$m^2$.

In the examples in which the protective layers were formed, "present" is noted in the columns of the protective layers in Tables 5 and 6.

The UV printing durability, the on-press developability, the property of suppressing development scum, and the chemical resistance of the obtained planographic printing plate precursor B were evaluated according to the same methods as those for the planographic printing plate precursor A described above, and the evaluation results are listed in Tables 5 and 6.

<Image recording layer coating solution (2)>

· Infrared absorbing agent (compound listed in Tables 5 and 6): 0.018 parts by mass
· Polymerization initiator (compound listed in Tables 5 and 6): 0.150 parts by mass
· Electron-donating polymerization initiator (R-1): 0.010 parts by mass
· Polymerizable compound (SR-399 (manufactured by Sartomer Japan Inc., M-2 shown below): 1.500 parts by mass
Acid color former (S-205, 2'-anilino-6'-(N-ethyl-N-isopentylamino)-3'-methylspiro[phthalide-3,9'-xanthene] (manufactured by Fukui Yamada Chemical Co., Ltd.)): 0.070 parts by mass
· Mercapto-3-triazole: 0.200 parts by mass
· Byk336 (manufactured by BYK Chemie GmbH): 0.4 parts by mass
· Klucel M (manufactured by Hercules, Inc., T-3 shown below): 4.8 parts by mass
· ELVACITE 4026 (manufactured by Ineos Acrylics Ltd.): 2.5 parts by mass
· n-Propanol: 55.0 parts by mass
· 2-Butanone: 17.0 parts by mass
· Specific polymer particle liquid: the amount listed in Tables 5 and 6

Further, the content of each compound listed in Tables 5 and 6 is the solid content (parts by mass).

[Table 5]

| | Support | Protective layer | Image recording layer coating solution (2) | | | | UV printing durability | On-press developability | On-press development scum | Thermal temporal stability |
|---|---|---|---|---|---|---|---|---|---|---|
| | | | Infrared absorbing agent | Polymerization initiator | Specific polymer particles | | | | | |
| | | | | | Type | Content (parts by mass) | (Number of sheets) | (Number of sheets) | A/B/C | (Number of sheets) |
| Example 29 | D | Present | K-2 | I-2 | G-1 | 16.3 | 70 | 30 | A | 40 |
| Example 30 | D | Present | K-2 | I-2 | G-2 | 16.3 | 70 | 40 | A | 45 |
| Example 31 | D | Present | K-2 | I-2 | G-3 | 16.3 | 72 | 32 | A | 45 |
| Example 32 | D | Present | K-2 | I-2 | G-4 | 16.3 | 75 | 45 | A | 50 |
| Example 33 | D | Present | K-2 | I-2 | G-5 | 16.3 | 74 | 32 | A | 38 |
| Example 34 | D | Present | K-2 | I-2 | G-6 | 16.3 | 60 | 30 | A | 30 |
| Example 35 | D | Present | K-2 | I-2 | G-7 | 16.3 | 72 | 50 | C | 52 |
| Example 36 | D | Present | K-2 | I-2 | G-8 | 16.3 | 65 | 45 | B | 50 |
| Example 37 | D | Present | K-2 | I-2 | G-9 | 16.3 | 55 | 65 | C | 65 |
| Example 38 | D | Present | K-2 | I-2 | G-10 | 16.3 | 63 | 42 | A | 42 |
| Example 39 | D | Present | K-2 | I-2 | G-11 | 16.3 | 65 | 25 | A | 29 |
| Example 40 | D | Present | K-2 | I-2 | G-12 | 16.3 | 70 | 28 | A | 30 |
| Example 41 | D | Present | K-2 | I-2 | G-13 | 16.3 | 72 | 25 | A | 30 |
| Example 42 | D | Present | K-2 | I-2 | G-14 | 16.3 | 68 | 27 | A | 35 |
| Example 43 | D | Present | K-2 | I-2 | G-15 | 16.3 | 58 | 20 | A | 25 |
| Example 44 | D | Present | K-2 | I-2 | G-16 | 16.3 | 65 | 25 | A | 35 |
| Example 45 | D | Present | K-2 | I-2 | G-17 | 16.3 | 75 | 25 | A | 40 |
| Example 46 | D | Present | K-2 | I-2 | G-18 | 16.3 | 72 | 25 | A | 30 |
| Example 47 | D | Present | K-2 | I-2 | G-20 | 16.3 | 52 | 30 | A | 35 |
| Example 48 | D | Absent | K-3 | I-3 | G-13 | 16.3 | 52 | 35 | A | 45 |
| Comparative example 5 | D | Present | K-2 | I-2 | H-1 | 16.3 | 40 | 25 | A | 30 |
| Comparative example 6 | D | Present | K-2 | I-2 | H-2 | 16.3 | 45 | 50 | C | 55 |

(continued)

| | Support | Protective layer | Image recording layer coating solution (2) | | | | UV printing durability | On-press developability | On-press development scum | Thermal temporal stability |
|---|---|---|---|---|---|---|---|---|---|---|
| | | | Infrared absorbing agent | Polymerization initiator | Specific polymer particles | | | | | |
| | | | | | Type | Content (parts by mass) | (Number of sheets) | (Number of sheets) | A/B/C | (Number of sheets) |
| Comparative example 7 | D | Present | K-2 | I-2 | H-3 | 16.3 | 42 | 70 | C | 80 |
| Comparative example 8 | D | Present | K-2 | I-2 | H-4 | 16.3 | 48 | 40 | B | 50 |

[Table 6]

| | Support | Protective layer | Image recording layer coating solution (2) | | | | UV printing durability (number of sheets) | On-press developability (number of sheets) | Property of suppressing on-press development scum |
|---|---|---|---|---|---|---|---|---|---|
| | | | Infrared absorbing agent | Polymerization initiator | Specific polymer particles | | | | |
| | | | | | Type | Content (parts by mass) | | | |
| Example 102 | D | Present | K-2 | I-2 | S-1 | 16.3 | 90 | 17 | A |

As shown in the results listed in Tables 5 and 6, it is clarified that the balance between the UV printing durability, the developability, and the development scum was excellent in the planographic printing plate precursors of Examples 29 to 48 and Example 102 as compared with the planographic printing plate precursors of Comparative Examples 5 and 6.

(Examples 49 to 55)

The planographic printing plate precursors of Examples 48 to 55 were respectively prepared according to the following method.

The support B was coated with the undercoat layer coating solution having the above-described composition such that the dry coating amount thereof was set to 20 $mg/m^2$, thereby forming an undercoat layer. The undercoat layer was bar-coated with an image recording layer coating solution (3) described below and dried in an oven at 120° for 40 seconds, thereby forming an image recording layer having a dry coating amount of 1.0 $g/m^2$.

<Preparation of image recording layer coating solution (3)>

An image recording layer coating solution was prepared based on Table 7. The content of each compound listed in Table 7 is a solid content (parts by mass).

Further, the core shell particle dispersion liquid listed in Table 7 was obtained by separately mixing the resin A (polymer particle liquid) with the additive compound B (a monomer or polymer) listed in Table 7 and heating and stirring the at 40°C for 8 hours.

The image recording layer coating solution (3) containing polymer particles was prepared by mixing the following image recording layer coating solution (3) other than the core shell particles with the core shell particle dispersion liquid immediately before the coating and stirring the solution.

[Image recording layer coating solution (3)]

· Infrared absorbing agent (compound listed in Table 7): 0.026 parts by mass
· Polymerization initiator (I-1): 0.260 parts by mass
· Radical generation assistant (compound listed in Table 7): amount listed in Table 7
· Polymerizable compound (compound listed in Table 7): 0.310 parts by mass
· Low-molecular-weight hydrophilic compound (compound listed in Table 7): 0.062 parts by mass
· Sensitizing agent (compound listed in Table 7): 0.008 parts by mass
· Fluorine-based surfactant (1): 0.008 parts by mass
Acid color former (S-205, 2'-anilino-6'-(N-ethyl-N-isopentylamino)-3'-methylspiro[phthalide-3,9'-xanthene] (manufactured by Fukui Yamada Chemical Co., Ltd.)): 0.060 parts by mass
· 2-Butanone: 1.091 parts by mass
· 1-Methoxy-2-propanol: 8.609 parts by mass
· Distilled water: 2.425 parts by mass
· Core shell particle liquid: the amount listed in Table 7

[Table 7]

| | Support | Protective layer | Image recording layer coating solution (3) | | | | | | Core shell particle solution | | | | | UV printing durability | On-press developability | Property of suppressing on-press development scum | Thermal temporal stability |
|---|---|---|---|---|---|---|---|---|---|---|---|---|---|---|---|---|---|
| | | | Infrared absorbing agent | Radical generation assistant | | Polymerizable compound | Low-molecular-weight hydrophilic compound | Sensitizing agent | Resin A | | Compound B | | Addition amount (Total parts) | | | | |
| | | | | Type | Addition amount (parts) | | | | (Type) | Addition amount (parts) | (Type) | Addition amount (parts) | | (Number of sheets | (Number of sheets | A/B/C | (Number of sheets) |
| Example 49 | B | Present | K-1 | R-1 | 0.01 | M-1 | T-1 | C-3 | G-26 | 6.0 | SM-1 | 2.6 | 8.6 | 80 | 15 | A | 15 |
| Example 50 | B | Present | K-3 | R-1 | 0.01 | M-4 | T-2 | C-2 | G-26 | 5.8 | P-1 | 2.8 | 8.6 | 75 | 22 | A | 25 |
| Example 51 | B | Present | K-1 | R-1 | 0.03 | M-1 | T-1 | C-1 | G-27 | 5.8 | SM-2 | 2.8 | 8.6 | 84 | 25 | B | 25 |
| Example 52 | B | Present | K-3 | R-1 | 0.01 | M-1 | T-1 | C-1 | G-27 | *5.0* | P-2 | 3.6 | 8.6 | 80 | 27 | A | 30 |
| Example 53 | B | Absent | K-1 | R-1 | 0.01 | M-1 | T-1 | C-1 | G-28 | *5.0* | SM-3 | 3.6 | 8.6 | 75 | 24 | B | 26 |
| Example 54 | B | Present | K-1 | R-1 | 0.01 | M-1 | T-1 | C-1 | G-28 | 6.2 | P-3 | 2.4 | 8.6 | 70 | 29 | A | 30 |
| Example 55 | B | Present | K-3 | R-1 | 0.01 | M-4 | T-2 | C-2 | G-26 | 5.8 | P-4 | 2.8 | 8.6 | 78 | 25 | A | 22 |

The "compound B" and "compound A" in the "core shell particle liquid" in Table 7 indicate that the compounds having the following structures were used.

| Compound No | Structural formula | Median diameter (nm) | Coefficient of variation (%) |
|---|---|---|---|
| G-26 | 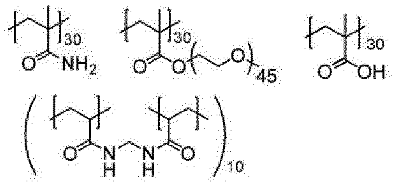 | 120 | 34.1 |
| G-27 | 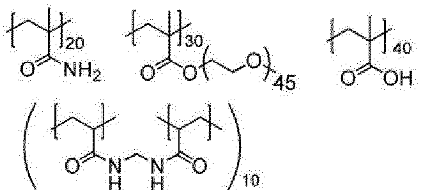 | 145 | 40.1 |
| G-28 | 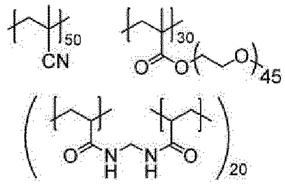 | 162 | 38.2 |

| Compound No | Structural formula | M w |
|---|---|---|
| SM- 1 | 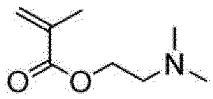 | - |
| P - 1 | 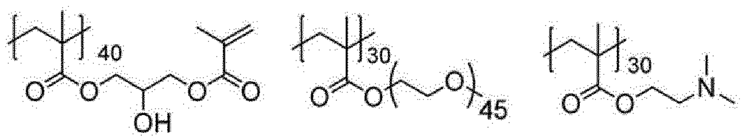 | 25,000 |
| SM- 2 | 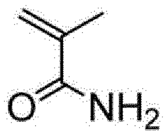 | - |
| P - 2 | 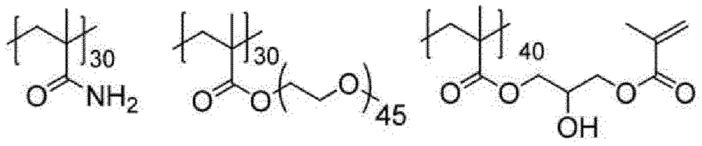 | 30,000 |
| SM- 3 | 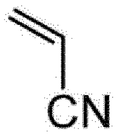 | - |
| P-3 | 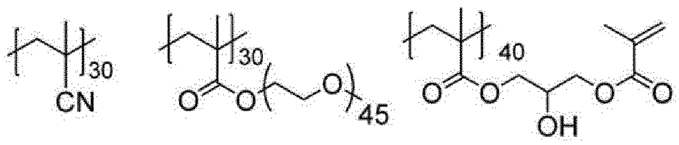 | 50,000 |

(continued)

| Compound No | Structural formula | M w |
|---|---|---|
| P-4 | 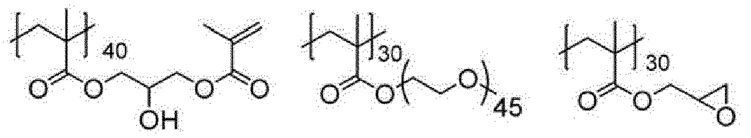 | 35,000 |

As shown in the results listed in Table 7, it is clarified that the balance between the UV printing durability, the developability, and the development scum was excellent in the planographic printing plate precursors of Examples 49 to 55.

The compounds used in the coating solutions (1), (2) and (3) for the image recording layer are as follows.

[Binder polymer]

B-1: Compound having the following structure

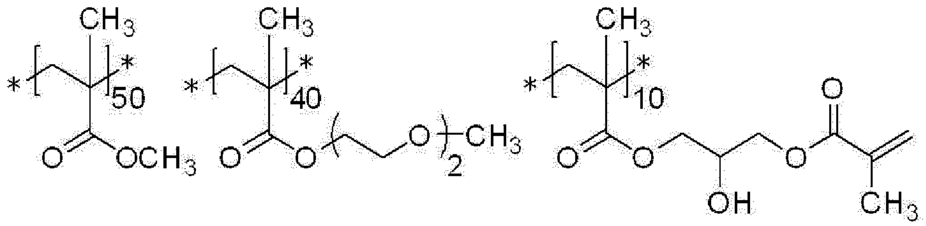

B - 1
Mw = 70,000

In the formula shown above, the content of each structural unit (the subscript on the lower right side of the parentheses) indicates the mass ratio, and the subscript on the lower right side of the parentheses of the ethyleneoxy structure indicates the repetition number.

[Polymerizable compound]

M-1: tris(acryloyloxyethyl) isocyanurate, NK ESTER A-9300, manufactured by Shin-Nakamura Chemical Co., Ltd.
M-2: dipentaerythritol pentaacrylate, SR-399, manufactured by Sartomer Japan Inc.
M-3: dipentaerythritol hexaacrylate, A-DPH, manufactured by Shin-Nakamura Chemical Co., Ltd.
M-4: dipentaerythritol pentaacrylate hexamethylene diisocyanate urethane prepolymer, UA-510H, manufactured by Kyoeisha Chemical Co., Ltd.

[Polymerization initiator]

I-1 to I-3: compounds having the following structures

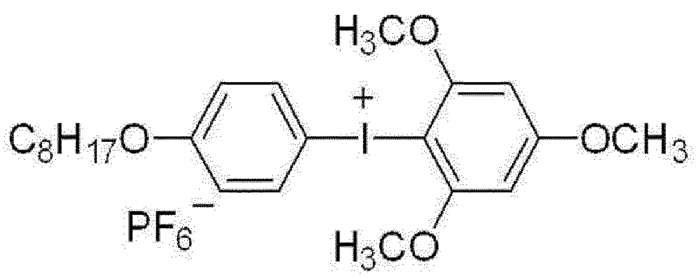

I - 1

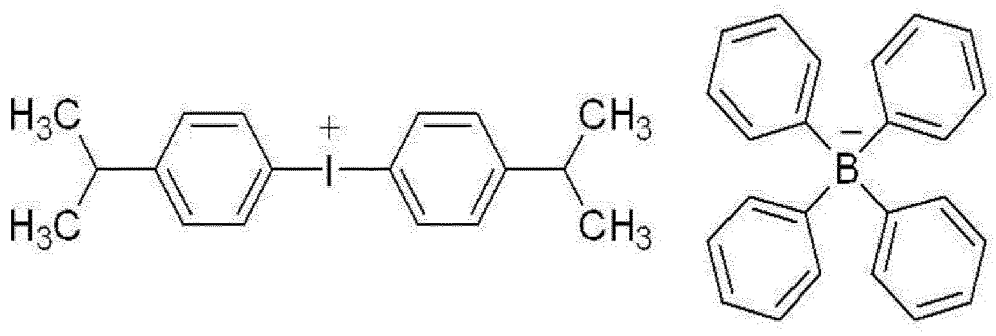

I - 2

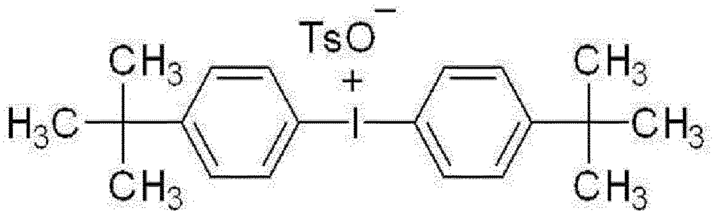

I - 3

In the structures shown above, TsO $^-$ represents a tosylate anion.

[Infrared absorbing agent]

K-1 to K-3: compounds having the following structures

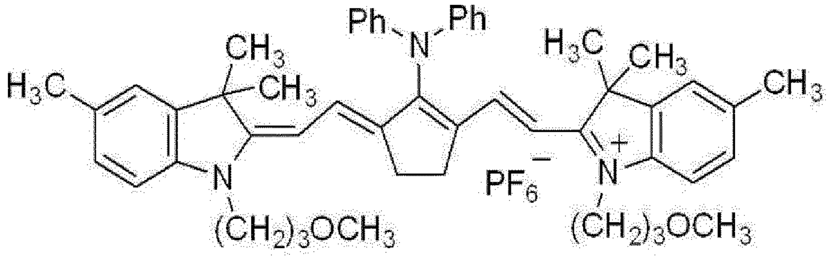

K - 1

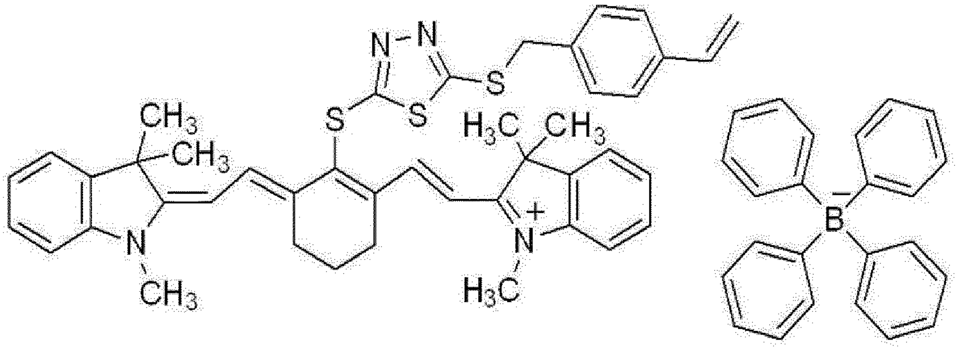

K - 2

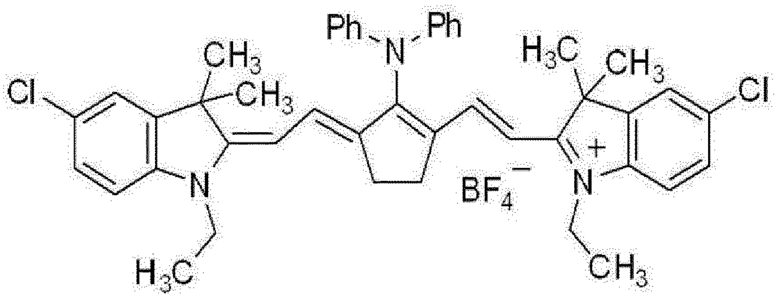

K - 3

In the structures shown above, Ph represents a phenyl group.

[Electron-donating polymerization initiator]

R-1: compound having the following structure

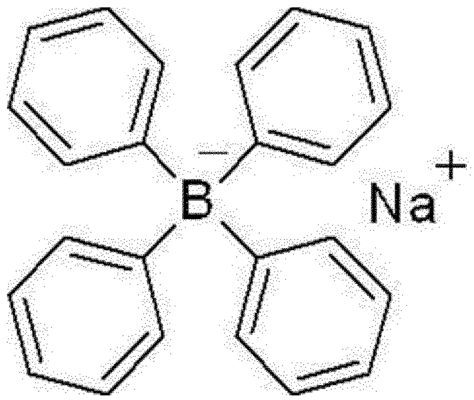

R - 1

[Hydrophilic compound]

T-1: tris(2-hydroxyethyl) isocyanurate
T-2: compound having the following structure
T-3: hydroxypropyl cellulose, Klucel M, manufactured by Hercules, Inc.

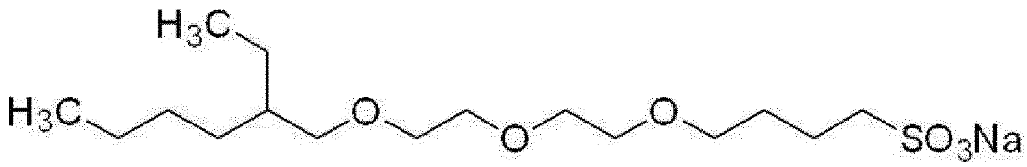

T - 2

[Sensitizing agent]

C-1: compound having the following structure
C-2: benzyl dimethyl octyl ammonium·$PF_6$ salt
C-3: compound having the following structure

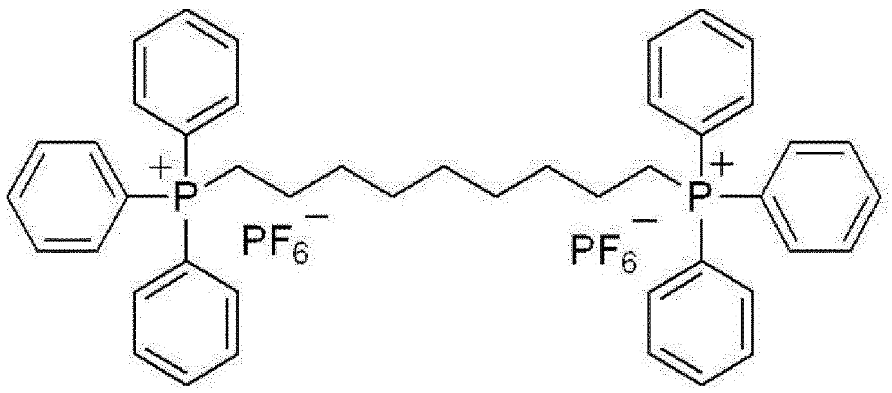

C - 1

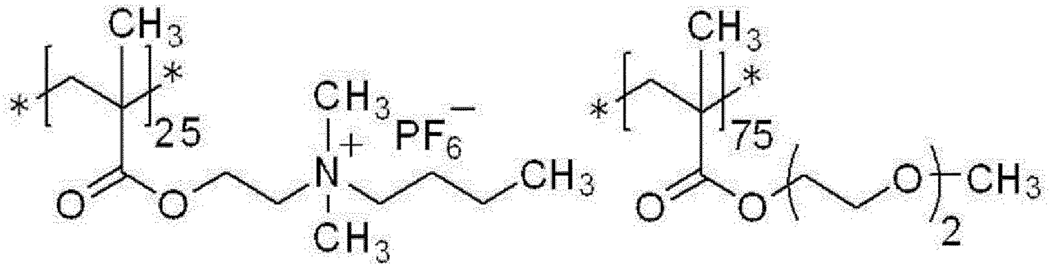

C - 3

[Surfactant]

Fluorine-based surfactant (1): compound W-1 having the following structure

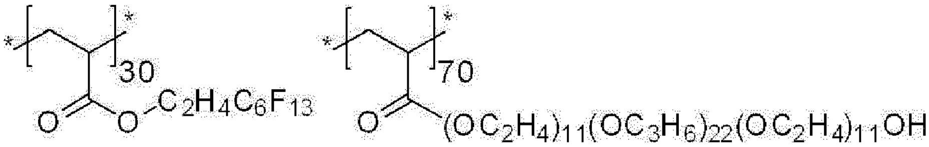

W - 1
Mw = 13,000

In the structure shown above, the subscript on the lower right side of each structural unit indicates the content ratio (mass ratio).

Reference is made to the disclosure of JP2018-163556 filed on August 31, 2018 and the disclosure of JP2019-016536 filed on January 31, 2019.

## Claims

**1.** A planographic printing plate precursor comprising, in the following order:

a support; and
an image recording layer,
wherein the image recording layer contains polymer particles containing an addition polymerization type resin, the addition polymerization type resin contains a polymerizable group and a hydrophilic structure, and
the polymerizable group is an ethylenically unsaturated group, and the ethylenically unsaturated group is a (meth) acryloxy group,
**characterized in that** a coefficient of variation in particle diameter of the polymer particles, determined as defined in the description, is 100% or less.

**2.** The planographic printing plate precursor according to claim 1,
wherein the addition polymerization type resin further has a crosslinked structure.

**3.** The planographic printing plate precursor according to claim 1 or 2,

wherein the hydrophilic structure contains a group represented by Formula Z,

*-Q-W-Y Formula Z

in Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, any one of W or Y has a hydrophilic structure, and * represents a binding site with respect to another structure.

**4.** The planographic printing plate precursor according to any one of claims 1 to 3,
wherein the hydrophilic structure has a polyalkylene oxide structure.

**5.** The planographic printing plate precursor according to any one of claims 1 to 4,

wherein the image recording layer further contains an infrared absorbing agent and a compound represented by Formula I,

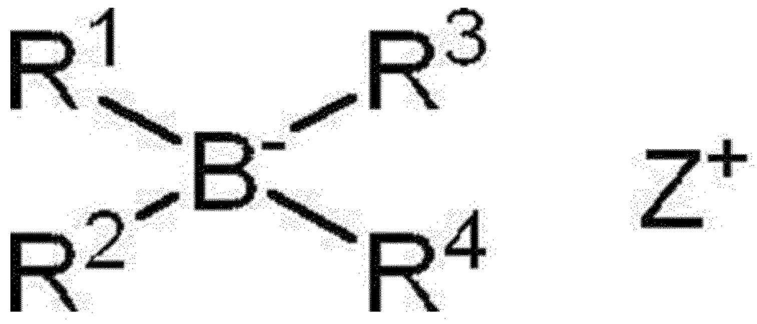

Formula I

in Formula I, $R^1$, $R^2$, $R^3$, and $R^4$ each independently represent an alkyl group, an aryl group, an alkenyl group, an alkynyl group, a cycloalkyl group, or a heterocyclyl group, or two or more of $R^1$, $R^2$, $R^3$, and $R^4$ represent a structure forming a heterocycle in which a boron atom in Formula I is included as a ring member, and $Z^+$ represents a cation.

**6.** The planographic printing plate precursor according to any one of claims 1 to 5, wherein the polymer particles are water-dispersible polymer particles.

**7.** The planographic printing plate precursor according to any one of claims 1 to 6, wherein the polymer particles are organic solvent-dispersible polymer particles.

**8.** The planographic printing plate precursor according to any one of claims 1 to 7, wherein a median diameter of the polymer particles is 1000 nm or less.

**9.** The planographic printing plate precursor according to any one of claims 1 to 8, wherein the planographic printing plate precursor is an on-press development type planographic printing plate precursor.

**10.** A method of preparing a planographic printing plate, comprising:

imagewise-exposing the planographic printing plate precursor according to any one of claims 1 to 9; and
supplying at least one selected from the group consisting of printing ink and dampening water to remove, on a printing press, an image recording layer of a non-image area.

**11.** A planographic printing method, comprising:

imagewise-exposing the planographic printing plate precursor according to any one of claims 1 to 9; and
supplying at least one selected from the group consisting of printing ink and dampening water to remove, on a printing press, an image recording layer of a non-image area to prepare a planographic printing plate; and
performing printing using the obtained planographic printing plate.

**Patentansprüche**

**1.** Planographischer Druckplattenvorläufer, umfassend, in der folgenden Reihenfolge:

einen Träger; und
eine Bildaufzeichnungsschicht,
wobei die Bildaufzeichnungsschicht Polymerpartikel enthält, die ein Harz des Additionspolymerisationstyps enthalten,
das Harz des Additionspolymerisationstyps eine polymerisierbare Gruppe und eine hydrophile Struktur enthält, und
die polymerisierbare Gruppe eine ethylenisch ungesättigte Gruppe ist und die ethylenisch ungesättigte Gruppe eine (Meth)acryloxygruppe ist,

**dadurch gekennzeichnet, dass** ein Variationskoeffizient von Partikeldurchmesser der Polymerpartikel, bestimmt wie in der Beschreibung definiert, 100 % oder weniger beträgt.

2. Planographischer Druckplattenvorläufer nach Anspruch 1, wobei das Harz des Additionspolymerisationstyps ferner eine vernetzte Struktur aufweist.

3. Planographischer Druckplattenvorläufer nach Anspruch 1 oder 2,

wobei die hydrophile Struktur eine Gruppe enthält, die durch Formel Z dargestellt wird,

*-Q-W-Y- Formel Z

in Formel Z Q eine divalente Verbindungsgruppe darstellt, W eine divalente Gruppe mit einer hydrophilen Struktur oder eine divalente Gruppe mit einer hydrophoben Struktur darstellt, Y eine monovalente Gruppe mit einer hydrophilen Struktur oder eine monovalente Gruppe mit einer hydrophoben Struktur darstellt, W oder Y eine hydrophile Struktur aufweist und * eine Bindungsstelle in Bezug auf eine andere Struktur darstellt.

4. Planographischer Druckplattenvorläufer nach einem der Ansprüche 1 bis 3, wobei die hydrophile Struktur eine Polyalkylenoxid-Struktur aufweist.

5. Planographischer Druckplattenvorläufer nach einem der Ansprüche 1 bis 4,

wobei die Bildaufzeichnungsschicht ferner ein infrarotabsorbierendes Mittel und eine Verbindung, die durch Formel I dargestellt wird, enthält,

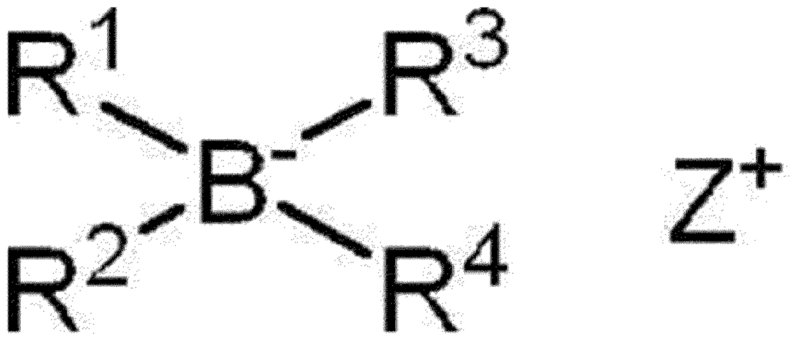

Formel I

in Formel I $R^1$, $R^2$, $R^3$ und $R^4$ jeweils unabhängig voneinander eine Alkylgruppe, eine Arylgruppe, eine Alkenylgruppe, eine Alkynylgruppe, eine Cycloalkylgruppe oder eine Heterocyclylgruppe darstellen oder zwei oder mehr von $R^1$, $R^2$, $R^3$ und $R^4$ eine Struktur, die einen Heterozyklus bildet, in dem ein Boronatom in Formel I als ein Ringelement enthalten ist, darstellen und $Z^+$ ein Kation darstellt.

6. Planographischer Druckplattenvorläufer nach einem der Ansprüche 1 bis 5, wobei die Polymerpartikel wasser-dispergierbare Polymerpartikel sind.

7. Planographischer Druckplattenvorläufer nach einem der Ansprüche 1 bis 6, wobei die Polymerpartikel organische lösungsmittel-dispergierbare Polymerpartikel sind.

8. Planographischer Druckplattenvorläufer nach einem der Ansprüche 1 bis 7, wobei ein mittlerer Durchmesser der Polymerpartikel 1000 nm oder weniger beträgt.

9. Planographischer Druckplattenvorläufer nach einem der Ansprüche 1 bis 8, wobei der planographische Druckplattenvorläufer ein planographischer Druckplattenvorläufer des Druckpressen-Entwicklungstyps ist.

10. Verfahren des Herstellens einer planographischen Druckplatte, umfassend:

bildweises Belichten des planographischen Druckplattenvorläufers nach einem der Ansprüche 1 bis 9; und

Zuführen von mindestens einem, das aus der Gruppe, die aus Druckfarbe und Feuchtwasser besteht, ausgewählt wird, um an einer Druckmaschine eine Bildaufzeichnungsschicht eines Nichtbildbereichs zu entfernen.

**11.** Planographisches Druckverfahren, umfassend:

bildweises Belichten des planographischen Druckplattenvorläufers nach einem der Ansprüche 1 bis 9; und
Zuführen von mindestens einem, das aus der Gruppe, die aus Druckfarbe und Feuchtwasser besteht, ausgewählt wird, um eine Bildaufzeichnungsschicht eines Nichtbildbereichs an einer Druckmaschine zu entfernen, um eine planographische Druckplatte herzustellen; und
Durchführen von Drucken unter Verwendung der erhaltenen planographischen Druckplatte.

## Revendications

**1.** Précurseur de plaque d'impression planographique comprenant, dans l'ordre suivant :

un support ; et
une couche d'enregistrement d'images,
dans lequel la couche d'enregistrement d'images contient des particules de polymère contenant une résine de type polymérisation par addition,
la résine de type polymérisation par addition contient un groupe polymérisable et une structure hydrophile, et le groupe polymérisable est un groupe éthyléniquement insaturé, et le groupe éthyléniquement insaturé est un groupe (méth)acryloxy,
**caractérisé en ce qu'**un coefficient de variation du diamètre des particules de polymère, déterminé comme défini dans la description, est de 100 % ou moins.

**2.** Précurseur de plaque d'impression planographique selon la revendication 1,
dans lequel la résine de type polymérisation par addition a en outre une structure réticulée.

**3.** Précurseur de plaque d'impression planographique selon la revendication 1 ou la revendication 2,

dans lequel la structure hydrophile contient un groupe représenté par Formule Z,

$$*\text{-Q-W-Y} \qquad \text{Formule Z}$$

dans Formule Z, Q représente un groupe de liaison divalent, W représente un groupe divalent ayant une structure hydrophile ou un groupe divalent ayant une structure hydrophobe, Y représente un groupe monovalent ayant une structure hydrophile ou un groupe monovalent ayant une structure hydrophobe, l'un quelconque de W ou Y a une structure hydrophile, et * représente un site de liaison par rapport à une autre structure.

**4.** Précurseur de plaque d'impression planographique selon l'une quelconque des revendications 1 à 3,
dans lequel la structure hydrophile a une structure de polyalkylène glycol.

**5.** Précurseur de plaque d'impression planographique selon l'une quelconque des revendications 1 à 4,

dans lequel la couche d'enregistrement d'images contient en outre un agent absorbant les infrarouges et un composé représenté par Formule I,

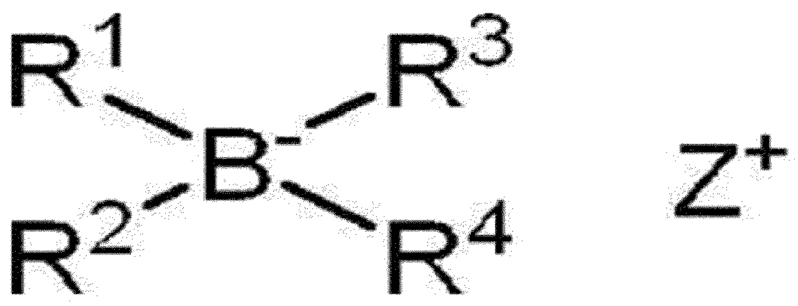

Formule I

dans Formule I, $R^1$, $R^2$, $R^3$ et $R^4$ représentent chacun indépendamment un groupe alkyle, un groupe aryle, un groupe alcényle, un groupe alkynyle, un groupe cycloalkyle ou un groupe hétérocyclique, ou deux ou plusieurs de $R^1$, $R^2$, $R^3$ et $R^4$ représentent une structure formant un hétérocycle dans lequel un atome de bore dans Formule I est inclus en tant qu'élément de l'anneau, et $Z^+$ représente un cation.

**6.** Précurseur de plaque d'impression planographique selon l'une quelconque des revendications 1 à 5, dans lequel les particules de polymère sont des particules de polymère dispersibles dans l'eau.

**7.** Précurseur de plaque d'impression planographique selon l'une quelconque des revendications 1 à 6, dans lequel les particules de polymère sont des particules de polymère dispersibles dans un solvant organique.

**8.** Précurseur de plaque d'impression planographique selon l'une quelconque des revendications 1 à 7, dans lequel un diamètre médian des particules de polymère est de 1000 nm ou moins.

**9.** Précurseur de plaque d'impression planographique selon l'une quelconque des revendications 1 à 8, dans lequel le précurseur de plaque d'impression planographique est un précurseur de plaque d'impression planographique de type développement sur presse.

**10.** Procédé de préparation d'une plaque d'impression planographique, comprenant :

Exposer par images le précurseur de plaque d'impression planographique selon l'une quelconque des revendications 1 à 9; et
fournir au moins un élément sélectionné parmi le groupe constitué d'encre d'impression et d'eau de mouillage pour éliminer, sur une presse d'impression, une couche d'enregistrement d'images d'une zone sans image.

**11.** Procédé d'impression planographique comprenant :

Exposer par images le précurseur de plaque d'impression planographique selon l'une quelconque des revendications 1 à 9; et
fournir au moins un élément sélectionné parmi le groupe constitué d'encre d'impression et d'eau de mouillage pour éliminer, sur une presse d'impression, une couche d'enregistrement d'images d'une zone sans image afin de préparer une plaque d'impression planographique ; et
effectuer une impression en utilisant la plaque d'impression planographique obtenue.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013503365 A
- JP 2010234587 A
- EP 2554381 A1
- EP 2363748 A1
- EP 2383118 A2
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H05005005 A
- JP 2001222101 A
- JP 2014104631 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP S48041708 B
- JP 51037193 A
- JP S51037193 A
- JP 2032293 B
- JP H02032293 B
- JP 2016765 B
- JP H02016765 B
- JP 2003344997 A
- JP 2006065210 A
- JP 58049860 B
- JP S58049860 B
- JP 56017654 B
- JP S56017654 B
- JP 62039417 B
- JP S62039417 B
- JP 62039418 B
- JP S62039418 B
- JP 2000250211 A
- JP 2007094138 A
- US 7153632 A
- JP 8505958 A
- JP H08505958 A
- JP 2007293221 A
- JP 2007293223 A
- JP 5129242 B
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2007276454 A
- JP 2009154525 A
- JP 2006297907 A
- JP 2007050660 A
- JP 2008284858 A
- JP 2009090645 A
- JP 2009208458 A
- JP 62293247 A
- JP S62293247 A
- JP 2008284817 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP H05045885 A
- JP 6035174 A
- JP H06035174 A
- JP 10282679 A
- JP H10282679 A
- JP 2304441 A
- JP H02304441 A
- JP 2005238816 A

- JP 2005125749 A
- JP 2006239867 A
- JP 2006215263 A
- JP 2006188038 A
- US 3458311 A
- JP 55049729 B
- JP S55049729 B
- JP 2005250216 A
- JP 2006259137 A
- JP 2007206348 A
- JP 2006065321 A
- JP 2008203359 A
- JP 2008276166 A
- JP 2009047927 A
- JP 2018163556 A
- JP 2019016536 A


**Non-patent literature cited in the description**


- **TOSHINAO OKITSU**. *Journal of the Adhesion Society of Japan*, 1993, vol. 29 (5)
- Dye Handbook. 1970
- **HANSCH, C.** ; **LEO, A.** ; **TAFT, R. W.** *Chem. Rev.*, 1991, vol. 91, 165-195
- *Research Disclosure No. 33303*, January 1992